(19) **Europäisches Patentamt**
**European Patent Office**
**Office européen des brevets**

(11) **EP 2 955 858 B1**

(12) **EUROPEAN PATENT SPECIFICATION**

(45) Date of publication and mention
of the grant of the patent:
**26.07.2017 Bulletin 2017/30**

(51) Int Cl.:
*H04B 7/04 (2017.01)*     *H04L 27/34 (2006.01)*
*H04L 1/00 (2006.01)*     *H04H 60/11 (2008.01)*
*H03M 13/09 (2006.01)*     *H03M 13/11 (2006.01)*
*H03M 13/15 (2006.01)*     *H03M 13/25 (2006.01)*
*H03M 13/29 (2006.01)*     *H03M 13/35 (2006.01)*
*H04L 1/06 (2006.01)*     *H04L 27/26 (2006.01)*
*H04W 52/32 (2009.01)*     *H04W 52/42 (2009.01)*

(21) Application number: **15177721.6**

(22) Date of filing: **01.02.2011**

(54) **BROADCAST SIGNAL RECEIVER USING MIMO PROCESSING WITH A MIMO ROTATION MATRIX**

RUNDFUNKSIGNALEMPFÄNGER UNTER VERWENDUNG VON MIMO-VERARBEITUNG MIT EINER MIMO-ROTATIONSMATRIX

RÉCEPTEUR DE SIGNAUX DE RADIODIFFUSION UTILISANT UN TRAITEMENT MIMO AVEC UNE MATRICE DE ROTATION MIMO

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.02.2010 US 301199 P**

(43) Date of publication of application:
**16.12.2015 Bulletin 2015/51**

(62) Document number(s) of the earlier application(s) in accordance with Art. 76 EPC:
**11740000.2 / 2 533 524**

(73) Proprietor: **LG Electronics Inc.**
**Yeongdeungpo-gu**
**Seoul 150-721 (KR)**

(72) Inventors:
- **KO, Woo Suk**
  **137-724 Seoul (KR)**
- **MOON, Sang Chul**
  **137-724 Seoul (KR)**

(74) Representative: **Cabinet Plasseraud**
**66 rue de la Chaussée d'Antin**
**75440 Paris Cedex 09 (FR)**

(56) References cited:
**WO-A2-2007/069172**     **US-A1- 2006 039 489**

- **ATANES P ET AL: "MIMO Performance of the Next Generation DVB-T", 2009 IEEE 69TH VEHICULAR TECHNOLOGY CONFERENCE, HELD IN BARCELONA, SPAIN, 26 April 2009 (2009-04-26), - 29 April 2009 (2009-04-29), pages 1-5, XP031474619, PISCATAWAY, NJ, USA ISBN: 978-1-4244-2517-4**
- **"Digital Video Broadcasting (DVB); Frame structure channel coding and modulation for a second generation digital terrestrial television broadcasting system (DVB-T2)", EUROPEAN STANDARD (TELECOMMUNICATIONS SERIES), EUROPEAN TELECOMMUNICATIONS STANDARDS INSTITUTE (ETSI), no. V1.1.1, July 2009 (2009-07), XP014044393, 650, ROUTE DES LUCIOLES ; F-06921 SOPHIA-ANTIPOLIS ; FRANCE**
- **SANGCHUL MOON ET AL: "Enhanced spatial multiplexing for rate-2 MIMO of DVB-NGH system", 2012 19TH IEEE INTERNATIONAL CONFERENCE ON TELECOMMUNICATIONS (ICT), 23 April 2012 (2012-04-23), pages 1-5, XP032188380, PISCATAWAY, NJ, USA DOI: 10.1109/ICTEL.2012.6221323 ISBN: 978-1-4673-0745-1**

**Description**

[Technical Field]

The present invention relates to a method for transceiving broadcast signals and an apparatus for transceiving broadcast signals, and more particularly, to a method for transceiving broadcast signals, which can enhance data transmission efficiency and is compatible with conventional methods for transceiving broadcast signals, and a transceiving apparatus thereof.

[Background Art]

As analog broadcasting will soon end, a variety of technologies for transmitting and receiving digital broadcast signals has been developed. Digital broadcast signals can transmit a greater capacity of video/audio data than analog broadcast signals, and can include a variety of optional data in addition to video/audio data.

A digital broadcast system can provide High Definition (HD) images, multi-channel sound, and a variety of optional services. However, data transmission efficiency for high capacity data transmission, robustness of transmitting and receiving networks, and flexibility of networks in consideration of mobile receiving equipment are problems that should still be improved.

In "MIMO Performance of the Next Generation DVB-T", 2009 IEEE 69TH VEHICULAR TECHNOLOGY CONFERENCE, BARCELONA, SPAIN, April 2009, pages 1-5, XP031474619, P. Atanes, et al. discuss MIMO performance in DVB-T2 systems.

[Disclosure]

[Technical Problem]

A technical object of one embodiment of the present invention is to provide a method and apparatus for transceiving broadcast signals, which can enhance data transmission efficiency in a digital broadcast system.

Another technical object of the present invention is to provide a method and apparatus for transceiving broadcast signals, which can receive digital broadcast signals without error even under an indoor environment or using mobile receiving equipment.

A further technical object of the present invention is to provide a method and apparatus for transceiving broadcast signals, which can maintain compatibility with a conventional broadcast system in addition to achieving the above described objects.

[Technical Solution]

According to an aspect of the present invention, a method for receiving a broadcast signal as defined in claim 1 and an apparatus for receiving a broadcast signal as defined in claim 5 are provided. Embodiments are further defined in claims 2-4 and 6-8.

[Advantageous Effects]

According to the present invention, in a digital broadcast system, it is possible to enhance data transmission efficiency and increase robustness in terms of transmission and reception of broadcast signals, by virtue of provision of a MIMO system.

Further, according to the present invention, it is possible to provide a method and apparatus for transceiving broadcast signals, which can receive digital broadcast signals without error even under an indoor environment or using mobile reception equipment.

Furthermore, according to the present invention, even in the case in which transmission paths or channels are similar to each other in a MIMO broadcast system, it is possible to recover and use a broadcast service, by virtue of provision of SVC technologies.

In addition, according to the present invention, a broadcast system using MIMO of the present invention can achieve the above described advantages while maintaining compatibility with a conventional broadcast system not using MIMO, by virtue of arranging MIMO broadcast signals which are SVC encoded per PLP or per frame.

[Description of Drawings and Best Mode]

The following description and and the accompanying drawings illustrate both the embodiments of the invention that comprise the features of the independent claims and other embodiments of related inventions that do not comprise all the features of the independent claims but are useful for better understanding the claimed invention.

[Description of Drawings]

FIG. 1 illustrates a broadcast signal transmitter using a MIMO scheme according to an embodiment of the present invention;
FIG. 2 illustrates an input processing module according to an embodiment of the present invention;
FIG. 3 illustrates a stream adaptation block included in an input processing module according to another embodiment of the present invention;
FIG. 4 illustrates a BICM encoder (module) according to an embodiment of the present invention;
FIG. 5 illustrates a frame builder according to an embodiment of the present invention;
FIG. 6 illustrates an OFDM generator according to an embodiment of the present invention;
FIG. 7 illustrates a broadcast signal receiver according to an embodiment of the present invention;
FIG. 8 illustrates an OFDM demodulator according to an embodiment of the present invention;
FIG. 9 illustrates a frame parser according to an embodiment of the present invention;
FIG. 10 illustrates a BICM decoder according to an embodiment of the present invention;
FIG. 11 illustrates an output processing module of the broadcast signal receiver according to an embodiment of the present invention;
FIG. 12 illustrates a structure of a PLP based transmission frame transmitted/received by a transceiving system according to an embodiment of the present invention;
FIG. 13 illustrates structures of an FEF based new transmission frame according to an embodiment of the present invention;
FIG. 14 illustrates a procedure of generating a P1 symbol for identifying a new transmission frame according to an embodiment of the present invention;
FIG. 15 illustrates L1-pre signaling information included in a transmitted/received signal according to an embodiment of the present invention;
FIG. 16 illustrates L1-post signaling information included in a transmitted/received signal according to an embodiment of the present invention;
FIG. 17 illustrates L1-post signaling information included in a transmitted/received signal according to another embodiment of the present invention;
FIG. 18 illustrates a broadcast signal transceiver according to another embodiment of the present invention;
FIG. 19 illustrates a broadcast signal transceiver according to another embodiment of the present invention;
FIG. 20 illustrates a MIMO broadcast signal transmitter and a transmission method using SVC according to an embodiment of the present invention;
FIG. 21 illustrates a MIMO broadcast signal transmitter and a transmission method using SVC according to another embodiment of the present invention;
FIG. 22 illustrates a MIMO broadcast signal transmitter and a transmission method using SVC according to another embodiment of the present invention;
FIG. 23 illustrates a structure of a transmission stream transmitted by a terrestrial broadcast system to which a MIMO transmission system using SVC according to an embodiment of the present invention is applied;
FIG. 24 illustrates a MIMO transceiving system according to an embodiment of the present invention;
FIG. 25 is a BER/SNR chart showing a performance difference between a GC scheme and an SM scheme using an outer code according to an embodiment of the present invention;
FIG. 26 is a BER/SNR chart showing a performance difference between a GC scheme and an SM scheme according to modulation schemes and a code rate of an outer code according to an embodiment of the present invention;
FIG. 27 illustrates a data transceiving method based on MIMO transmission of SM scheme in a channel environment according to an embodiment of the present invention;
FIG. 28 illustrates input signals and transmission signals on which a MIMO encoding method according to a first embodiment of the present invention has been performed;
FIG. 29 illustrates input signals and transmission signals on which a MIMO encoding method according to a third embodiment of the present invention has been performed;
FIG. 30 illustrates a MIMO transmitter and a MIMO receiver according to an embodiment of the present invention;

FIG. 31 illustrates a MIMO transmitter and a MIMO receiver according to another embodiment of the present invention;

FIG. 32 illustrates a MIMO transmitter and a MIMO receiver according to another embodiment of the present invention;

FIG. 33 illustrates a MIMO transmitter and a MIMO receiver according to another embodiment of the present invention;

FIG. 34 illustrates an LDPC encoding block and a demultiplexer according to an embodiment of the present invention;

FIG. 35 is a table showing reliabilities of received signals according to MIMO channel conditions according to an embodiment of the present invention;

FIG. 36 illustrates part of a MIMO transceiving system according to an embodiment of the present invention;

FIG. 37 illustrates operations of a demultiplexer and a divider according to an embodiment of the present invention;

FIG. 38 illustrates operations of a demultiplexer and a divider according to an embodiment of the present invention; and

FIG. 39 is a flowchart illustrating a method of transmitting a broadcast signal according to an embodiment of the present invention.

[Best Mode]

Hereinafter, although the preferred embodiments of the present invention will be described in detail with reference to the accompanying drawings and contents as described with relation to the accompanying drawings, it is to be understood that the present invention is not limited to the embodiments.

The present invention relates to a broadcast signal transmitter and a broadcast signal receiver using multi-input multi-output (MIMO) processing.

Performances of systems employing MIMO depend on characteristics of a transmission channel and, particularly, systems having independent channel environments exhibit high performance. That is, the performance of a system to which MIMO is applied can be improved when channels from antennas of a transmitter to antennas of a receiver are uncorrelated and independent. However, in a channel environment in which correlation between channels between transmit antennas and receive antennas is high, such as a line-of sight (LOS) environment, the performance of a system employing MIMO may abruptly decrease or the system may not operate.

When MIMO is applied to broadcast systems using single-input single-output (SISO) and MISO schemes, a data transmission efficiency can increase. However, the above-mentioned problems are generated and compatibility should be maintained such that a receiver having a single antenna can be provided with MIMO service. Accordingly, the present invention proposes a method capable of solving these problems.

Furthermore, the present invention proposes a broadcast signal transceiver and a broadcast signal transmission/reception method for a system capable of transmitting/receiving an additional broadcast signal (or enhanced broadcast signal), for example, a mobile broadcast signal, while sharing an RF band with a conventional terrestrial broadcast system, for example, DVT-T2. This mobile broadcast system may be referred to as a MIMO transceiving system or new transceiving system.

To achieve this, the present invention can use a video coding method having scalability, which can divide video components into a basic video component having low definition while being robust against a communication environment and a video component vulnerable to the communication environment while being capable of providing high definition images and respectively transmit the different types of video components. While the present invention describes SVC as the video coding method having scalability, other arbitrary video coding methods can be used. Embodiments of the present invention will now be described in detail with reference to the attached drawings.

A broadcast signal transmitter and receiver of the present invention can perform MISO processing and MIMO processing on a plurality of signals transmitted and received through a plurality of antennas. A description will be given of a broadcast signal transceiver that processes two signals transmitted and received through two antennas.

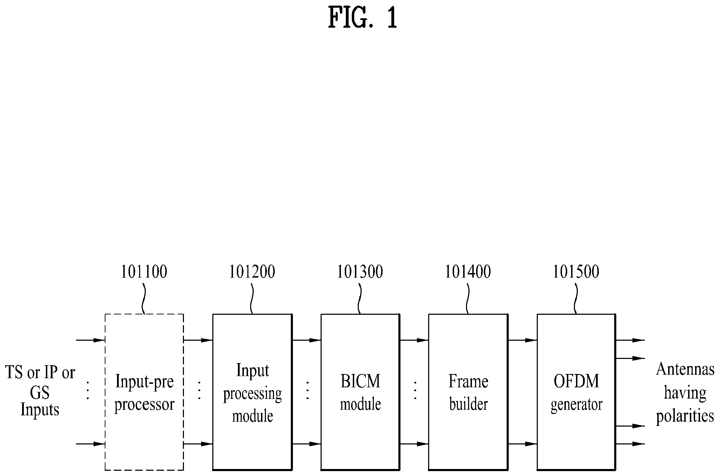

FIG. 1 illustrates a broadcast signal transmitter using the MIMO scheme according to an embodiment of the present invention.

As shown in FIG. 1, the broadcast signal transmitter according to the present invention may include an input processor 101100, an input processing module 101200, a Bit Interleaved Coded Modulation (BICM) encoder 101300, a frame builder 101400, and an Orthogonal Frequency-Division Multiplexing (OFDM) generator (or transmitter) 101500. The broadcast signal transmitter according to the present invention may receive a plurality of MPEG-TS streams or a General Stream Encapsulation (GSE) stream (or GS stream).

The input processor 101100 may generate physical layer pipes (PLPs) on a service basis in order to give robustness to the input stream, that is, the plurality of MPEG-TS streams or the GSE stream.

A PLP is a data unit identified in a physical layer and data is processed for each PLP on the same transmission path. That is, the PLP is data having the same physical layer attribute, processed on the transmission path, and may be mapped on a cell-by-cell basis in a frame. Furthermore, the PLP may be defined as a TDM channel of a physical layer transmitted through a cell.

The input processing module 101200 may generate a base band (BB) frame including the generated PLPs.

The BICM encoder 101300 may add redundancy to the BB frame to correct an error on a transmission channel and interleave PLP data included in the BB frame.

The frame builder 101400 may accomplish a transmission frame structure by mapping the plurality of PLPs to a transmission frame and adding signaling information thereto. The OFDM generator 101500 may demodulate input data from the frame builder according to OFDM to divide the input data into a plurality of paths such that the input data is transmitted through a plurality of antennas.

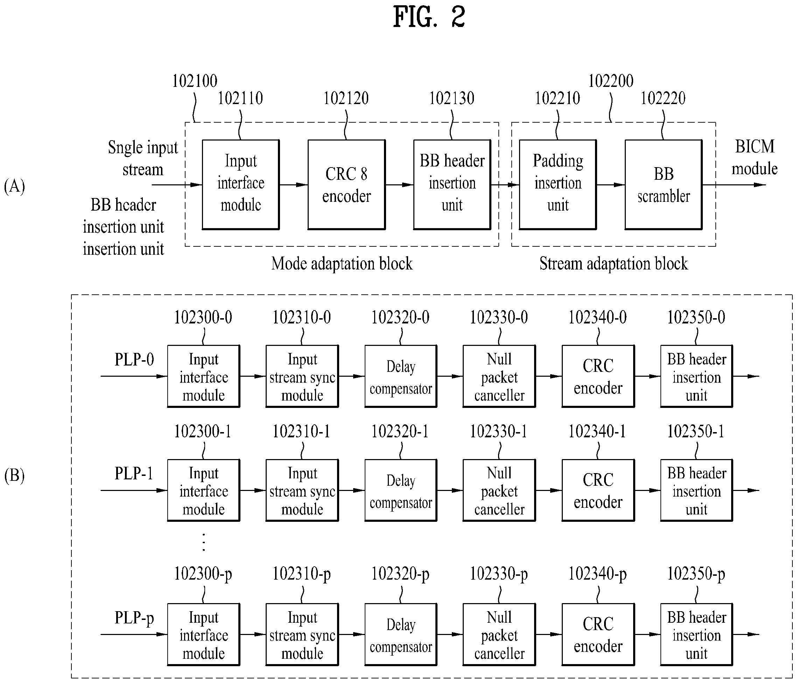

FIG. 2 illustrates an input processing module according to an embodiment of the present invention.

FIG. 2(A) show an embodiment of the input processing module 101200 when a single input stream is input to the input processing module 101200. When there is a single input stream, the input processing module 101200 may include a mode adaptation block 102100 and a stream adaptation block 102200.

The mode adaptation block 102100 may include an input interface module 102110 for dividing the input bitstream into logical units for FEC (BCH/LDPC) encoding performed in a BICM encoder following the input processing module 101200 and mapping the logical units, a cyclic redundancy check (CRC)-8 encoder 102120 for performing CRC encoding on the mapped bitstream, and a BB header insertion unit 102130 for inserting a BB header having a fixed size to a data field. In this case, the BB header may include mode adaptation type (TS/GS/IP) information, user packet length information, data field length information, etc.

The stream adaptation block 102200 may include a padding insertion unit 102210 for inserting a padding bit into the input stream to accomplish one BB frame for FEC encoding when the input stream does not fill the BB frame, and a BB scrambler module 102220 for generating a pseudo random binary sequence (PRBS) and performing an XOR operation on the input bitstream and the generated PRBS to randomizing the input stream.

FIG. 2(B) illustrates another embodiment of the mode adaptation block 102100 included in the input processing module 102100 when a plurality of input streams is input to the input processing module 102100.

The mode adaptation block 102100 may include p+1 input interface modules 102300-0 to 102300-p, p+1 input stream sync modules 102310-0 to 102310-p, p+1 delay compensators 102320-0 to 102320-p, p+1 null packet cancellers 102330-0 to 1-2330-p, p+1 CRC encoders 102340-0 to 102340-p, and p+1 BB header insertion units 102350-0 to 102350-p.

P+1 input streams may be independently processed into streams converted from a plurality of MPEG-TSs or GSE streams, and each of the processed streams may be a complete stream including a plurality of service components or a stream of a minimum unit including only a single service component.

Paths through which the input streams to be independently processed are transmitted may be referred to as PLPs. Services may be transmitted/received through a plurality of RF channels. PLP data may be included in slots distributed at time intervals in the plurality of RF channels, or distributed at time intervals in one RF channel. To increase transmission efficiency, an embodiment of the present invention selects a PLP from the plurality of PLPs and transmits information that can be commonly applied to the plurality of PLPs through the selected PLP. This PLP may be referred to as a common PLP or L2 signaling information. There may be multiple common PLPs according to the intention of a designer.

The p+1 input interface modules 102300-0 to 102300-p, p+1 CRC encoders 102340-0 to 102340-p, and p+1 BB header insertion units 102350-0 to 102350-p have the same functions as those of the input interface module 102100, CRC-8 encoder 102120, and BB header insertion unit 102130 shown in FIG. 2(A), and thus detailed descriptions thereof are omitted. The p+1 input stream sync modules 102310-0 to 102310-p may insert input stream clock reference (ISCR) information, that is, timing information necessary for a receiver to restore a transport stream (TS) or a generic stream (GS).

The p+1 delay compensators 102320-0 to 102320-p may acquire synchronization by delaying data for PLPs in each group on the basis of the timing information inserted by the input stream sync modules, and the p+1 null packet cancellers 102330-0 to 1-2330-p may delete unnecessarily transmitted null packets inserted in delay-compensated BB frames and insert the number of deleted null packets to positions at which the null packets are deleted.

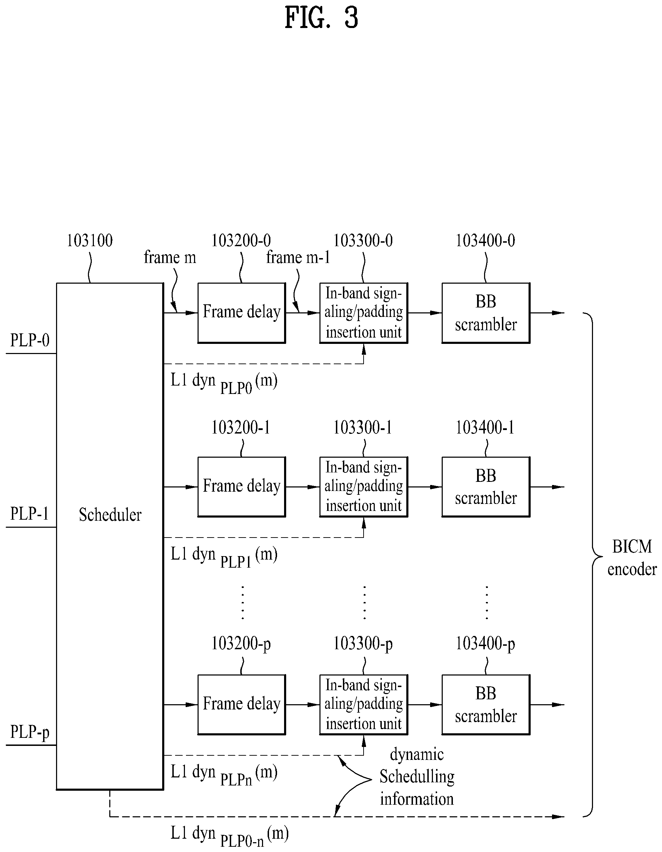

FIG. 3 illustrates the stream adaptation block included in the input processing module according to another embodiment of the present invention.

The stream adaptation block 102200 shown in FIG. 3 may include a scheduler 103100 for performing scheduling for allocating a plurality of PLPs to slots of a transport stream and transmitting L1-dynamic signaling information of a current frame to the BICM module 101300, separately from in-band signaling, p+1 frame delays 103200-0 to 103211-p for delaying input data by one frame such that the current frame can include scheduling information about the following frame for in-band signaling, p+1 in-band signaling/padding inserting units 103200-0 to 103200-p for inserting undelayed L1-dynamic signaling information to the data delayed by one frame and, when a padding space is present, inserting a padding bit to the padding space or inserting in-band signaling information to the padding space, and p+1 BB scramblers 103300-0 to 103300-p. The p+1 BB scramblers 103300-0 to 103300-p operate in the same manner as the BB scrambler module 102150 shown in FIG. 2(A), and thus detailed description thereof is omitted.

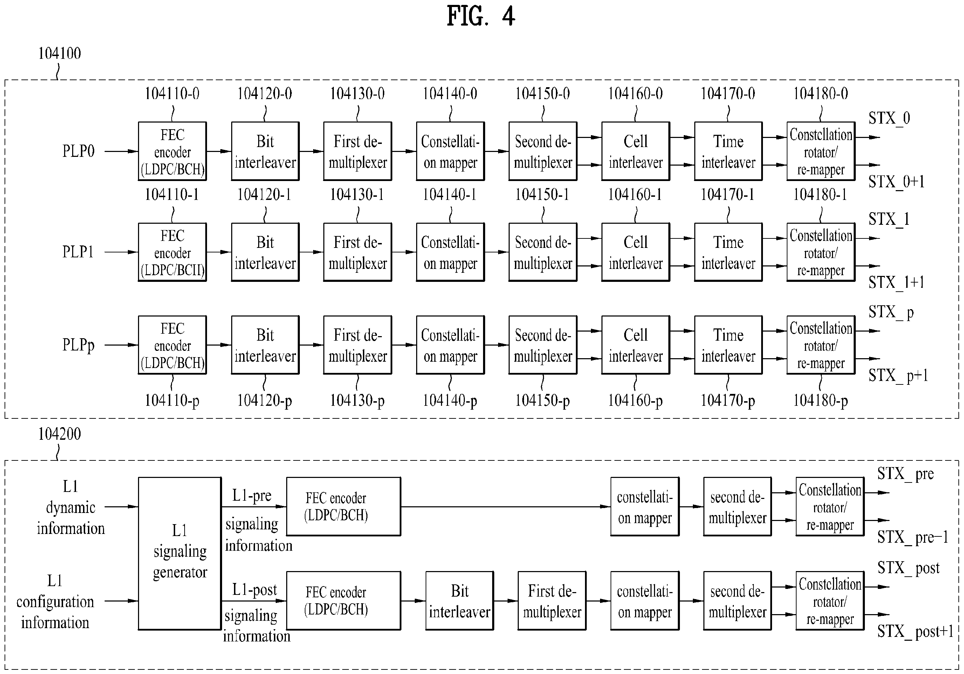

FIG. 4 illustrates the BICM encoder (module) according to an embodiment of the present invention.

The BICM encoder 101300 may include a first BICM encoding block 104100 and a second BICM encoding block 104200. The first BICM encoding block 104100 may include blocks for respectively processing a plurality of input-processed PLPs, and the second BICM encoding block 104200 may include blocks for respectively processing signaling information. The signaling information may include L1-pre signaling information and L1-post signaling information. Positions of the blocks may be changed by a designer. The blocks will now be described in detail.

The first BICM block 104100 may include p+1 FEC encoders 104110-0 to 104110-p for adding redundancy to data included in PLPs (referred to as PLP data hereinafter) such that the receiver can correct an error on the transmission channel and performing BCH encoding and LDPC encoding of the PLP data, p+1 bit interleavers 1041200-0 to 1041200-p for bit-interleaving the FEC-encoded PLP data on an FEC block basis, p+1 first demultiplexers (bit-to-cell Demux) 1041300-0 to 1041300-p for demultiplexing the bit-interleaved PLP data on an FEC block basis, p+1 constellation mappers 104140-0 to 104140-p for mapping the demultiplexed bit-based PLP data to constellations on a symbol-by-symbol basis, p+1 second demultiplexers (cell-to-polarity Demux) 104150-0 to 104150-p for dividing cells mapped to the constellations into two paths, that is, first and second paths, p+1 cell interleavers 104160-0 to 104160-p for interleaving the PLP data mapped to the constellations, p+1 time interleavers 104170-0 to 104170-p for interleaving the cell-interleaved PLP data in time, and p+1 constellation rotators/remappers 104180-0 to 104180-p for rotating the constellations by a predetermine angle according to modulation type. The second demultiplexers may be referred to as dividers.

The first BICM encoding block 104100 may include a MISO encoder or a MIMO encoder for performing MISO encoding or MIMO encoding for the plurality of PLPs. In this case, The MISO/MIMO encoder may follow the p+1 constellation mappers 104140-0 to 104140-p or follow the p+1 time interleavers 104170-0 to 104170-p. Otherwise, the MISO/MIMO encoder may be included in the OFDM generator 101500.

Data output through the first path divided by the p+1 second demultiplexers 104150-0 to 104150-p may be transmitted through a first antenna Tx_1 and data output through the second path may be transmitted through a second antenna Tx_2.

The constellations rotated by the p+1 constellation rotators/remappers 104180-0 to 104180-p may be represented by an in-phase (I-phase) component and a quadrature-phase (Q-phase) component. The p+1 constellation rotators/remappers 104180-0 to 104180-p may delay only the Q-phase component by a predetermined value. Then, the p+1 constellation rotators/remappers 104180-0 to 104180-p may remap the interleaved PLP data to new constellations using the I-phase component and the delayed Q-phase component. Accordingly, a diversity gain can be obtained since I/Q components of the first and second paths are mixed and thus the same information is transmitted through the first and second paths. The p+1 constellation rotators/remappers 104180-0 to 104180-p may be located before the cell interleavers, which can be changed by the designer. Consequently, the first BICM encoding block 104100 can output two pieces of data for each PLP. For example, the first BICM encoding block 104100 can receive PLP0, process received PLP0 and output STX_0 and STX_0+1.

The second BICM encoding block 104200 may include an L1 signaling generator 104210 for encoding input L1-dynamic information and L1-configurable information to generate L1-pre signaling information and L1-post signaling information, two FEC encoders, a bit interleaver, a demultiplexer, two constellation mappers, two demultiplexers, and two constellation rotators/remappers.

The L1 signaling generator 104210 may be included in the stream adaptation block 102200, which may be changed by the designer. Other blocks operate in the same manner as those included in the first BICM encoding block 104100, and thus detailed description thereof is omitted.

The L1-pre signaling information may include information necessary for the receiver to decode the L1-post signaling information, and the L1-post signaling information may include information necessary for the receiver to restore received data. To decode L1-signaling information and data in the receiver, correct and rapid decoding of the L1-pre signaling information is necessary. Accordingly, the second BICM encoding block 104200 according to the present invention does not perform bit interleaving and demultiplexing on the L1-pre signaling information such that the receiver can rapidly decode the L1-pre signaling information. Consequently, the second BICM encoding block 104200 can output two pieces of data for the L-dynamic information and L1-configurable information. For example, the first BICM encoding block 104100 can receive and process the L1-dynamic information and output STX-pre and STX_pre+1.

The BICM encoder 101300 may process the data input through the first and second paths and output the processed data to the frame builder 101400 through the first and second paths. This may be changed according to the intention of the designer.

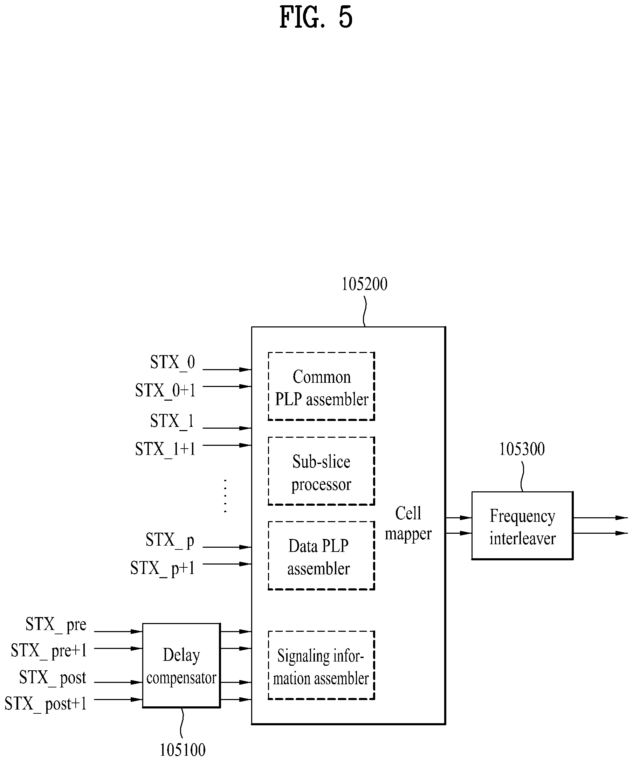

FIG. 5 illustrates the frame builder according to an embodiment of the present invention.

As described above, the first BICM encoding block 104100 can output two data such as STX_k and STX_k+1 for a plurality of PLP data and the second BICM encoding block 104200 can output four signaling data, that is, STX_pre, STX_pre+1, STX_post and STX_post+1 for the L-pre signaling information and the L1-post signaling information.

Each output data is input to the frame builder 101400. In this case, as shown in FIG. 5, the frame builder 101400 may receive the four signaling data, that is, STX_pre, STX_pre+1, STX_post and STX_post+1 first from among the data output from the BICM encoding module 101300. The frame builder 104100 may include a delay compensator 105100 for compensating a delay of one transmission frame and a delay according to processing in the BICM encoding module 101300 for the L1-pre signaling data or the L1-post signaling data, a cell mapper 105200 for arranging input common PLP cells, PLP cells including normal data and cells including signaling information in an OFDM symbol based array of a transmission frame using scheduling information, and a frequency interleaver 105300 for interleaving cells input thereto in the frequency domain and outputting the interleaved data through first and second paths.

The cell mapper 1054200 may include a common PLP assembler, sub-slice processor, data PLP assembler and signaling information assembler blocks and perform an arrangement-related function using scheduling information included in signaling information. The cell mapper 105200 may apply the same cell mapping scheme or different cell mapping schemes to the first and second paths depending on the scheduling information.

The frame builder 101400 may process data input through the first and second paths and output the processed data to the OFDM generator through the first and paths, which may be changed according to the intention of the designer.

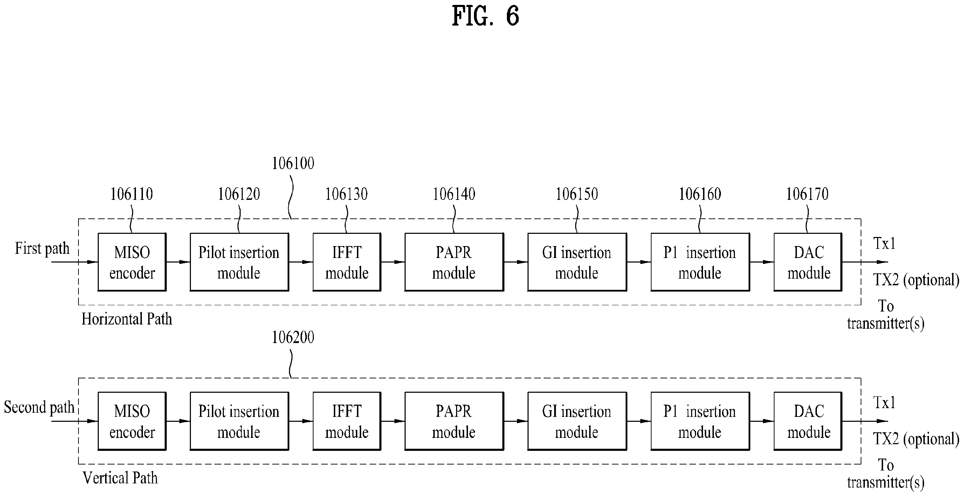

FIG. 6 illustrates the OFDM generator according to an embodiment of the present invention.

The OFDM generator 101500 according to an embodiment of the present invention may receive broadcast signals through first and second paths, demodulates the received broadcast signals and output the demodulated signals to two antennas TX1 and TX2.

In the present invention, a block for modulating the broadcast signal to be transmitted through the first antenna TX1 may be referred to as a first transmitter 106100 and a block for modulating the broadcast signal to be transmitted through the second antenna TX2 may be referred to as a second transmitter 106200. In the following description, the first and second transmitters may be respectively called first and second OFDM generators.

When channel correlation between channels transmitted through the first and second antennas is high, the first and second antennas may apply a polarity to transmitted signals according to the sign of the correlation and transmit the signals. A MIMO scheme using this technique may be referred to as a polarity multiplexing MIMO scheme, the first antenna that adds a polarity to a received signal and transmits the signal with the polarity may be referred to as a vertical antenna, and the second antenna that adds a polarity to a received signal and transmits the signal with the polarity may be referred to as a horizontal antenna. A description will be given of modules included in the first transmitter 106100 and the second transmitter 106200.

The first transmitter 106100 may include a MISO encoder 10610 for MISO-encoding input symbols transmitted through each path such that the input symbols have transmit diversity, a pilot insertion module 106120 for inserting a pilot having a predetermined pilot pattern into a predetermined position in a transmission frame and outputting the transmission frame to an inverse fast Fourier transform (IFFT) module 106130, the IFFT module 106130 performing IFFT on the signal having the pilot on each path, a peak-to-average power ratio (PAPR) module 106140 for reducing a PAPR of signals in the time domain and outputting the signals with the reduced PAPR to a guard interval (GI) insertion module 106150 or feeding back necessary information to the pilot insertion module 106120 according to a PAPR reduction algorithm, the GI insertion module 106150 copying the last part of an effective OFDM symbol, inserting a GI into each OFDM symbol in the form of a cyclic prefix (CP) and outputting each OFDM symbol to a P1 symbol insertion module 106160, the P1 symbol insertion module 106160 inserting a P1 symbol into the beginning of each transmission frame, and a digital-to-analog converter (DAC) module 106170 converting each signal frame having the P1 symbol inserted thereto into an analog signal and transmitting the analog signal through the first antenna Tx1.

The second transmitter 106200 may include the same modules as those of the first transmitter 106100. The modules included in the second transmitter 106200 perform the same functions as those of the modules included in the first transmitter 106100, and thus detailed descriptions are omitted. A description will be given of operations of the modules included in the first transmitter 106100.

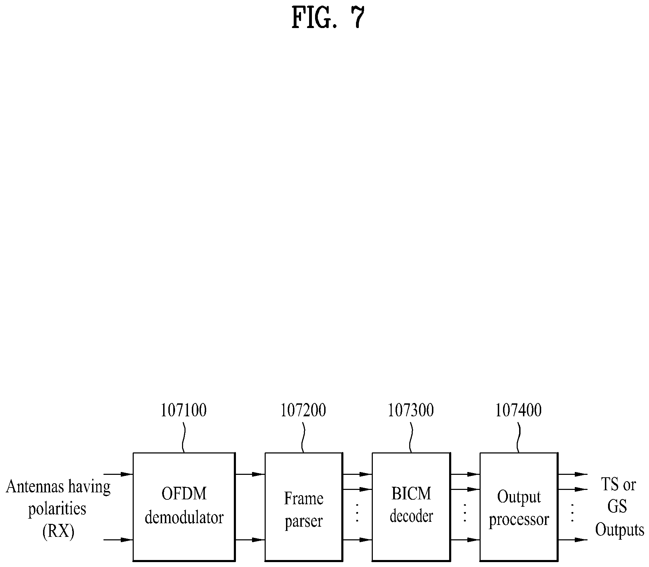

FIG. 7 illustrates a broadcast signal receiver according to an embodiment of the present invention.

As shown in FIG. 7, the broadcast signal receiver may include an OFDM demodulator 107100, a frame parser 107200, a BICM decoder 107300, and an output processor 107400. The OFDM demodulator 107100 may convert signals received through a plurality of receive antennas into signals in the frequency domain. The frame parser 107200 may output PLPs for a necessary service from among the converted signals. The BICM decoder 107300 may correct an error generated according to a transmission channel. The output processor 107400 may perform procedures necessary to generate output TSs or GSs. Here, dual polarity signals may be input as input antenna signals and one or more streams may be output as the TXs or GSs.

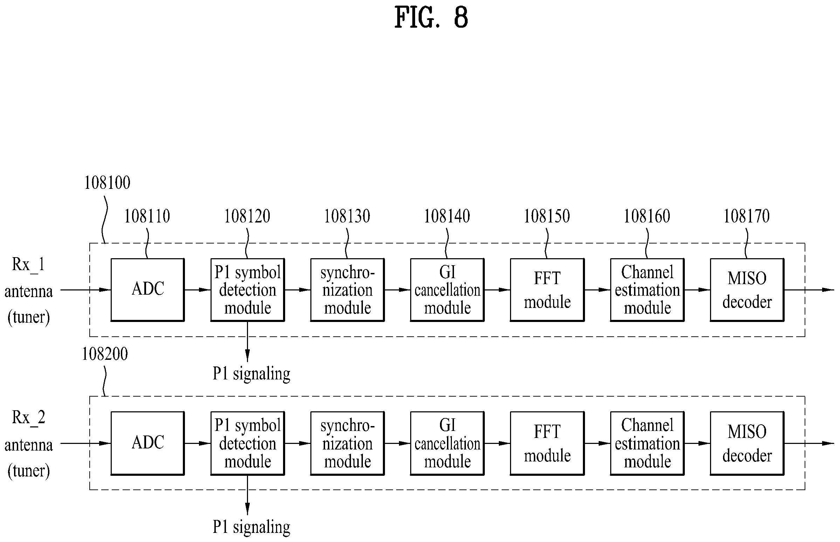

FIG. 8 illustrates the OFDM demodulator according to an embodiment of the present invention.

The OFDM demodulator 107100 may receive broadcast signals of the respective paths through two antennas Rx1 and Rx2 and perform OFDM demodulation on the broadcast signals. A block that demodulates the broadcast signal received through the first antenna Rx1 may be referred to as a first receiver 108100 and a block that demodulates the broadcast signal received through the second antenna Rx2 may be referred to as a second receiver 108200. In the following description, the first receiver 108100 and the second receiver 108200 may be respectively referred to as a first OFDM demodulator and a second OFDM demodulator. Furthermore, according to an embodiment of the present invention, polarity multiplexing MIMO can be employed. That is, the first receiver 108100 may demodulate the broadcast signal input through the first antenna Rx1 according to OFDM and output the demodulated broadcast signal to the frame parser 107200 through a first path, and the second receiver 108200 may demodulate the broadcast signal input through the second antenna Rx2 according to OFDM and output the demodulated broadcast signal to the frame parser 107200 through a second path.

The first receiver 108100 may include an ADC module 108110, a P1 symbol detection module 108120, a synchronization module 108130, a GI cancellation module 108140, an FFT module 108150, a channel estimation module 108160, and a MISO decoder 108170.

The second receiver 108200 may include modules identical to the modules of the first receiver 108100 and the modules included in the second receiver 108200 perform the same functions as the modules included in the first receiver 108100. The OFDM demodulator 107100 shown in FIG. 8 can perform a reverse procedure of the procedure of the OFDM generator 101500 illustrated in FIG. 6, and thus detailed description thereof is omitted.

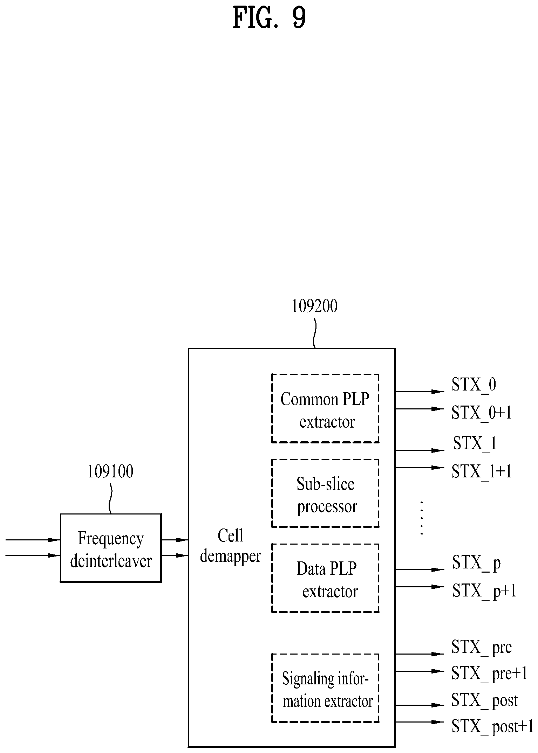

FIG. 9 illustrates the frame parser according to an embodiment of the present invention.

As shown in FIG. 9, the frame parser 107200 may include a frequency deinterleaver 109100 for processing data input through the first and second paths and a cell mapper 109200. This may be modified by the designer. The frame parser 107200 shown in FIG. 9 can perform a reverse procedure of the procedure of the frame builder 101400 illustrated in FIG. 5 and thus detailed description thereof is omitted.

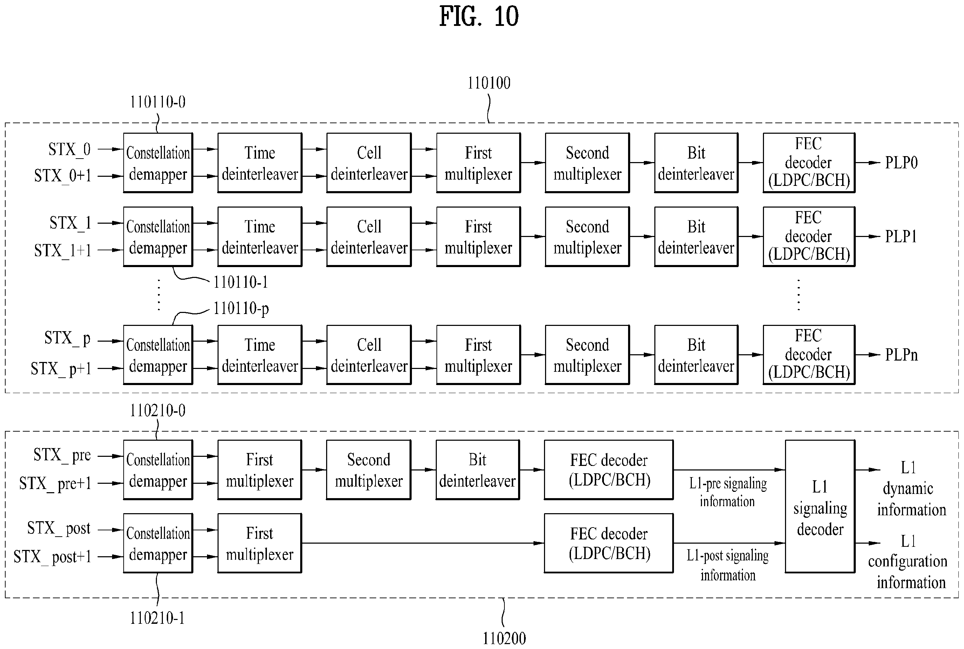

FIG. 10 illustrates the BICM decoder according to an embodiment of the present invention.

Referring to FIG. 10, the BICM decoder 107300 may include a first BICM decoding block 110100 for processing data SRx_0 to SRx_P+1 output through the first and second paths from the frame demapper 107200 and a second BICM decoding block 110200 for processing data SRx_pre to SRx_post+1 output through the first and second paths. In this case, p+1 constellation demappers 110110-0 to 110110-p included in the first BICM decoding block 110100 and two constellation demappers 110210-0 and 110210-1 included in the second BICM decoding block 110200 may rotate constellations by a predetermined angle, delay only Q-phase components of the constellations by a predetermined value and calculate LLR values in consideration of the constellation rotation angle. If constellation rotation and Q-phase component delay are not performed, the LLR values can be calculated on the basis of normal QAM. The p+1 constellation demappers 110110-0 to 110110-p included in the first BICM decoding block 110100 and the two constellation demappers 110210-0 and 110210-1 included in the second BICM decoding block 110200 may be located before the cell interleaver, which may be modified by the designer.

The BICM decoder 107300 according to the present invention may include a MISO decoder or a MIMO decoder according to the intention of the designer. In this case, the MISO decoder or the MIMO decoder may follow the cell interleaver or the constellation demappers. This may be modified according to the designer.

In FIG. 10, a first multiplexer merges cells respectively received through the first and second paths into one cell stream, and a second multiplexer restores bits allocated to a cell in the form of a bitstream before allocation. The first multiplexer may be referred to as a merger.

Other blocks included in the BICM decoder 107300 may perform a reverse procedure of the procedure of the BICM encoder illustrated in FIG. 4 and thus detailed description thereof is omitted.

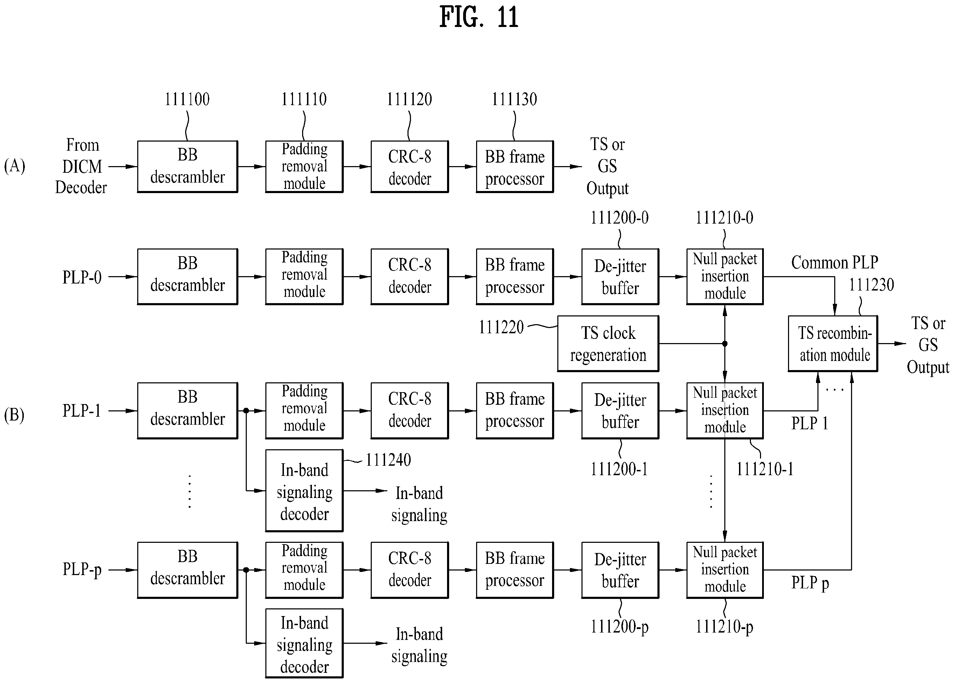

FIG. 11 illustrates the output processing module of the broadcast signal receiver according to an embodiment of the present invention.

The output processing module 107500 shown in FIG. 11(A) corresponds to the input processing module 101100 for processing a single PLP, illustrated in FIG. 1(A), and performs a reverse procedure of the procedure of the input processing module 101100. The output processing module 107500 may include a BB descrambler 111100, a padding removal module 111110, a CRC-8 decoder 111120 and a BB frame processor 111130. The output processing module 107500 shown in FIG. 11 (A) may receive a bitstream from the BICM decoder 107300 (or decoding module) of the broadcast signal receiver, which performs a reverse procedure of the BICM encoding procedure of the broadcast signal transmitter and performs a reverse procedure of the procedure of the input processing module 101200 illustrated in FIG. 1, and thus detailed description thereof is omitted.

FIG 11 (B) illustrates the output processing module 107500 of the broadcast signal receiver according to another embodiment of the present invention. The output processing module 107500 shown in FIG. 11 (B) may correspond to the input processing module 101200 for processing a plurality of PLPs, illustrated in FIG. 2(B), and perform a reverse procedure of the procedure of the input processing module 101200. The output processing module 107500 shown in FIG. 11 (B) may include a plurality of blocks for processing a plurality of PLPs. Specifically, the output processing module 107500 may include p+1 BB descramblers, p+1 padding removal modules, p+1 CRC-8 decoders, p+1 BB frame processors, p+1 de-jitter buffers 111200-0 to 111200-p for compensating a delay inserted by the broadcast signal transmitter for synchronization of the plurality of PLPs according to time to output (TTO) parameter information, p+1 null packet insertion modules 111210-0 to 111210-p for restoring null packets cancelled by the transmitter with reference to deleted null packet (DNP) information, a TS clock regeneration module 111220 for restoring detailed time synchronization of output packets on the basis of input stream time reference (ISCR) information, an in-band signaling decoder 111240 for restoring and outputting in-band signaling information transmitted through padding bit fields of data PLPs, and a TS recombining module 111230 for receiving data PLPs related to a restored common PLP and restoring original TSs, IPs or GSs. The output processing module 107500 shown in FIG. 11(B) may include an L1 signaling decoder (not shown). Descriptions of the blocks corresponding to the blocks shown in FIG. 11 (A) are omitted.

Processing of the plurality of PLPs according to the broadcast signal receiver may be described for a case in which data PLPs related to a common PLP are decoded or a case in which the broadcast signal receiver simultaneously decodes a plurality of services or service components (e.g. components of scalable video service (SVS)). The BB descramblers, padding removal modules, CRC-8 decoders and BB frame processors correspond to those illustrated in FIG. 11 (A).

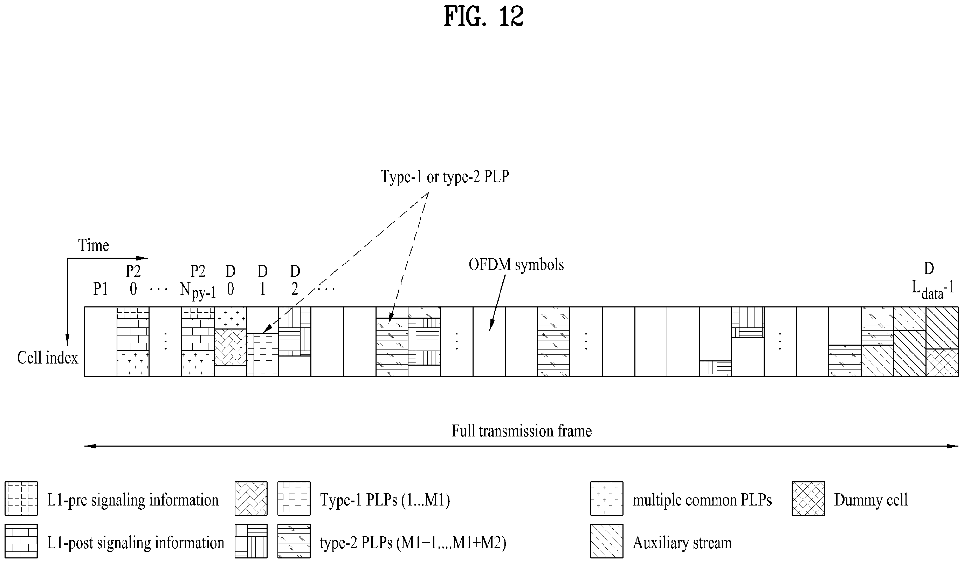

FIG. 12 illustrates an additional frame structure based on PLP according to an embodiment of the present invention.

As shown in FIG. 12, a frame according to an embodiment of the present invention may include a preamble area and a data area. The preamble area may include a P1 symbol and a P2 symbol and the data area may include a plurality of data symbols.

The P1 symbol may transmit P1 signaling information associated with a basic transmission parameter and transmission type and a corresponding preamble identifier and the receiver may detect the frame using the P1 symbol. A plurality of P2 symbols may be provided and may carry L1 signaling information and signaling information such as a command PLP. The common PLP may include network information such as a Network Information Table (NIT), PLP information, and service information such as a Service Description Table (SDT) or an Event Information Table (EIT).

A plurality of data symbols located next to the P1 symbol may include a plurality of PLPs. The plurality of PLPs may include audio, video, and data TS streams and PSI/SI information such as a Program Association Table (PAT) and a Program Map Table (PMT). In the present invention, a PLP that transmits PSI/SI information may be referred to as a base PLP or a signaling PLP. The PLPs may include a type-1 PLP that is transmitted through one sub-slice per frame and a type-2 PLP that is transmitted through two sub-slices per frame. The plurality of PLPs may transmit one service and may also transmit service components included in one service. When the PLPs transmit service components, the transmitting side may transmit signaling information which indicates that the PLPs transmit service components.

In addition, additional data (or an enhanced broadcast signal) in addition to basic data may be transmitted through a specific PLP while sharing an RF frequency band with the conventional terrestrial broadcast system according to an embodiment of the present invention. In this case, the transmitting side may define a system or a signal that is currently transmitted through signaling information of the P1 symbol described above. The following description is given with reference to the case in which the additional data is video data. That is, as shown in FIG. 12, PLP M1 112100 and PLP (M1+M2) 112200 which are type 2 PLPs may be transmitted while including additional video data. In addition, in the present invention, a frame that transmits such additional video data may be referred to as a new frame.

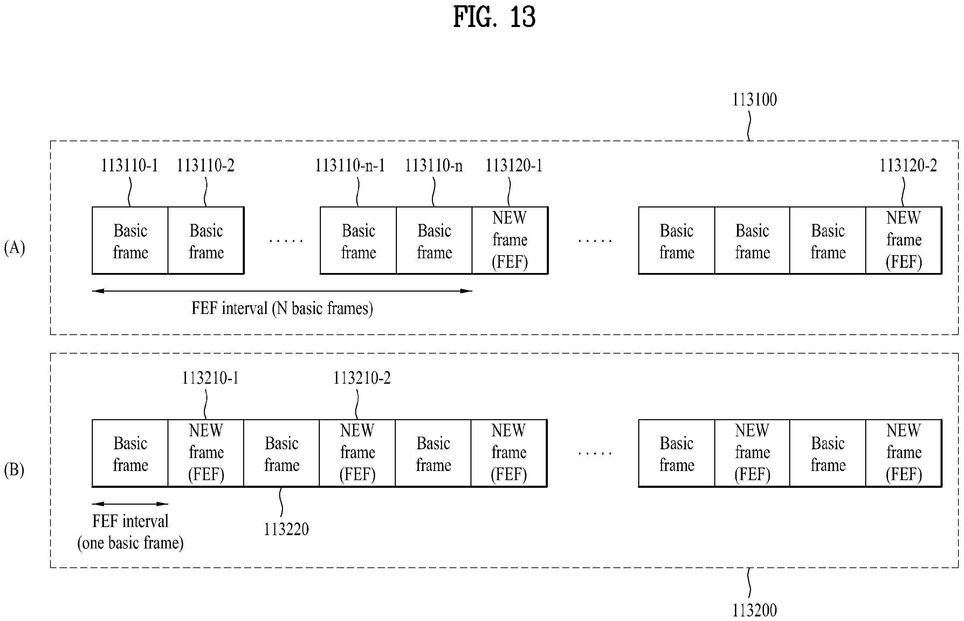

FIG. 13 illustrates a structure of an FEF based new transmission frame according to an embodiment of the present invention.

Specifically, FIG. 13 shows the case in which a Future Extension Frame (FEF) is used in order to transmit additional video data. In the present invention, a frame that transmits basic video data may be referred to as a basic frame and an FEF that transmits additional video data may be referred to as a new frame.

FIG. 13 shows structures of superframes 11100 and 113200 in each of which a basic frame and new frame are multiplexed. Frames 113100-1 to 113100-n that are not shaded from among frames included in the superframe 113100 are basic frames and shaded frames 113120-1 and 113120-2 are new frames.

FIG. 13(a) shows the case in which the ratio of basic frames to additional frames is N:1. In this case, the time required for the receiver to receive a next additional frame 113120-2 after receiving one additional frame 113120-1 may correspond to N basic frames.

FIG. 13(b) shows the case in which the ratio of basic frames to additional frames is 1:1. In this case, the proportion of additional frames in the superframe 113200 may be maximized and therefore the additional frames may have a structure very similar to that of the basic frames in order to maximize the extent of sharing with the basic frames. In addition, in this case, the time required for the receiver to receive a next additional frame 113210-2 after receiving one additional frame 113210-1 corresponds to 1 basic frame 113220 and therefore the superframe period is shorter than that of FIG. 13(b).

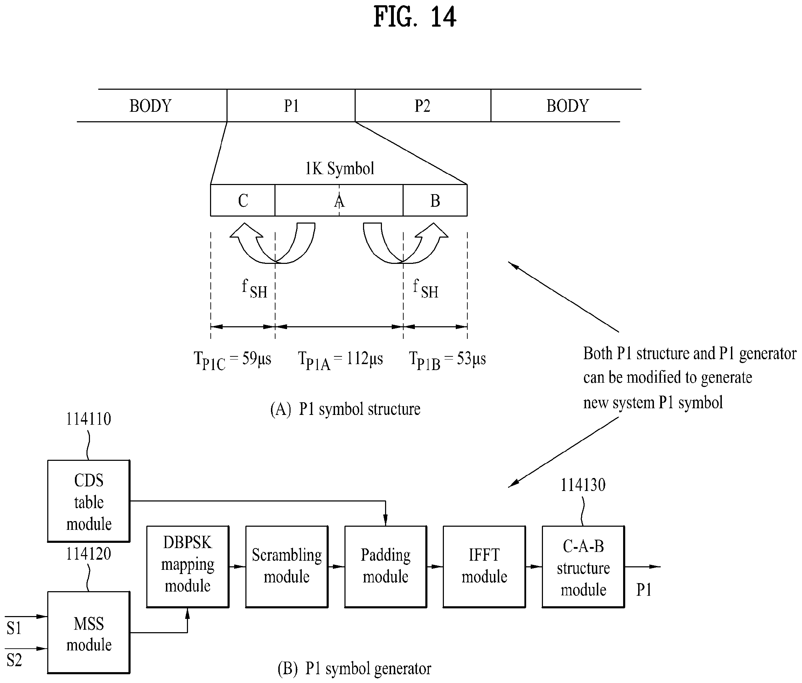

FIG. 14 illustrates a P1 symbol generation procedure for identifying additional frames according to an embodiment of the present invention.

In the case in which additional video data is transmitted through additional frames which are distinguished from basic frames as shown in FIG. 13, there is a need to transmit additional signaling information for enabling the receiver to identify and process an additional frame. An additional frame of the present invention may include a P1 symbol for transmitting such additional signaling information and the P1 symbol may be referred to as a new_system_P1 symbol. This new_system_P1 symbol may be different from a P1 symbol that is used in a conventional frame and a plurality of new_system_P1 symbols may be provided. In an embodiment, the new_system_P1 symbol may be located before a first P2 symbol in a preamble area of the frame.

The present invention may modify the P1 symbol of a conventional transmission frame and use the modified P1 symbol in order to generate the new_system_P1 symbol. To achieve this, the present invention proposes a method of generating the new_system_P1 symbol by modifying the P1 symbol structure of the conventional transmission frame or modifying a symbol generator 114100.

FIG. 14(A) shows the P1 symbol structure of the conventional transmission frame. In the present invention, it is possible to modify the PI symbol structure of the conventional transmission frame shown in FIG. 14(A) to generate the new_symbol_P1 symbol. In this case, the new_system_P1 symbol may be generated by changing frequency shift values f_SH for prefix and post fix of the conventional P1 symbol or by changing the duration (T_P1C or T_P1B) of the P1 symbol. However, when the P1 symbol structure is modified to generate an AP1 symbol, parameters f_SH, T_P1C and T_P1B used for the P1 symbol structure need to be appropriately modified.

FIG. 14(B) illustrates a P1 symbol generator for generating a P1 symbol. The present invention may generate the new_system_P1 symbol by modifying the P1 symbol generator shown in FIG. 14B. In this case, it is possible to generate the new_system_P1 symbol using a method of changing a distribution of active carriers used for a P1 symbol in a CDS table module 114110, an MSS module 114120 and a C-A-B structure module 114130 included in the P1 symbol generator 114100 (e.g. the CDS table module 114110 uses a different complementary set of sequence (CSS)) or a method of changing a pattern for information transmitted through the P1 symbol (e.g. the MSS module 114120 uses a different CSS).

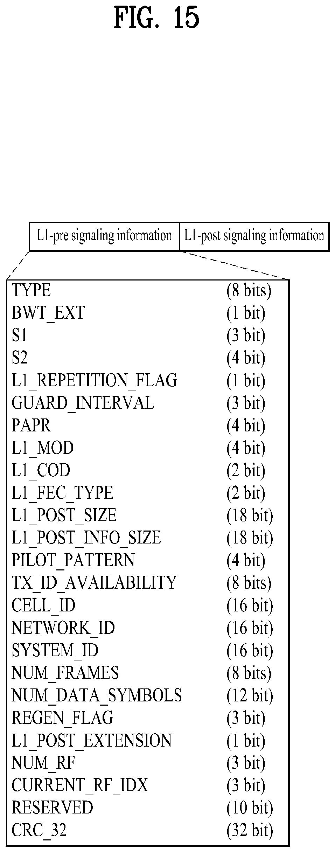

FIG. 15 shows L1-pre signaling information included in a transmitted/received signal according to an embodiment of the present invention.

As described above, L1 signaling information may include P1 signaling information, L1-pre signaling information and L1-post signaling information. The P1 signaling information (not shown) may be located prior to the L1-pre signaling information. The P1 signaling information may include an S1 field and an S2 field. The S1 field may include identifiers for indicating formats of a preamble region and the S2 field may include identifiers for indicating side information.

FIG. 15 shows an embodiment of a table included in the L1-pre signaling information. The L1-pre signaling information may include information necessary to receive and decode the L1-post signaling information. Fields included in the table will now be described. The size of each field and field types that can be included in the table may be changed.

The TYPE field has 8 bits and may indicate whether the type of an input stream is TS or GS.

The BWT_EXT field has 1 bit and may indicate bandwidth extension of an OFDM symbol.

The S1 field has 3 bits and may represent whether a current transmission system is a MISO system or a MIMO system.

The S2 field has 4 bits and may indicate an FFT size.

The L1_REPETITION_FLAG field has 1 bit and may represent a repetition flag of an L1 signal.

The GUARD_Interval field has 3 bits and may indicate the size of a guard interval of the current transmission system.

The PAPR field has 4 bits and may indicate a PAPR reduction scheme. As described above, ACE or TR scheme may be used as the PAPR scheme in the present invention.

The L1_MOD field has 4 bits and may indicate QAM modulation type of the L1-post signaling information.

The L1_COD field has 2 bits and may indicate the code rate of the L1-post signaling information.

The L1_FEC_TYPE field has 2 bits and may indicate the FEC type of the L1-post signaling information.

The L1_POST_SIZE field has 18 bits and may indicate the size of the L1-post signaling information.

The L1_POST_INFO_SIZE field has 18 bits and may indicate the size of an information region of the L1-post signaling information.

The PILOT_PATTERN field has 4 bits and may indicate a pilot insertion pattern.

The TX_ID_AVAILABILITY field has 8 bits and may indicate transmitter identification availability in a current geographical cell range.

The CELL_ID field has 16 bits and may indicate a cell identifier.

The NETWORK_ID field has 16 bits and may indicate a network identifier.

The SYSTEM_ID field has 16 bits and may indicate a system identifier.

The NUM_FRAMES field has 8 bits and may indicate the number of transmission frames per super-frame.

The NUM_DATA_SYMBOLS field 12 bits and may indicate the number of OFDM symbols per transmission frame.

The REGEN_FLAG field has 3 bits and may indicate the number of regenerations of a signal according to a repeater.

The L1_POST_EXTENSION field has 1 bit and may indicate presence or absence of an extension block of the L1-post signaling information.

The NUM_RF field has 3 bits and may indicate the number of RF bands for TFS.

The CURRENT_RF_IDX field has 3 bits and may indicate the index of a current RF channel.

The RESERVED field has 10 bits and is reserved for later use.

The CRC_32 field has 32 bits and may indicate a CRC error extraction code of the L1-pre signaling information.

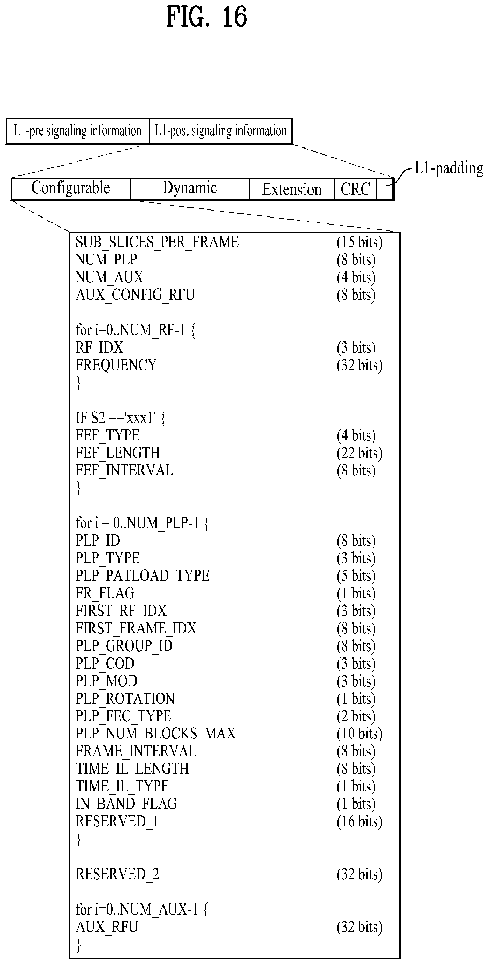

FIG. 16 shows L1-post signaling information included in a transmitted/received signal according to an embodiment of the present invention.

The L1-post signaling information may include parameters necessary for the receiver to encode PLP data.

The L1-post signaling information may include a configurable block, a dynamic block, an extension block, a cyclic redundancy check (CRC) block, and an L1 padding block.

The configurable block may include information equally applied to one transmission frame and the dynamic block may include characteristic information corresponding to a currently transmitted frame.

The extension block may be used when the L1-post signaling information is extended, and the CRC block may include information used for error correction of the L1-post signaling information and may have 32 bits. The padding block may be used to adjust sizes of information respectively included in a plurality of encoding blocks to be equal when the L1-post signaling information is transmitted while being divided into the encoding blocks and has a variable size.

FIG. 16 shows a table included in the configurable block, which includes the following fields. The size of each field and field types that can be included in the table are variable.

The SUB_SLICES_PER_FRAME field has a size of 15 bits and may indicate the number of sub-slices per transmission frame.

The NUM_PLP field has a size of 8 bits and may indicate the number of PLPs.

The NUM_AUX field has a size of 4 bits and may indicate the number of auxiliary streams.

The AUX_CONFIG_RFU field has a size of 8 bits and is a reserved region.

The following fields are included in a frequency loop.

The RF_IDX field has a size of 3 bits and may indicate an RF channel index.

The FREQUENCY field has a size of 32 bits and may indicate an RF channel frequency.

The following fields are used only when the LSB of S2 field is 1, that is, when S2='xxx1'.

The FEF_TYPE field has a size of 4 bits and may be used to indicate a future extension frame (FEF).

The FEF_LENGTH field has a size of 22 bits and may indicate the length of an FEF.

The FEF_INTERVAL field has a size of 8 bits and may indicate the duration of an FEF interval.

The following fields are included in a PLP loop.

The PLP_ID field has a size of 8 bits and may be used to identify a PLP.

The PLP_TYPE field has a size of 3 bits and may indicate whether a current PLP is a common PLP or a PLP including normal data.

The PLP_PAYLOAD_TYPE field has a size of 5 bits and may indicate a PLP payload type.

The FF_FLAG flag has a size of 1 bit and may indicate a fixed frequency flag.

The FIRST_RF_IDX field has a size of 3 bits and may indicate the index of the first RF channel for TFS.

The FIRST_FRAME_IDX field has a size of 8 bits and may indicate the first frame index of a current PLP in a super-frame.

The PLP_GROUP_ID field has a size of 8 bits and may be used to identify a PLP group. A PLP group may be referred to as a link-layer-pipe (LLP) and PLP_GROUP_ID field is called LLP_ID field in an embodiment of the present invention.

The PLP_COD field has a size of 3 bits and may indicate a code rate of a PLP.

The PLP_MOD field has a size of 3 bits and may indicate a QAM type of a PLP.

The PLP_ROTATION field has a size of 1 bit and may indicate a constellation rotation flag of a PLP.

The PLP_FEC_TYPE field has a size of 2 bits and may indicate FEC type of a PLP.

The PLP_NUM_BLOCKS_MAX field has a size of 10 bits and may indicate a maximum number of PLPs of FEC blocks.

The FRAME_INTERVAL field has a size of 8 bits and may indicate an interval of a transmission frame.

The TIME_IL_LENGTH field has a size of 8 bits and may indicate a symbol interleaving (or time interleaving) depth.

The TIME_IL_TYPE field has a size of 1 bit and may indicate a symbol interleaving (or time interleaving) type.

The IM-BAND_B_FLAG field has a size of 1 bit and may indicate an in-band signaling flag.

The RESERVED_1 field has a size of 16 bits and is used in the PLP loop in the future.

The RESERVED_2 field has a size of 32 bits and is used in the configurable block in the future.

The following fields are included in an auxiliary stream loop.

The AUX_RFU field has a size of 32 bits and may be used in the auxiliary stream loop in the future.

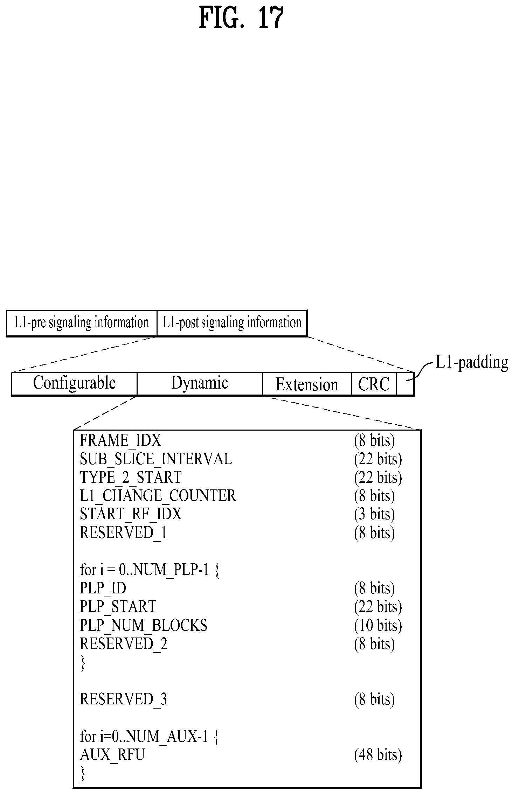

FIG. 17 shows L1-post signaling information included in a transmitted/received signal according to another embodiment of the present invention.

A table shown in FIG. 17 is included in the dynamic block and includes the following fields. The size of each field and field types that can be included in the table are variable.

The FRAME_IDX field has a size of 8 bits and may indicate a frame index in a super-frame.

The SIB_SLICE_INTERVAL field has a size of 22 bits and may indicate a sub-slice interval.

The TYPE_2_START field has a size of 22 bits and may indicate a start position of PLPs of a symbol interleaver over a plurality of frames. L1_CHANGE_COUNTER field has a size of 8 bits and may indicate a change in L1 signaling.

The START_RF_IDX field has a size of 3 bits and may indicate a start RF channel index for TFS.

The RESERVED_1 field has a size of 8 bits and is a reserved field.

The following fields are included in the PLP loop.

The PLP_ID field has a size of 8 bits and may be used to identify each PLP.

The PLP_START field has a size of 22 bits and may indicate a PLP start address in a frame.

The PLP_NUM_BLOCKS field has a size of 10 bits and may indicate the number of PLPs of FEC blocks.

The RESERVED_2 field has a size of 8 bits and may be used in the PLP loop in the future.

The RESERVED_3 field has a size of 8 bits and may be used in the dynamic block in the future.

The following field is included in the auxiliary stream loop.

The AUX_RFU field has a size of 48 bits and may be used in the auxiliary stream loop in the future.

Signals transmitted through paths from a plurality of antennas of a broadcast signal transmitter to a plurality of antennas of a broadcast signal receiver may be transmitted through different channels or through identical or similar channels. If signals are transmitted through identical or similar channels using MIMO, the receiver cannot separate the signals received from the transmitter because inter-channel correlation is high. Accordingly, it is necessary to adaptively acquire signals through MIMO processing depending on inter-channel correlation, which is called a hierarchical MIMO scheme. A description will be given of a broadcast signal transceiver using the hierarchical MIMO scheme.

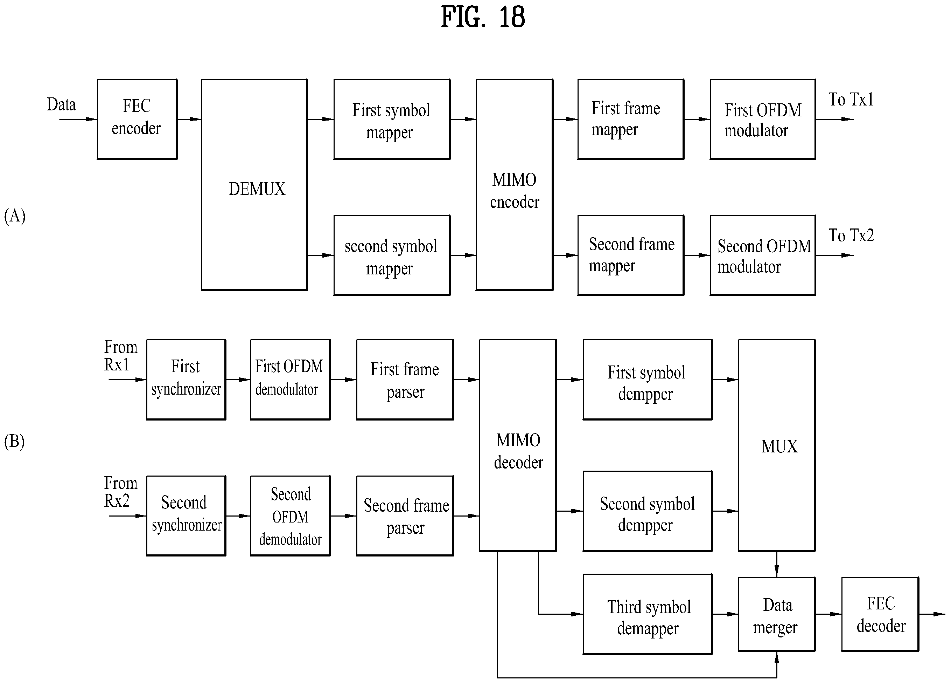

FIG. 18 is a block diagram of a broadcast signal transceiver according to another embodiment of the present invention.

FIG. 18(A) illustrates a broadcast transmitter according to another embodiment of the present invention.

Referring to FIG. 18(A), the broadcast signal transceiver according to another embodiment of the present invention may include an FEC encoder for encoding input PLP data, a demultiplexer for bit-interleaving the encoded PLP data for each FEC block, first and second symbol mappers for demultiplexing the data with the most significant bit (MSB) and the least significant bit (LSB) among bits to be mapped to symbols and outputting the demultiplexed data through first and second paths, a MIMO encoder for receiving hierarchically mapped symbols and MIMO-encoding the received symbols, first and second frame mappers for generating signal frames to be transmitted through the first and second paths, and first and second OFDM modulators for modulating the signal frames according to OFDM and transmitting the modulated signal frames through first and second antennas. The first and second symbol mappers may have different symbol mapping schemes. Accordingly, if data is transmitted at (M+N) bps/Hz through the two antennas, the first symbol mapper can map the data of M bps/Hz to symbols whereas the second symbol mapper can map the data of N bps/Hz to symbols.

FIG. 18(B) illustrates a broadcast signal receiver according to another embodiment of the present invention.

As shown in FIG. 18(B), the broadcast signal receiver according to another embodiment of the present invention may include first and second synchronization units for acquiring synchronization of signals received through first and second antennas in the time and frequency domains, first and second OFDM demodulators for respectively demodulating the signals for which synchronization has been acquired according to OFDM and performing channel equalization for the signals received through the first and second antennas, first and second frame parsers for respectively parsing signal frames from the signals equalized on the two antenna paths, a hierarchical MIMO decoder for calculating channel correlation using channel information and performing MIMO decoding on signals included in the parsed signal frames depending on the calculated channel correlation, first, second and third symbol demappers for symbol-demapping the signals divided by the MIMO decoder according to control signals using hierarchical demodulation or a demodulation scheme, a multiplexer for multiplexing bitstreams symbol-demapped by the first and second symbol demappers, a data merger for receiving channel information according to the channel correlation from the MIMO decoder and selectively outputting bitstreams output from the multiplexer and the third symbol demapper, and an FEC decoder for performing error correction decoding on the bitstream output from the data merger.

When the channel correlation is low, the first and second symbol demappers may respectively receive symbols output from the MIMO decoder, demap the received symbols according to symbol mapping schemes thereof, and output bitstreams corresponding to the MSB and LSB of the received data. When the channel correlation is high, the third symbol demapper may demap symbols corresponding to a combined signal of the signals transmitted through the antenna paths.

In the case of a broadcast signal transmitter using MIMO, data rate may depend on a symbol mapping scheme and, when data is transmitted through two or more transmission paths, the data rates largely depend on the symbol mapping scheme. In this case, it is possible to control the data rate using as many different symbol mapping schemes as the number of transmission paths. This method is called a hybrid MIMO scheme. A description will be given of a broadcast signal transceiver using the hybrid MIMO scheme.

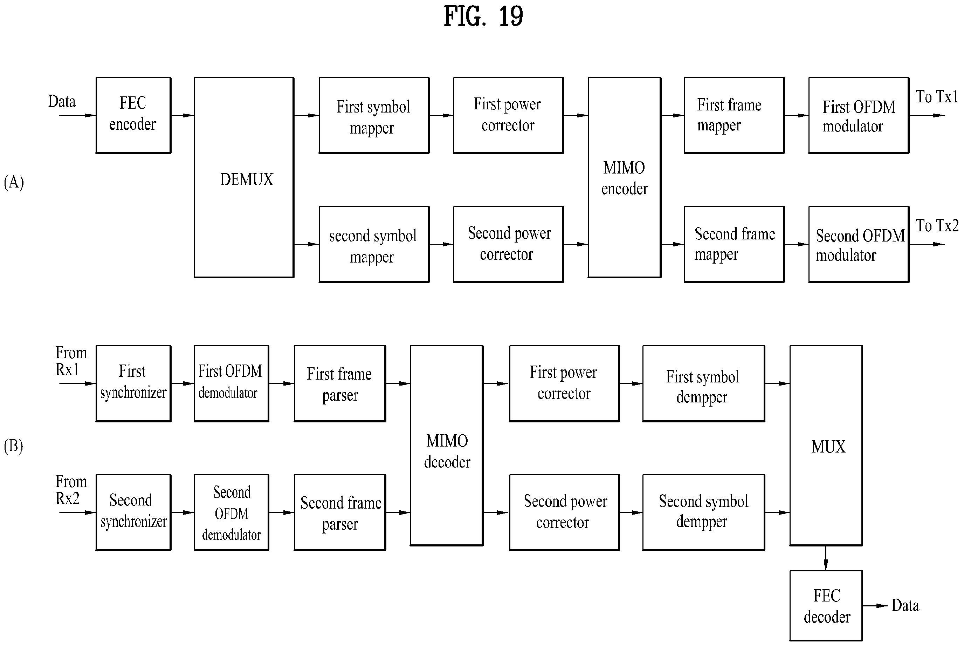

FIG. 19 is a block diagram of a broadcast signal transceiver according to another embodiment of the present invention.

FIG. 19(A) illustrates a broadcast signal transmitter according to another embodiment of the present invention. Referring to FIG. 19(A), the broadcast signal transmitter according to another embodiment of the present invention may include an FEC encoder for performing error correction coding on data to be transmitted according to a predetermined error correction coding scheme, a demultiplexer for dividing the error-correction-coded data and respectively outputting the divided data through a plurality of paths, first and second symbol mappers for respectively mapping the data received through the respective paths to symbols, first and second power correctors for controlling power of the symbols such that the symbols are transmitted with optimized power, a MIMO encoder for receiving the mapped symbols and MIMO-encoding the received symbols, first and second frame mappers for generating signal frames to be transmitted through antenna paths, and first and second OFDM modulators for modulating the signal frames according to OFDM and transmitting the modulated signal frames through antennas.

The first and second symbol mappers may have different symbol mapping schemes. The first and second power correctors may control the power of the symbols according to the two different symbol mapping schemes. For example, the first and second power correctors can adjust the power of the symbols to average power of the symbols according to the two symbol mapping schemes.

FIG. 19(B) illustrates a broadcast signal receiver according to another embodiment of the present invention.

As shown in FIG. 19(B), the broadcast signal receiver according to another embodiment of the present invention may include first and second synchronization units, first and second OFDM demodulators, first and second frame parsers, a MIMO decoder, first and second power correctors, first and second symbol demappers, a multiplexer, and an FEC decoder. The broadcast signal receiver according to the present embodiment can demap signals received through a plurality of antennas using the hybrid MIMO scheme according to different symbol demapping schemes. The broadcast signal receiver performs a reverse procedure of the procedure of the broadcast signal transmitter illustrated in FIG. 19(A), and thus detailed description thereof is omitted.

In addition, the present invention proposes a MIMO system using scalable video coding (SVC). SVC is a video coding method developed to cope with a variety of terminals and communication environments and variations in the terminals and communication environments. SVC can code a video hierarchically such that desired definition is generated and transmit additional video data having a base layer from which video data about an image having basic definition can be restored and an enhancement layer from which an image having higher definition can be restored. Accordingly, a receiver can acquire the basic definition image by receiving and decoding only the video data of the base layer, or obtain the higher definition image by decoding the video data of the base layer and the video data of the enhancement layer according to characteristics thereof. In the following description, the base layer can include video data corresponding to the base layer and the enhancement layer can include video data corresponding to the enhancement layer. In the following, video data may not be a target of SVC, the base layer can include data capable of providing a fundamental service including basic video/audio/data corresponding to the base layer, and the enhancement layer can include data capable of providing a higher service including higher video/audio/data corresponding to the enhancement layer.

The present invention proposes a method of transmitting the base layer of SVC through a path through which signals can be received according to SISO or MISO using SVC and transmitting the enhancement layer of SVC through a path through which signals can be received according to MIMO in the broadcast system of the present invention. That is, the present invention provides a method by which a receiver having a single antenna acquires an image with basic definition by receiving the base layer using SISO or MISO and a receiver having a plurality of antennas acquires an image with higher definition by receiving the base layer and the enhancement layer using MIMO.

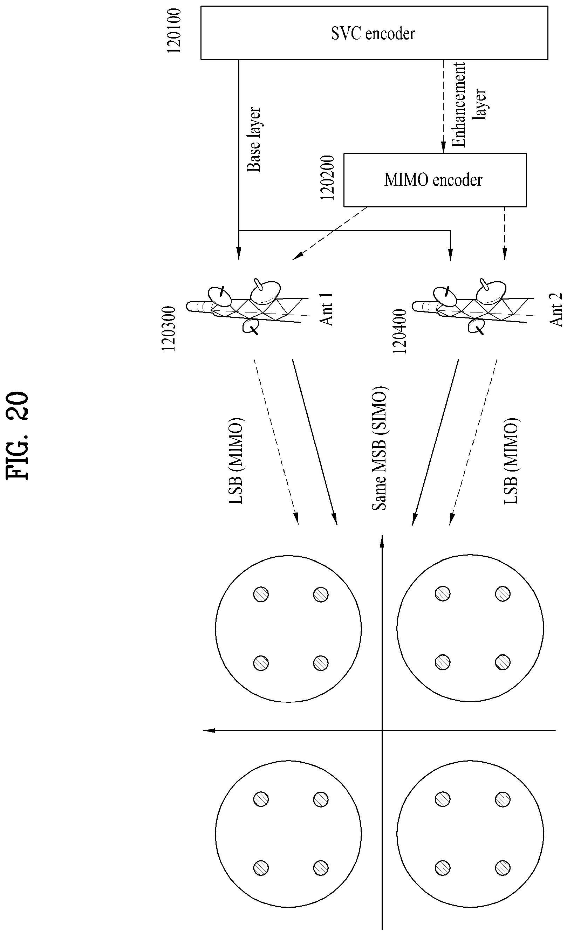

FIG. 20 illustrates a MIMO broadcast signal transmitter and a transmission method using SVC according to an embodiment of the present invention.

Referring to FIG. 20, the broadcast signal transmitter may include an SVC encoder 120100 for encoding a broadcast service using SVC, and a MIMO encoder 120200 for distributing data according to a space diversity or space multiplexing scheme such that the data can be transmitted through a plurality of antennas. The broadcast signal transmitter shown in FIG. 20 uses hierarchical modulation.

The SVC encoder 120100 encodes a broadcast service and outputs a base layer and an enhancement layer. The base layer is transmitted as the same data through a first antenna (Ant1) 120300 and a second antenna (Ant2) 120400. The enhancement layer is encoded by the MIMO encoder 120200 and transmitted as the same data or different data through the first and second antennas 120300 and 120400. In this case, the transmitter performs symbol mapping during data modulation, which is shown in the left of FIG. 20 (a symbol mapper is not shown).

The broadcast signal transmitter may map bits corresponding to the base layer to the MSB of data modulated during symbol mapping and map bits corresponding to the enhancement layer to the LSB of the data by performing hierarchical modulation.

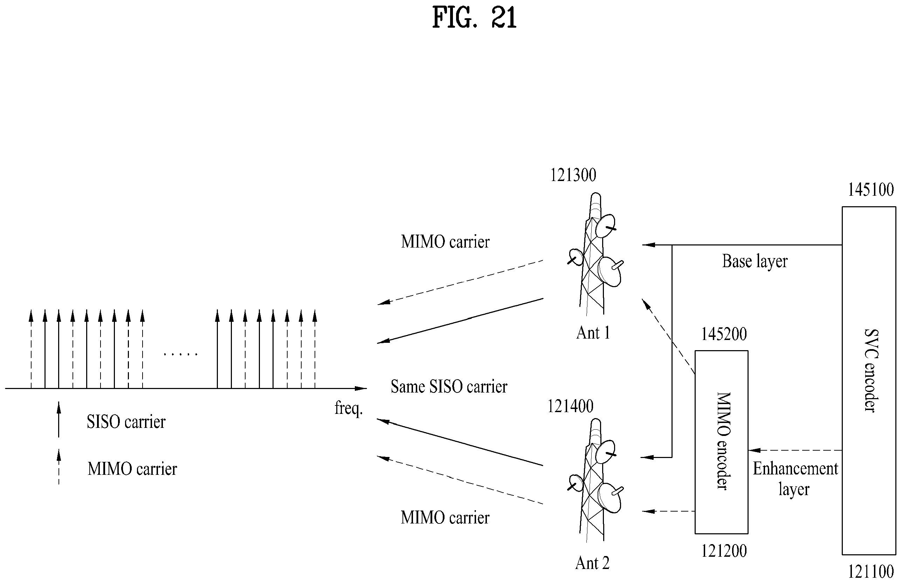

FIG. 21 illustrates a MIMO broadcast signal transmitter and a transmission method using SVC according to another embodiment of the present invention.

Referring to FIG. 21, the broadcast signal transmitter may include an SVC encoder 121100 for encoding a broadcast signal using SVC, and a MIMO encoder 121200 for distributing data according to a space diversity or space multiplexing scheme such that the data can be transmitted through a plurality of antennas. The broadcast signal transmitter shown in FIG. 21 uses frequency division multiplexing (FDM).

The SVC encoder 121100 encodes a broadcast service and outputs a base layer and an enhancement layer. The base layer is transmitted as the same data through a first antenna (Ant1) 121300 and a second antenna (Ant2) 121400. The enhancement layer is encoded by the MIMO encoder 121200 and transmitted as the same data or different data through the first and second antennas 121300 and 121400.

The broadcast signal transmitter may process data using FDM in order to improve data transmission efficiency and, particularly, may transmit data through a plurality of subcarriers using OFDM. In addition, the broadcast signal transmitter may classify subcarriers into subcarriers used to transmit SISO/MISO signals and subcarriers used to transmit MIMO signals and transmit the signals using the subcarriers. The base layer output from the SVC encoder 121100 may be transmitted through the plurality of antennas using SISO/SISO carriers, whereas the enhancement layer may be MIMO-encoded and then transmitted through the plurality of antennas using MIMO carriers.

A broadcast signal receiver may receive OFDM symbols, acquire the base layer by decoding data corresponding to the SISO/MISO carriers and acquire the enhancement layer by MIMO-decoding data corresponding to the MIMO carriers. Then, the service may be restored and provided using only the base layer when MIMO decoding cannot be performed, and using both the base layer and the enhancement layer when MIMO decoding can be performed according to channel state and reception system. In the second embodiment, since bit information of a service is subjected to MIMO processing after mapped to symbols, the MIMO encoder 121200 can be located after the symbol mapper so as to simplify the configuration of the broadcast signal transmitter than that of the broadcast signal transmitter shown in FIG. 21.

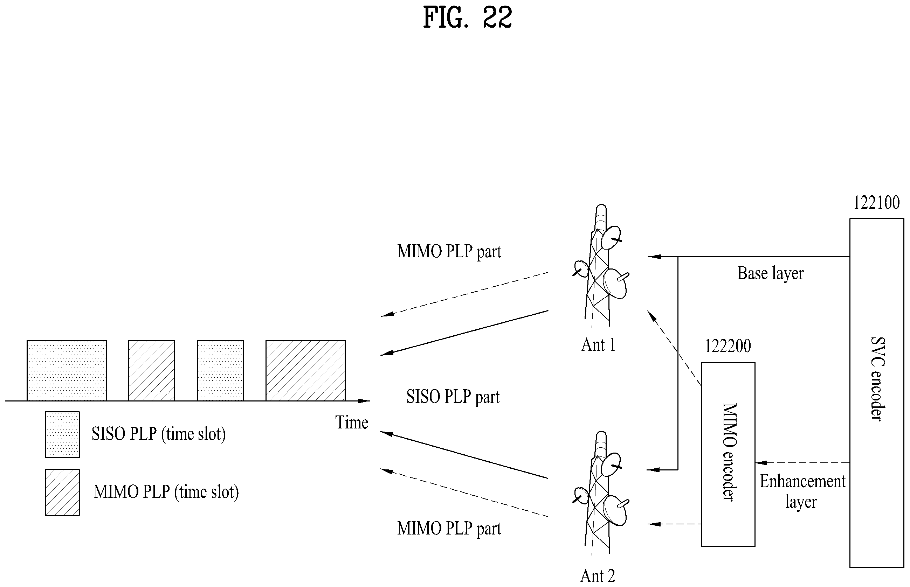

FIG. 22 illustrates a MIMO broadcast signal transmitter and transmission method using SVC according to another embodiment of the present invention.

Referring to FIG. 22, the broadcast signal transmitter may include an SVC encoder 122100 for encoding a broadcast service using SVC and a MIMO encoder 122200 for distributing data through space diversity or space multiplexing such that the data can be transmitted through a plurality of antennas. The broadcast signal transmitter shown in FIG. 22 uses time division multiplexing (TDM).

In the embodiment shown in FIG. 22, the broadcast signal transmitter may respectively transmit a base layer and an enhancement layer encoded according to SVC through SISO/MISO slots and MIMO slots. These slots may be time or frequency slots and they are time slots in the embodiment shown in FIG. 22. Otherwise, the slots may be PLPs. A broadcast signal receiver checks the type of received slots, receives the base layer from SISO/MISO slots and receives the enhancement layer from MIMO slots. As described above, the receiver may restore the service using only the base layer or by performing MIMO decoding and using both the base layer and the enhancement layer according to channel or receiver state.

In the above-mentioned first to third embodiments, the methods of generating the base layer and the enhancement layer using SVC and transmitting the base layer and the enhancement layer using one of SISO/SIMO and MIMO have been described. The base layer and the enhancement layer transmitted in this manner correspond to MIMO broadcast data. A description will be given of a method of transmitting the MIMO broadcast data including the base layer and the enhancement layer in association with terrestrial broadcast frames for transmitting terrestrial broadcast signals. In the following description, the MIMO broadcast data including the base layer and the enhancement layer may be generated according to one of the first to third embodiments or according to a combination of one or more of the first to third embodiments.

(1) Method of transmitting MIMO broadcast data using predetermined PLP

It is possible to transmit the MIMO broadcast data included in a predetermined PLP while distinguishing the predetermined PLP from a PLP including terrestrial broadcast data. In this case, the predetermined PLP is used to transmit the MIMO broadcast data, and signaling information for describing the predetermined PLP may be additionally transmitted. In the following, the predetermined PLP including the MIMO broadcast data may be referred to as a MIMO broadcast PLP and the PLP including the terrestrial broadcast data may be referred to as a terrestrial broadcast PLP.

(2) Method of transmitting MIMO broadcast data using predetermined frame

It is possible to include the MIMO broadcast data generated as described above in a predetermined frame and to transmit the predetermined frame including the MIMO broadcast data while distinguishing the predetermined frame from a terrestrial broadcast frame. In this case, the predetermined frame is used to transmit the MIMO broadcast data, and signaling information for describing the predetermined frame may be additionally transmitted. The predetermined frame may be an FEF illustrated in FIG. 13. In the following description, the predetermined frame including the MIMO broadcast data is referred to as a MIMO broadcast frame.

**(3) Method of transmitting MIMO broadcast PLP using terrestrial broadcast frame and MIMO broadcast frame**

PLPs including MIMO broadcast data may be transmitted through a terrestrial broadcast frame and a MIMO broadcast frame. Since a MIMO broadcast PLP may be present in the terrestrial broadcast frame (or basic frame), distinguished from the above-mentioned embodiments, it is necessary to signal the relationship between connected PLPs present in the terrestrial broadcast frame and the MIMO broadcast frame. To achieve this, the MIMO broadcast frame may also include L1 signaling information, and information about the MIMO broadcast PLP present in the broadcast frame may be transmitted along with L1 signaling information of the terrestrial broadcast frame.

MIMO broadcast PLPs included in the MIMO broadcast frame may include SISO, MISO and MIMO PLPs. In this case, SISO/MISO PLPs or carriers may transmit the base layer and MIMO PLPs or carriers may transmit the enhancement layer. The proportion of the SISO/MISO PLPs or carriers and the proportion of the MIMO PLPs may vary between 0 to 100%, and the proportions may be differently set on a per frame basis.

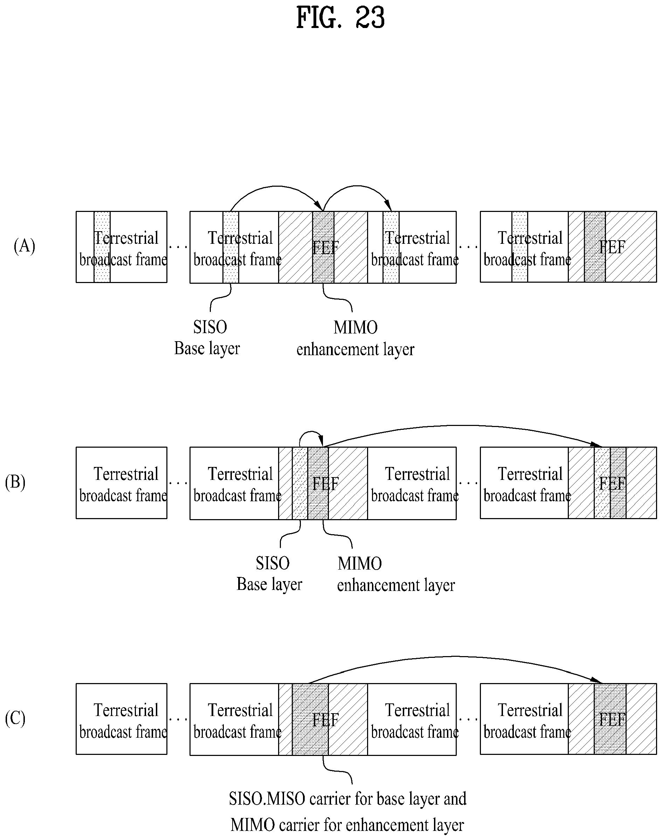

FIG. 23 shows structures of transmission streams transmitted by a terrestrial broadcast system to which the MIMO transmission system using SVC according to an embodiment of the present invention is applied. FIG. 23 illustrates exemplary broadcast signals using at least one of the methods described with reference to FIGS. 20 to 22 and the methods (1), (2) and (3).

FIG. 23(A) illustrates a broadcast signal including terrestrial broadcast frames and MIMO broadcast frames. In FIG. 23(A), MIMO broadcast PLPs may be present in the terrestrial broadcast frames and MIMO broadcast frames. MIMO broadcast PLPs included in the terrestrial broadcast frames are base layers and MIMO broadcast PLPs included in the MIMO broadcast frames are enhancement layers. The MIMO broadcast PLPs may be transmitted according to SISO, MISO or MIMO.

FIG. 23(B) illustrates a broadcast signal including terrestrial broadcast frames and MIMO broadcast frames. In FIG. 23(B), MIMO broadcast PLPs may be present in only MIMO broadcast frames. In this case, the MIMO broadcast PLPs may include a PLP including a base layer and a PLP including an enhancement layer.

FIG. 23(C) illustrates a broadcast signal including terrestrial broadcast frames and MIMO broadcast frames. MIMO broadcast data is present in only MIMO broadcast frames. However, a base layer and an enhancement layer may be distinguished from each other by carriers instead of PLPs and transmitted, distinguished from FIG. 23(C). That is, it is possible to respectively allocate data corresponding to the base layer and data corresponding to the enhancement layer to separate subcarriers, modulate the data according to OFDM, and transmit the modulated data, as described with reference to FIG. 21.

In the aforementioned MIMO broadcast system using SVC, the broadcast signal transmitter may receive and process a base layer and an enhancement layer while distinguishing the base layer and the enhancement layer from each other using PLPs. For example, in the mode adaptation block 102100 for processing a plurality of PLPs, shown in FIG. 2(B), the base layer can be included in PLP0 and the enhancement layer can be included in PLP1. The broadcast signal receiver corresponding to the broadcast signal transmitter may receive and process a broadcast signal including the base layer and the enhancement layer distinguished from each other by PLPs and transmitted from the broadcast signal transmitter. The broadcast signal transmitter may transmit the base layer and the enhancement layer using one PLP. In this case, the broadcast signal transmitter may include an SVC encoder for SVC-encoding data and outputting the data as a base layer and an enhancement layer. The broadcast signal receiver corresponding to the broadcast signal transmitter may receive and process a broadcast signal including a base layer and an enhancement layer transmitted through one PLP.

A description will be given of the MIMO transmission method in the above-mentioned broadcast signal transmitter and transmission method in more detail.

Various technologies are introduced to improve transmission efficiency and perform robust communication in a digital broadcast system. One of the technologies is a method of using a plurality of antennas at a transmitting side or a receiving side. This method may be divided into SISO, SIMO, MISO and MIMO. While multiple antennas are described as two antennas in the following, the present invention is applicable to systems using two or more antennas.

SISO is a normal broadcast system using a single transmit antenna and a single receive antenna. SIMO is a broadcast system using a single transmit antenna and multiple receive antennas.

MISO is a broadcast system that provides transmission diversity using a plurality of transmit antennas and a plurality of receive antennas. An example of MISO is Alamouti scheme. MISO can receive data using a single antenna without performance loss. While a reception system may receive the same data through a plurality of receive antennas for performance improvement, this is included in MISO in the specification.

MIMO is a broadcast system that provides transmit/receive diversity and high transmission efficiency using a plurality of transmit antennas and a plurality of receive antennas. MIMO can process signals differently in temporal and spatial dimensions and transmit a plurality of data streams through parallel paths simultaneously operating in the same frequency band to achieve diversity and high transmission efficiency.

In an embodiment, MIMO can use spatial multiplexing (SM) and Golden code (GC) schemes, which will be described in detail.

A modulation scheme in broadcast signal transmission may be represented as M-QAM (Quadrature Amplitude Modulation) in the following description. That is, BPSK (Binary Phase Shift Keying) can be represented by 2-QAM when M is 2 and QPSK (Quadrature Phase Shift Keying) can be represented by 4-QAM when M is 4. M can indicate the number of symbols used for modulation.

A description will be given of a case in which a MIMO system transmits two broadcast signals using two transmit antennas and receives two broadcast signals using two receive antennas as an example.

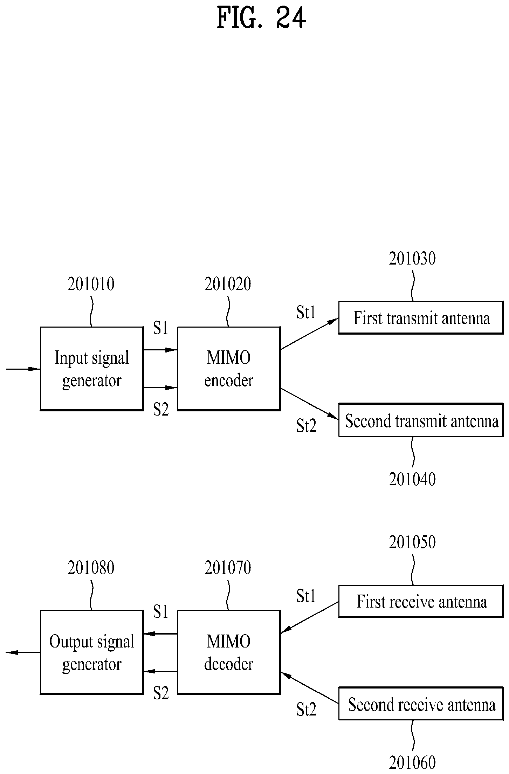

FIG. 24 illustrates MIMO transmission and reception systems according to an embodiment of the present invention.

As shown in FIG. 24, the MIMO transmission system includes an input signal generator 201010, a MIMO encoder 201020, a first transmit antenna 201030, and a second transmit antenna 201040. In the following, the input signal generator 201010 may be referred to as a divider and the MIMO encoder 201020 may be referred to as a MIMO processor.

The MIMO reception system may include a first receive antenna 201050, a second receive antenna 201060, a MIMO decoder 201070, and an output signal generator 201080. In the following, the output signal generator 201080 may be referred to as a merger and the MIMO decoder 101070 may be referred to as an ML detector.

In the MIMO transmission system, the input signal generator 201010 generates a plurality of input signals for transmission through a plurality of antennas. In the following, the input signal generator 201010 may be referred to as a divider. Specifically, the input signal generator 201010 may divide an input signal for transmission into 2 input signals and output the first input signal S1 and the second input signal S2 for MIMO transmission.

The MIMO encoder 201020 may perform MIMO encoding on the plurality of input signals S1 and S2 and output a first transmission signal St1 and a second transmission signal St2 for MIMO transmission and the output transmission signals may be transmitted through a first antenna 201030 and a second antenna 201040 via required signal processing and modulation procedures. The MIMO encoding 201020 may perform encoding on a per symbol basis. The SM scheme or the GC scheme may be used as the MIMO encoding method. In the following, the MIMO encoder may be referred to as a MIMO processor. Specifically, the MIMO encoder may process a plurality of input signals according to a MIMO matrix and a parameter value of the MIMO matrix which are described below.

The input signal generator 201010 is an element that outputs a plurality of input signals for MIMO encoding and may also be an element such as a demultiplexer or a frame builder depending on the transmission system. The input signal generator 201010 may also be included in the MIMO encoder 201020 such that the MIMO encoder 201020 generates a plurality of input signals and performs encoding on the plurality of input signals. The MIMO encoder 201020 may be a device that performs MIMO encoding or MIMO processing on a plurality of signals and outputs the encoded or processed signals so as to acquire diversity gain and multiplexing gain of the transmission system.

Since signal processing should be performed on a plurality of input signals after the input signal generator 201010, a plurality of devices may be provided next to the input signal generator 201010 to process signals in parallel or one device including one memory may be provided to sequentially process signals or to simultaneously process signals in parallel.

The MIMO reception system receives a first reception signal Sr1 and a second reception signal Sr2 using a first receive antenna 201050 and a second receive antenna 201060. The MIMO decoder 201070 then processes the first reception signal and the second reception signal and outputs a first output signal and a second output signal. The MIMO decoder 201070 processes the first reception signal and the second reception signal according to the MIMO encoding method used by the MIMO encoder 201020. As an ML detector, the MIMO decoder 201070 outputs a first output signal and a second output signal using information regarding the channel environment, reception signals, and the MIMO matrix used by the MIMO encoder in the transmission system. In an embodiment, when ML detection is performed, the first output signal and the second output signal may include probability information of bits rather than bit values and may also be converted into bit values through FEC decoding.

The MIMO decoder of the MIMO reception system processes the first reception signal and the second reception signal according to the QAM type of the first input signal and the second input signal processed in the MIMO transmission system. Since the first reception signal and the second reception signal received by the MIMO reception system are signals that have been transmitted after being generated by performing MIMO encoding on the first input signal and the second input signal of the same QAM type or different QAM types, the MIMO reception system may determine a combination of QAM types of the reception signals to perform MIMO decoding on the reception signals. Accordingly, the MIMO transmission system may transmit information identifying the QAM type of each transmission signal in the transmission signal and the QAM type identification information may be included in a preamble portion of the transmission signal. The MIMO reception system may determine the combination of the QAM types of the reception signals from the QAM type identification information of the transmission signals and perform MIMO decoding on the reception signals based on the determination.

The following is a description of a MIMO encoder and a MIMO encoding method that have low system complexity, high data transmission efficiency, and high signal reconstruction (or restoration) performance in various channel environments according to an embodiment of the present invention.

The SM scheme is a method in which data is simultaneously transmitted through a plurality of antennas without MIMO encoding. In this case, the receiver can acquire information from data that is simultaneously received through a plurality of receive antennas. The SM scheme has an advantage in that the complexity of a Maximum Likelihood (ML) decoder that the receiver uses to perform signal reconstruction (or restoration) is relatively low since the decoder only needs to check a combination of received signals. However, the SM scheme has a disadvantage in that transmit diversity cannot be achieved at the transmitting side. In the case of the SM scheme, the MIMO encoder bypasses a plurality of input signals. In the following, such a bypass process may be referred to as MIMO encoding.

The GC scheme is a method in which data is transmitted through a plurality of antennas after the data is encoded according to a predetermined rule (for example, according to an encoding method using golden code). When the number of the antennas is 2, transmit diversity is acquired at the transmitting side since encoding is performed using a 2x2 matrix. However, there is a disadvantage in that the complexity of the ML decoder of the receiver is high since the ML decoder needs to check 4 signal combinations.

The GC scheme has an advantage in that it is possible to perform more robust communication than using the SM scheme since transmit diversity is achieved. However, such a comparison has been made when only the GC scheme and the SM scheme are used for data processing for data transmission and, if data is transmitted using additional data coding (which may also be referred to as outer coding), transmit diversity of the GC scheme may fail to yield additional gain. This failure easily occurs especially when such outer coding has a large minimum Hamming distance. For example, the transmit diversity of the GC scheme may fail to yield additional gain compared to the SM scheme when data is transmitted after being encoded by adding redundancy for error correction using a Low Density Parity Check (LDPC) code having a large minimum Hamming distance. In this case, it may be advantageous for the broadcast system to use the SM scheme having low complexity.

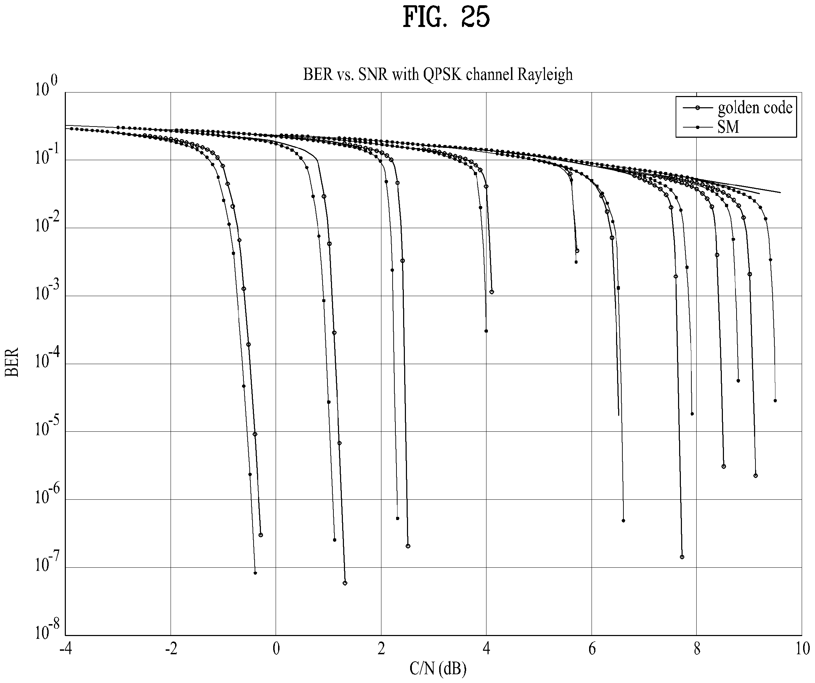

FIG. 25 illustrates a BER/SNR chart showing the performance difference between the SM scheme and the GC scheme using the outer code according to an embodiment of the present invention.

Specifically, FIG. 25 shows BER/SNR performance of the SC scheme and the GC scheme according to the code rate of the outer code under the assumption that a QPSK modulation scheme is used and channels are in a Rayleigh channel environment. In charts described below, the term "Rayleigh channel environment" refers to an environment in which channels have no correlation between paths when MIMO transmission and reception is performed.

From FIG. 25, it can be seen that the SM scheme exhibits higher performance than the GC scheme at a low code rate (1/4, 1/3, 2/5, 1/2) having a large minimum Hamming distance. However, it can also be seen that the GC scheme exhibits higher performance than the SM scheme at a high code rate (2/3, 3/4, 4/5, 5/6) having a small minimum Hamming distance since the transmit diversity gain of the GC scheme is high compared to performance improvement due to coding.

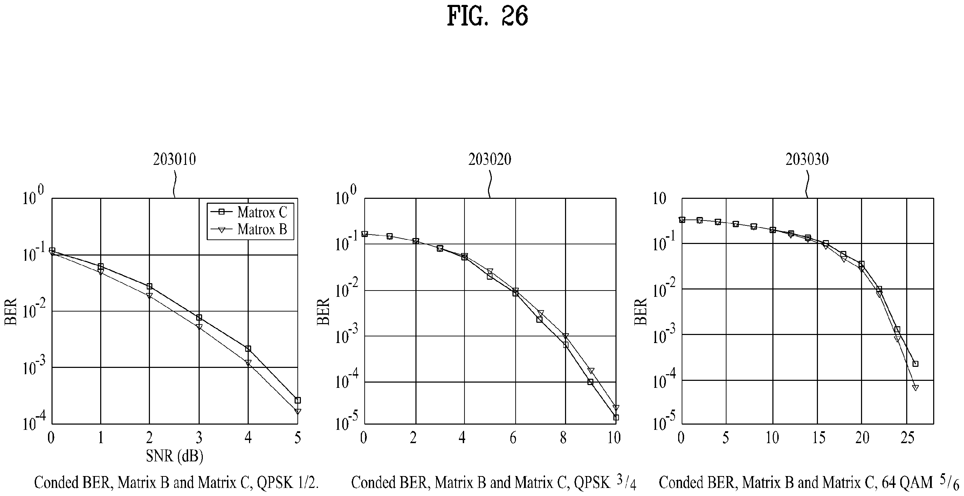

FIG. 26 illustrates BER/SNR charts showing the performance difference between the SM scheme and the GC scheme according to the code rate of the outer code and the modulation scheme according to an embodiment of the present invention.

The chart 203010 of FIG. 26 shows the case in which an outer code having a code rate of 1/2 and a QPSK modulation scheme are used, the chart 203020 shows the case in which an outer code having a code rate of 3/4 and a QPSK modulation scheme are used, and the chart 203030 shows the case in which an outer code having a code rate of 5/6 and a 64-QAM modulation scheme are used.

From comparison of the charts 203010 to 203030, it can be seen that the SM scheme exhibits higher performance than the GC scheme when a low code rate (1/2) is used as shown in the chart 203010 and when a large QAM size (64-QAM) is applied as shown in the chart 203030.

Accordingly, the present invention suggests that a more efficient MIMO broadcast system be designed using a robust outer code while using an SM scheme having low complexity. However, the SM scheme may have a problem associated with reception signal reconstruction (or restoration) depending on the degree of correlation between a plurality of MIMO transmission and reception channels.

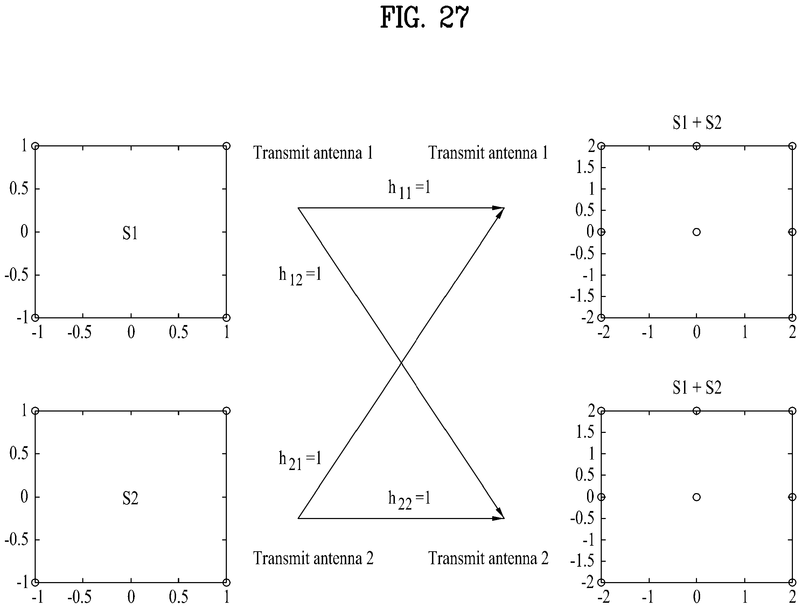

FIG. 27 illustrates a data transmission and reception method according to MIMO transmission of the SM scheme in a channel environment according to an embodiment of the present invention.

The MIMO transmission system may transmit input signal 1 (S1) and input signal 2 (S2) respectively through transmit antenna 1 and transmit antenna 2 according to the SM scheme. FIG. 27 illustrates an embodiment in which the transmitting side transmits a symbol modulated according to 4-QAM.

The transmit antenna 1 receives a signal through two paths. In the channel environment of FIG. 27, the received signal of the receive antenna 1 is $S1*h_{11} + S2h_{21}$ and the received signal of the receive antenna 2 is $S1*h_{12} + S2h_{22}$. The receiving side may acquire S1 and S2 through channel estimation to reconstruct data.

This is a scenario in which the transmission and reception paths are independent of each other. In the following, such an environment is referred to as being uncorrelated. On the other hand, channels of the transmission and reception paths may have a very high correlation with each other as in a Line Of Sight (LOS) environment, which is referred to as being fully correlated in the following description.

In the case in which channels are fully correlated in MIMO, each channel may be represented by a 2x2 matrix whose elements are all 1 (i.e., $h_{11}=h_{12}=h_{21}=h_{22}=1$) as shown in FIG. 27. Here, the receive antenna 1 and the receive antenna 2 receive the same reception signal (S1+S2). That is, if signals transmitted through 2 transmit antennas pass through the same channel and are received by 2 receive antennas, a reception signal received by the receiver, i.e., data added (or combined) through the channel, cannot express both symbols S1 and S2. As shown in FIG. 27, in the fully correlated channel environment, the receiver cannot receive a 16-QAM symbol, into which the signal S1 represented by a 4-QAM symbol and the signal S2 represented by a 4-QAM symbol are combined and the receiver cannot separate and reconstruct the signals S1 and S2 since the receiver receives a combined signal S1+S2 represented by 9 symbols as shown on the right side of FIG. 27.

In the following, a received signal that has passed through fully correlated channels may be represented by a signal corresponding to the sum of signals transmitted by the transmission system. That is, the MIMO encoding method will now be described on the assumption that, when the transmission system having two antennas transmits a first transmission signal and a second transmission signal, a received signal that has passed through the fully correlated channels corresponds to the sum of the first and second transmission signals.

In this case, the receiver cannot reconstruct a signal received according to MIMO using the SM scheme even when the receiver is in a very high SNR environment. In the case of a communication system, communication is generally performed in two ways and therefore such a channel environment may be signaled to the transmitter through a feedback channel established between the transmitter and the receiver to allow the transmitter to change the transmission method. However, in the case of a broadcast system, it may be difficult to perform bidirectional communication through a feedback channel and one transmitter covers a large number of receivers and a large range and therefore it may be difficult to deal with various channel environment changes. Accordingly, if the SM scheme is used in such a fully correlated channel environment, the receiver cannot receive services and it is difficult to deal with such an environment, increasing costs, unless the coverage of the broadcast network is reduced.

The following is a description of a method for dealing with the case in which the correlation between MIMO channels is 1, i.e., the case in which channels are in a fully correlated channel environment.

The present invention suggests that a MIMO system be designed such that signals received through MIMO channels satisfy the following conditions so as to deal with the case in which the MIMO channels are fully correlated.

1) A received signal should be able to represent both original signals S1 and S2. That is, coordinates of a constellation received by the receiver should be able to uniquely represent sequences of S1 and S2.
2) A minimum Euclidean distance of a received signal should be increased so as to reduce symbol error rate.
3) Hamming distance characteristics of a received signal should be good so as to reduce bit error rate.

First, the present invention suggests a MIMO encoding method that uses a MIMO encoding matrix including an encoding factor "a" as expressed in the following Expression 1 so as to satisfy such requirements.

[Expression 1]

$$\begin{bmatrix} 1 & a \\ a & -1 \end{bmatrix}$$

When a MIMO encoder encodes input signals S1 and S2 using a MIMO encoding matrix as shown in Expression 1, reception signal 1 (Rx1) and reception signal 2 (Rx2) received by antenna 1 and antenna 2 are calculated as expressed in the following Expression 2. The reception signal 1 (Rx1) and reception signal 2 (Rx2) are calculated as expressed in the last line of Expression 2, especially, when MIMO channels are fully correlated.

[Expression 2]

$$Rx_1 = h_{11}(S1+aS2)+h_{21}(aS1-S2)$$
$$Rx_2 = h_{12}(S1+aS2)+h_{22}(aS1-S2) \quad ,if\ h_{11}=h_{21}=h_{12}=h_{22}=h,$$
$$R = Rx_1 = Rx_2 = h\{(a+1)S1+(a-1)S2\}$$

First, when MIMO channels are uncorrelated, the reception signal 1 (Rx1) is calculated as Rx1 = $h_{11}$(S1+a*S2)+$h_{21}$(a*S1-S1) and the reception signal 2 (Rx2) is calculated as Rx2 = $h_{12}$(S1+a*S2)+$h_{22}$(a*S1-S2). Thus, since the signals S1 and S2 have the same power, it is possible to use gain of the MIMO system together with the SM scheme. When MIMO channels are fully correlated, the reception signals (R=Rx1=Rx2) expressed as R = h{(a+1)S1+(a-1)S2} are acquired and therefore it is possible to separate and acquire the signals S1 and S2 and the signals S1 and S2 are designed such that both have different power and therefore it is possible to secure robustness accordingly.

That is, the MIMO encoder may encode input signals S1 and S2 such that the input signals S1 and S2 have different powers according to the encoding factor "a" and are also received with different distributions even in fully correlated channels. For example, input signals S1 and S2 may be encoded such that both have different powers and the encoded signals may then be transmitted using constellations which have different Euclidean distances through normalization to allow the receiver to separate and reconstruct the input signals even when the signals have passed through fully correlated channels.

The MIMO encoding matrix described above may be represented as Expression 3 taking into consideration a normalization factor.

[Expression 3]

$$\frac{1}{\sqrt{1+a^2}}\begin{pmatrix}1 & a \\ a & -1\end{pmatrix} = \begin{pmatrix}\dfrac{1}{\sqrt{1+a^2}} & \dfrac{a}{\sqrt{1+a^2}} \\ \dfrac{a}{\sqrt{1+a^2}} & \dfrac{-1}{\sqrt{1+a^2}}\end{pmatrix} = \begin{bmatrix}\cos\theta & \sin\theta \\ \sin\theta & -\cos\theta\end{bmatrix}$$

MIMO encoding of the MIMO encoder that uses the MIMO encoding matrix (or rotation matrix) shown in Expression 3 may be considered as rotating the input signals by an arbitrary angle of θ that can be represented by the encoding factor a, separating the cosine and sine components (or real and imaginary components) of the rotated signals, assigning positive and negative (+/-) signs to the separated components, and transmitting the separated components through different antennas. For example, the MIMO encoder may encode the input signals S1 and S2 such that the cosine component of the input signal S1 and the sine component of the input signal S2 are transmitted through one transmit antenna and the sine component of the input signal S1 and the cosine component of the input signal S2 to which a negative sign is attached are transmitted through another transmit antenna. The angle, by which the input signals are rotated, changes according to change of the value of the encoding factor "a" and the power distributions of the input signals S1 and S2 become different according to the value of the factor and the angle. Since the power distribution difference can be represented by a distance between symbol coordinates in the constellations, the encoded input signals can be represented by different constellations even when the input signals are received by the receiving side via fully correlated channels such that it is possible to identify and separate the signals, thereby enabling reconstruction of the original input signals.

Specifically, the Euclidian distances of transmission signals change as the power distributions change, the transmission signals received by the receiving side can be represented by identifiable constellations having different Euclidian distances such that it is possible to reconstruct the signals even when the signals have passed through a fully correlated channel. That is, the MIMO encoder can encode the input signal S1 and the input signal S2 into signals having different Euclidian distances according to the value "a" and the receiving side can receive and reconstruct the encoded and transmitted signals using identifiable constellations.

MIMO encoding of the input signals using the above-described MIMO encoding matrix may be represented as Expression 4.

[Expression 4]

$$\begin{pmatrix}X1 \\ X2\end{pmatrix} = \frac{1}{\sqrt{1+a^2}}\begin{pmatrix}1 & a \\ a & -1\end{pmatrix}\begin{pmatrix}S1 \\ S2\end{pmatrix}$$

In Expression 4, S1 and S2 respectively represent normalized QAM symbols of constellations mapped by symbol mappers on MIMO paths of the input signals S1 and S2. X1 and X2 respectively denote MIMO-encoded symbols. That is, the MIMO encoder can apply the matrix as represented by Expression 4 to the first input signal including the symbols corresponding to S1 and the second input signal including the symbols corresponding to S2 to output a first transmission signal including the symbols corresponding to X1 and a second transmission signal including the symbols corresponding to X2.

The MIMO encoder may perform encoding on input signals using the MIMO encoding matrix described above while additionally adjusting the encoding factor a. That is, it is possible to adjust and optimize the encoding factor "a" taking into consideration additional data reconstruction performance of the MIMO transmission and reception system.

Power imbalance may occur between signals that are transmitted through respective communication paths when MIMO transmission and reception is performed. That is, signals transmitted through a plurality of transmission antennas may be received by a receiver with different powers. In the worst case, only a signal transmitted by one transmission antenna may be received by the receiver. The following is a description of a MIMO encoding method which can minimize performance degradation in such a power imbalance situation.

1. First Embodiment: MIMO encoding method that optimizes the encoding factor "a" taking into consideration Euclidian distances (in a fully correlated MIMO channel environment)

It is possible to calculate the encoding factor value "a" taking into consideration the Euclidean distance while using the MIMO encoding matrix. In a MIMO system having two transmit antennas and two receive antennas, when transmission signal St1 is an M-QAM symbol and transmission signal St2 is an N-QAM symbol, a signal St1+St2 that is received by the receiving side via a fully correlated MIMO channel is an (M*N)-QAM signal.

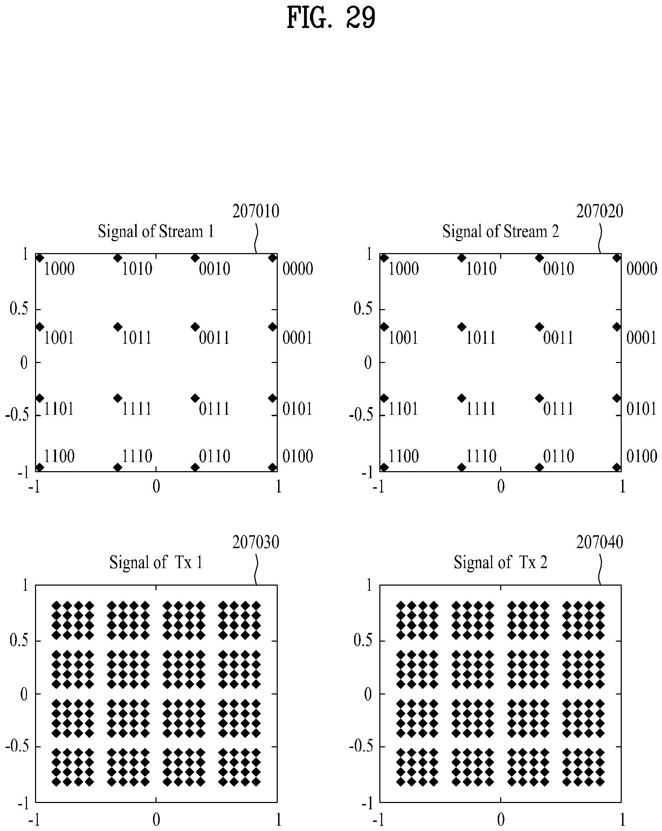

FIG. 29 illustrates input signals and transmission signals on which a MIMO encoding method according to a first embodiment of the present invention has been performed.

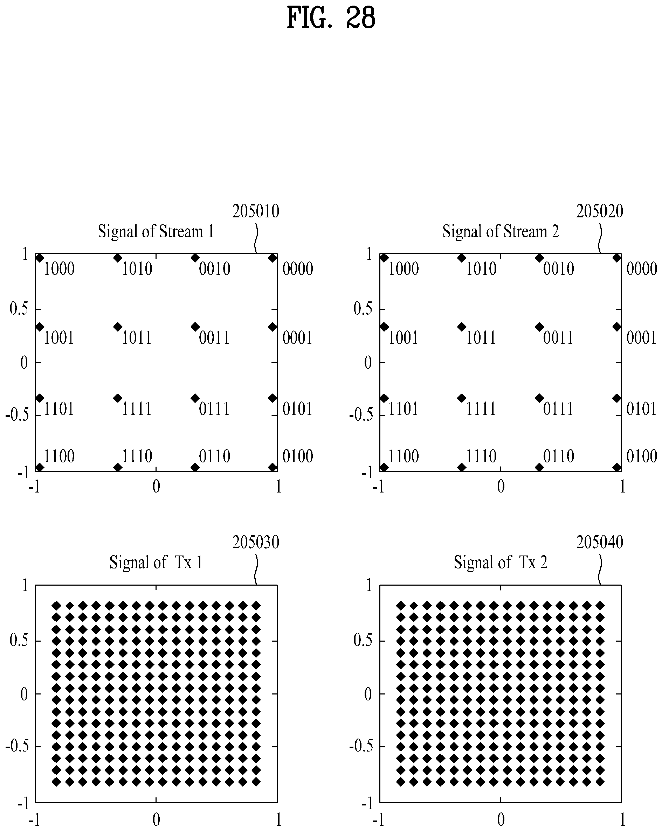

In the embodiment of FIG. 28, the input signal S1 has a constellation 221010 as a 16-QAM symbol and the input signal S2 has a constellation 221020 as a 16-QAM symbol. If the input signal S1 and the input signal S2 are MIMO-encoded using the MIMO encoding matrix, the encoded transmission signals St1 and St2 transmitted through antenna 1 (Tx1) and antenna 2 (Tx2) are 256-QAM symbols and the constellations of the encoded transmission signals have no minimum Euclidean distance. Although the value "a" may be determined by optimizing the Euclidian distance with reference to a reception signal, this may degrade decoding performance in a power imbalance situation. Accordingly, if the Euclidian distance is optimized with reference to transmission signals from the transmitting side, it is possible to minimize performance degradation that occurs in a power imbalance situation at the receiving side. Optimization of Euclidean distance means arrangement of symbols at an equal interval in a signal constellation and maximization of a minimum Euclidean distance in the constellation. The value "a" for optimizing the Euclidian distance with reference to transmission signals may be represented by Expression 5.

[Expression 5]

$$a = \begin{cases} 2 & , \text{for QPSK} + \text{QPSK} \\ 4 & , \text{for 16QAM} + \text{16QAM} \end{cases}$$

When the value "a" determined according to Expression 5 is used, i.e., when the value "a" is set to 4 and MIMO encoding is performed using the same in the example of expressions 1 or 3, the transmission signals St1 and St2 have a constellation 221030 and a constellation 221040, respectively. From the constellations 221030 and 221040 of the transmission signals St1 and St2, it can be seen that the Euclidian distance is distributed uniformly. Accordingly, it can be understood that, when the MIMO encoding method of the first embodiment is used, it is possible to minimize reception performance degradation since the Euclidian distance of the transmission signals received in a power imbalance situation has been optimized.

However, a different value needs to be used when symbol types of input signals are different as in the QPSK+16-QAM transmission method. The reason for this is that, when modulation schemes of input signals used for MIMO transmission are different, a trade-off problem occurs such that, if the optimized value "a" is used for one transmission antenna, then a signal having relatively low performance is transmitted through another transmission antenna.

2. Second Embodiment: MIMO encoding method taking into consideration gray mapping in addition to Euclidian distance

The second embodiment suggests a MIMO encoding method in which an encoding factor value "a" is set so as to optimize the Euclidean distance, similar to the first embodiment, and MIMO encoding is performed such that a reception signal that has passed through a fully correlated channel has a gray mapping (or gray mapping form).

In the MIMO encoding method of the second embodiment, at the receiving side, the signs of real and imaginary parts of the input signal S2 among the input signals S1 and S2 may be changed according to a value of the input signal S1 such that each signal becomes a gray mapping signal. Data values included in the input signal S2 may be changed using a method represented by the following Expression 6.

That is, the MIMO encoder may perform MIMO encoding after changing signs of the input signal S2 according to the value of the input signal S1 while using the same MIMO encoding factor as used in the first embodiment. In other words, the sign of the input signal S2 may be determined according to the sign of the input signal S1, and then the MIMO encoding matrix may be applied to the first and second input signals S1 and S2 to output the first and second transmission signals, as described above.

[Expression 6]

$$S1 = b_0 b_1 ... b_{N-1}, \quad N = \log_2 M, \quad M = \text{QAM size of } S1$$
$$real(S1) = b_0 b_2 .. b_{N-2}$$
$$imag(S1) = b_1 b_3 .. b_{N-1}$$
$$for \ i = 1 ... N-1$$
$$\quad si = sq = 1$$
$$\quad if \ i = index \ of \ real(S1) \ and \ b_i = 1$$
$$\quad\quad si = -si$$
$$\quad if \ i = index \ of \ imag(S1) \ and \ b_i = 1$$
$$\quad\quad sq = -sq$$
$$end \ for$$
$$S2 = si \cdot real(S2) + i \cdot sq \cdot imag(S2)$$

If bit values assigned to the real and imaginary parts of the input signal S1 212010 among the input signals S1 and S2 212010 and 212020 are XORed as in Expression 6 and the signs of the real and imaginary parts are determined according to the XORed value and transmission signal 1 and transmission signal 2 are transmitted respectively through antenna 1 and antenna 2, then reception symbols of a reception signal, which is received by the receiver via a fully correlated channel, have a gray mapping form such that the Hamming distance between adjacent symbols in the constellation does not exceed 2.

Since an (M*N)-QAM signal received by the receiver has a minimum Euclidean distance and a gray mapping form, the second embodiment may achieve the same performance as the SIMO scheme even in a fully correlated MIMO channel environment. However, when signals S1 and S2 are acquired by decoding the reception signal at the ML decoder, complexity may be increased since the value of S2 depends on the value of S1 and performance may be degraded due to the correlation between input signals in an uncorrelated MIMO channel.

3. Third Embodiment: MIMO encoding method that sets MIMO encoding factor taking into consideration Hamming distance in addition to Euclidian distance

The third embodiment suggests a method in which MIMO encoding is performed by setting an encoding factor value "a" so as to optimize the Euclidian distance taking into consideration the Hamming distance of a reception signal rather than allowing the entire constellation of the reception signal to have a Euclidian distance as in the first embodiment. Specifically, it is possible to design an encoding matrix such that the square of the Euclidian distance between adjacent constellation points when the Hamming distance between the adjacent constellation points is 2 is twice the square of the Euclidian distance between the points when the Hamming distance is 1. That is, the Euclidian distance is adjusted such that a reconstruction performance difference due to a Hamming distance difference can be compensated for using a power difference.

A description will be given of the method of setting value "a" in more detail. For example, in a transmission signal, since a Hamming distance in a section between internal symbols representing a first input signal in constellations corresponds to half a Hamming distance in an inter-symbol section between constellations representing the first input signal, the Euclidean distance can be adjusted such that the Hamming distance difference is compensated by maintaining the power of the internal section twice that of a neighboring section. In other words, the neighboring section has a Hamming distance twice that of the internal section. That is, in neighboring symbols, the number of different bits in one symbols is twice the number of different bits in the other. The Euclidean distance can be increased such that the section having a double Hamming distance has higher power to as to compensate for performance deterioration due to a Hamming distance difference when a received signal is restored. In other words, it is possible to compensate for a restoration performance difference caused by a Hamming distance difference with a power difference by adjusting the Euclidean distance.

Relative Euclidean distances for signals St1 and St2 transmitted from a transmitter are detected in constellations. It can be determined from the above-mentioned equation 2 that a minimum Euclidean distance of a 16-QAM symbol having decreasing power is (a-1) and a minimum Euclidean distance of a 16-QAM symbol having increasing power is (a+1) (because one transmitted signal is represented as R=h{a+1}S1+(a-1)S2}). The value "a" may be obtained using the above conditions, which may be represented by Expression 7.

[Expression 7]

$$a = \begin{cases} \sqrt{2}+1 & \text{, for QPSK} + \text{QPSK} \\ \sqrt{2}+3 & \text{, for 16QAM} + \text{16QAM} \end{cases}$$

FIG. 29 illustrates input signals and transmission signals on which a MIMO encoding method according to a third embodiment of the present invention has been performed.

In the embodiment of FIG. 29, an input signal S1 corresponds to 16-QAM symbols and has a constellation 207010, whereas an input signal S2 corresponds to 16-QAM symbols and has a constellation 207020. When the input signal S1 and the input signal S2 are encoded using a MIMO encoding matrix including an encoding parameter set according to the third embodiment, encoded transmission signals St1 and St2, which are transmitted through antenna 1 (Tx1) and antenna 2 (Tx2), become 256-QAM symbols and respectively have constellations 207030 and 207040 having Euclidean distances taking Hamming distance into account. Furthermore, the transmission signals have symbol distributions having the Euclidean distances taking the hamming distance into account, and thus performance loss can be minimized even when a receiver receives and decodes only one of the transmission signals in a power imbalance situation.

However, when the input signals have different symbol types as in a QPSK+16-QAM transmission method, it is necessary to use different values 'a'. This is because, if a value 'a' optimized for one of the transmission antennas is used, a signal having lower quality may be transmitted through the other transmission antenna when different modulation schemes are employed for the input signals used for MIMO transmission, that is, trade-off may be generated.

A description will be given of a broadcast signal transmitter and a broadcast signal receiver that perform MIMO encoding and decoding using the aforementioned MIMO matrix. A broadcast signal transmitter and a broadcast signal receiver using MIMO may be referred to as a MIMO transmitter and a MIMO receiver in the following description.

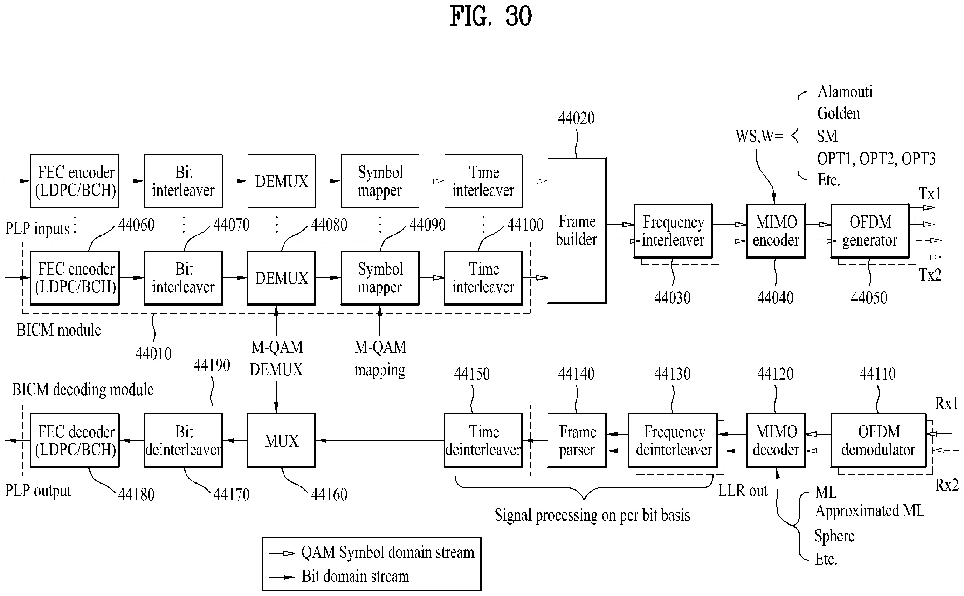

FIG. 30 is a block diagram illustrating a MIMO transmitter and a MIMO receiver according to an embodiment of the present invention.

FIG. 30 illustrates an embodiment in which the MIMO transmitter and the MIMO receiver perform MIMO communication using two antennas, respectively. Particularly, the MIMO transmitter uses the same modulation scheme for input signals. That is, M-QAM is used as a modulation scheme for two input signals to transmit the two input signals through two antennas (e.g. BPSK+BPSK or QPSK+QPSK).

Input data may be processed on a stream-by-stream or PLP-by-PLP basis. A PLP is a physical layer pipe, and each service may be transmitted/received through a plurality of RF channels in the present invention. A PLP may be regarded as a physical layer TDM channel carrying one or more services. A path through which the services are transmitted or a stream identifiable in the physical layer, transmitted through the path, is referred to as a PLP. PLPs may be located in slots distributed at time intervals in the plurality of RF channels, or may be distributed at time intervals in one RF channel. Signal frames may carry PLPs distributed in time in at least one RF channel. In other words, one PLP may be distributed in time in one RF channel or a plurality of RF channels and transmitted.

The MIMO transmitter may include a BICM module 44010, a frame builder 44020, a frequency interleaver 44030, a MIMO encoder 44040, and an OFDM generator 44050. The BICM module 44010 may include an FEC encoder 44060, a bit interleaver 44070, a demultiplexer 44080, a symbol mapper 44090, and a time interleaver 44100. The MIMO encoder 44040 may be referred to as a MIMO processor.

The MIMO receiver may include an OFDM demodulator 44110, a MIMO decoder 44120, a frequency deinterleaver 44130, a frame parser 44140, a time deinterleaver 44150, a multiplexer 44160, a bit deinterleaver 44170, and an FEC decoder 44180. The time deinterleaver 44150, the multiplexer 44160, the bit deinterleaver 44170 and the FEC decoder perform a reverse procedure of the procedure of the BICM module and may be referred to as a BICM decoding module 44190 in the following. The MIMO decoder 44120 may be referred to as a MIMO maximum likelihood (ML) detector.

Functions of the components of the MIMO transmitter and the MIMO receiver and MIMO transmission and reception methods will be described in the following.

First, the configuration and operation of the MIMO transmitter will now be described.

In the MIMO transmitter, a plurality of PLPs is input to respective BICM paths. FIG. 30 illustrates that one PLP is input to the BICM module 44010. The MIMO transmitter may include a plurality of BICM modules and PLPs respectively subjected to BICM may be applied to the frame builder 44020.

The BICM module 44010 encodes and interleaves data. More specifically, input bitstreams in PLPs are encoded using an outer code in the FEC encoder 44060. The FEC encoder 44060 may encode the bitstreams using an outer code such as bose-Chaudhuri-Hocquengham(BCH)/low density parity check (LDPC) code while adding redundancy for error correction to the bitstreams. The bit interleaver 44070 interleaves the encoded bitstreams on a bit-by-bit basis. The demultiplexer 44080 adjusts the bit output sequence of the bitstreams in order to disperse data reliability distribution generated during LDPC coding when symbol mapping is performed later. The demultiplexer 44080 demultiplexes the bitstreams on the basis of M-QAM. The symbol mapper 44090 performs M-QAM gray mapping on the bitstreams output from the demultiplexer 44080 to output M-QAM symbol streams. The time interleaver 44100 interleaves the symbol streams in time and, particularly, time-interleaves symbols output from one or more LDPC blocks. In FIG. 30, signal processing in blocks following the symbol mapper may be performed on a symbol-by-symbol basis.

The frame builder 44020 arranges the symbols in PLPs, output through each BICM path, in frames. The frame builder 44020 additionally functions as an input signal generator that generates or arranges a plurality of input signals for MIMO transmission. Here, the frame builder 44020 in the MIMO transmitter may arrange symbols such that different PLPs are not encoded together. In the embodiment of FIG. 30 in which signals are transmitted using two antennas, the frame builder 44020 may arrange two different symbols in the same cell position to generate and output two input signals. When the frame builder 44020 outputs two symbol data (i.e. two input signals) allocated to the same cell position in parallel, the frequency interleaver 44030 interleaves the two symbol data in the same pattern in the frequency domain. The MIMO encoder 44040 MIMO-encodes the two input signals for the two antennas, that is, the two symbol data output from the frequency interleaver 44030. Here, the MIMO encoding method of the above-mentioned first to third embodiments can be used for MIMO encoding, and thus the aforementioned MIMO encoding matrix can be used.

The OFDM generator 44050 may OFDM-modulate the MIMO-encoded symbol data and transmit the OFDM-modulated symbol data. The OFDM generator 44050 may include an IFFT module that performs inverse fast Fourier transform (IFFT) on a signal and modulates the signal into a plurality of subcarriers, a PAPR reduction module that reduces a peak-to-average power ratio (PAPR) in a modulated OFDM signal using at least one of active constellation extension (ACE) or tone reservation, a GI insertion module that inserts a guard interval into the OFDM signal, a P1 insertion module that inserts a preamble for L1 signaling information, and a digital-to-analog converter (DAC) that coverts a processed digital signal into an analog signal, which are not shown in FIG. 30.

The MIMO encoder 44040 may perform MISO processing or SISO processing in addition to MIMO encoding. In the embodiment of FIG. 30, the MIMO transmitter may use two antennas when only MIMO processing is performed and may use four antennas when MISO processing is additionally performed. When all PLPs are processed according to SISO and transmitted, one to four antennas may be arbitrarily used.

The MIMO receiver uses at least two antennas to receive a MIMO signal. If a received signal is a SISO signal or a MISO signal, the MIMO receiver may use one or more antennas.

The MIMO transmitter may include as many frequency interleavers and OFDM generators as the number of input signals transmitted to a plurality of antennas, which are arranged in parallel, such that the frequency interleavers 44030 and the OFDM generator 44050 can perform the aforementioned operations in parallel. Otherwise, one frequency interleaver 44030 and one OFDM generator 44050 may include memories to process a plurality of signals in parallel.

The configuration and operation of the MIMO receiver will now be described.

In the MIMO receiver, the OFDM demodulator 44110 OFDM-demodulates a plurality of signals received through a plurality of antennas and outputs a plurality of symbol data and channel information. In other words, the OFDM demodulator 44110 may perform fast Fourier transform (FFT) on the received signals to transform the received signals into frequency signals and acquire the channel information using a pilot included in the received signals. The OFDM demodulator 44110 may include an ADC that converts a received analog signal into a digital signal, a P1 detection and decoding module that detects a P1 signal including L1 signaling information, decodes the detected P1 signal and determines a frame configuration of a currently received signal from the P1 signal, a time/frequency synchronizer that detects a guard interval and performs time synchronization and frequency synchronization, a GI removal unit that removes the guard interval after synchronization, an FFT module that demodulates a plurality of subcarrier signals by performing FFT thereon, and a channel estimator that estimates a transmission channel between the transmitter and the receiver from pilot signals included in the frequency domain.

The MIMO decoder 44120 processes the channel information and the plurality of received symbol data output from the OFDM demodulator 44110 and outputs a plurality of output signals. The MIMO decoder 44120 can use the following Expression 8.

[Expression 8]

$$\log\left(\frac{\displaystyle\sum_{s\in S_0} e^{-\frac{1}{2\sigma^2}\sum_{s,h,t}\left|y_{h,t}-H_{h,t}WS_s\right|^2}}{\displaystyle\sum_{s\in S_1} e^{-\frac{1}{2\sigma^2}\sum_{s,h,t}\left|y_{h,t}-H_{h,t}WS_s\right|^2}}\right)$$

In Expression 8, $y_{h,t}$ denotes a signal received by the receiver where h denotes a channel received for each receive antenna. That is, $y_{h,t}$ represents a received signal that has passed thruogh a channel corresponding to time t. For example, $y_{h,t}$ represents signals received during one unit time and represents signals received for time of two units in the case of the GC scheme. $H_{h,t}$ denotes channel information to which the received signal has been subjected. In the embodiments of the present ivnention, h may be represented by a 2x2 matrix indicating a MIMO channel and t denotes a time unit. W denotes a MIMO encoding matrix and $S_s$ is a transmitted QAM signal that represents an input signal before MIMO-encoding. In addition, s is a unit for two signals used for MIMO transmission.

In Expresion 8, $\|Y - HWS\|^2$ represents a difference between a received signal vector (two signals can be referred to as a vector because they are simultaneously transmitted) and a transmtited signal vector, and the receiver detects vector $S_s$ that minimize the difference. Since the receiver knows $y_{h,t}$, $H_{h,t}$ and W, the receiver can acquire a log likelihood ratio (LLR) by comparing probability S1 that a corresponding bit is 1 with probability S0 that the corresponding bit is 0 in the log domain.

As described above, the MIMO decoder 44120 uses a method of detecting a signal closest to a transmitted signal from a received signal using Expression 8, and information acquired from the detection is bit-based probability, and thus a plurality of output signals of the MIMO decoder 44120 bit-based data represented in an LLR. Here, the MIMO decoder 44120 compares all combinations of data used for MIMO encoding and channel information with received data in order to obtain the LLR. In this case, the MIMO decoder 44120 may use an approximated ML scheme that uses only a value closest to the received data, a sphere decoding scheme that uses only a combination of values within a predetermined distance from the received data, etc. That is, in FIG. 30, the MIMO decoder 44120 MIMO-decodes two signals received through the two antennas to output as many output signals S1 and S2 as the number of input signals of the transmitter. Here, the output signals S1 and S2 may be bitstreams. In this case, the output signals correspond to QAM types of the input signals of the transmitter.

In the expression used for decoding of the MIMO decoding, WS and W are MIMO encoding matrices and include all encoding matrices of the aforementioned MIMO encoding methods (the first to third embodiments). The transmitter may transmit information about a MIMO matrix used therein and the receiver may check the MIMO matrix using the information and perform decoding. Optionally, the receiver may use a predetermined MIMO matrix.

The frequency deinterleaver 44130 performs deinterleaving on the plurality of output signals of the MIMO decoder 44120 in order reverse to the interleaving operation of the frequency interleaver 44030 of the transmitter. While the frequency interleaver 44030 of the transmitter performs frequency interleaving on a symbol-by-symbol basis, the frequency deinterleaver 44130 of the receiver reorders LLR bit information included in one QAM symbol as symbols and outputs the symbols because it uses LLR bit information. The MIMO receiver may include a plurality of frequency deinterleavers to respectively perform frequency deinterleaving on MIMO input signals in parallel.

The frame parser 44140 acquires desired PLP data from the data output from the frequency deinterleaver 44130 and output the acquired PLP data. The time deinterleaver 44150 performs deinterleaving in reverse order to the interleaving operation of the time interleaver 44100 of the transmitter. Here, the time deinterleaver 44150 performs deinterleaving on a bit-by-bit basis, distinguished from the transmitter, and thus it reorders bitstreams in consideration of LLR bit information and outputs the reordered bitstreams. The frame parser 44140 reorders a plurality of signals input thereto into one stream by performing frame parsing on the input signals and outputs the stream. That is, the frame parser 44140 performs the operation of the output signal generator illustrated in FIG. 24, and blocks following the frame parser 44140 in the receiver carry out signal processing on one stream.

The multiplexer 44160, the bit deinterleaver 44170 and the FEC decoder 44180 respectively perform operations reverse to the operations of the demultiplexer 44080, the bit interleaver 44070 and the FEC encoder 44060 of the transmitter, to output restored PLPs. That is, the multiplexer 44160 realigns the LLR bit information, the bit deinterleaver 44170 performs bit deinterleaving, and the FEC decoder 44180 performs LDPC/BCH decoding to correct errors and output PLP bit data. Operations following the operation of the frame parser may be regarded as BICM decoding operation of the BICM decoding module, which is reverse to the operation of the BICM module 44010 of the transmitter.

The MIMO transmitter and the MIMO receiver may include as many frequency interleavers 44030, frequency deinterleavers 44130, OFDM generators 44050 and OFDM demodulators 44110 as the number of MIMO transmitted/received signals so as to perform the aforementioned operations on the MIMO transmitted/received signals in parallel. Otherwise, the frequency interleaver 44030, frequency deinterleaver 44130, OFDM generator 44050 and OFDM demodulator 44110 may include memories that simultaneously process a plurality of data signals to reduce system complexity.

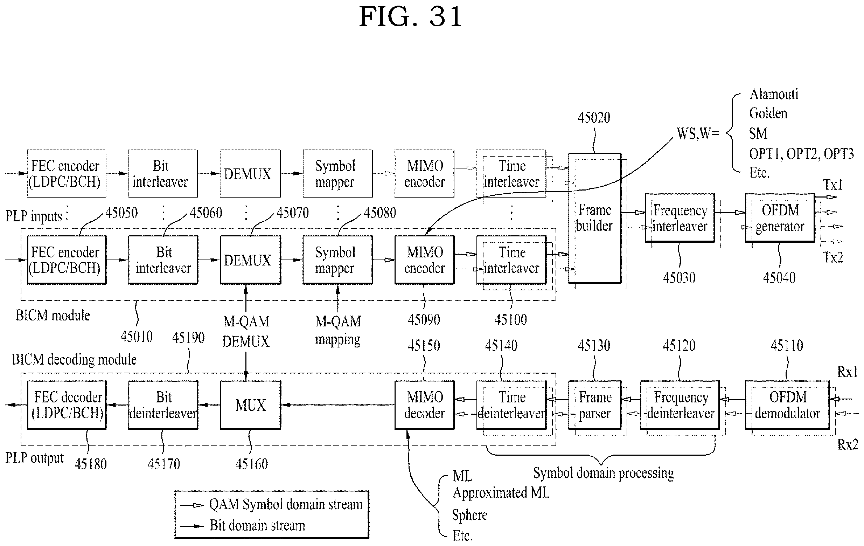

FIG. 31 illustrates a MIMO transmitter and a MIMO receiver according to another embodiment of the present invention.

FIG. 31 shows a case in which each of the MIMO transmitter and the MIMO receiver uses two antennas to perform MIMO communication. Particularly, in the MIMO transmitter, it is assumed that the same modulation scheme is used for input signals. That is, two input signals to be transmitted using the two antennas are modulated through M-QAM (e.g. BPSK+BPSK or QPSK+QPSK).

The MIMO transmitter includes a BICM module 45010, a frame builder 45020, a frequency interleaver 45030, and an OFDM generator 45040. The BICM module 45010 includes an FEC encoder 45050, a bit interleaver 45060, a demultiplexer 45070, a symbol mapper 45080, a MIMO encoder 45090 and a time interleaver 45100.

The MIMO receiver includes an OFDM demodulator 45110, a frequency deinterleaver 45120, a frame parser 45130, a time deinterleaver 45140, a MIMO ML detector 45050, a multiplexer 45160, a bit deinterleaver 45170, and an FEC decoder 45180. The time deinterleaver 45150, multiplexer 45160, bit deinterleaver 45170 and FEC decoder 45180 perform an operation reverse to the operation of the BICM module 45010 of the MIMO transmitter and may be referred to as a BICM decoding module 45190 in the following description.

Configurations and operations of the MIMO transmitter and MIMO receiver of FIG. 31 are similar to those of the MIMO transmitter and MIMO receiver of FIG. 30, and thus only a difference therebetween will be described now.

The MIMO encoder 45090 of the MIMO transmitter of FIG. 31 is located between the symbol mapper 45080 and the time interleaver 45100, that is, included in the BICM module 45010, distinguished from the MIMO encoder shown in FIG. 30. That is, the MIMO encoder 45090 receives symbols output from the symbol mapper 45080, arranges the symbols in parallel, MIMO-encodes the symbols and outputs the MIMO-encoded symbols in parallel, distinguished from the embodiment of FIG. 30 in which the frame builder outputs QAM symbols to be MIMO-encoded in parallel. The MIMO encoder 45090 additionally functions as an input signal generator to generate a plurality of input signals, perform MIMO encoding on the input signals and output a plurality of transmission signals. The MIMO transmission data output in parallel from the MIMO encoder 45090 are processed in parallel in the time interleaver 45100, frame builder 45020, frequency interleaver 45030 and OFDM generator 45040 and transmitted. Here, a plurality of time interleavers 45100, frame builders 45020, frequency interleavers 45030 and OFDM generators 45040 may be provided to process the MIMO transmission data in parallel. In the embodiment of FIG. 31 in which two transmit antennas are used, the MIMO transmitter may include two time interleavers 45100, two frame builders 45020, two frequency interleavers 45030, and two OFDM generators 45040 to process data output from the MIMO encoder 45090 in parallel.

In the MIMO receiver of FIG. 31, the MIMO decoder 45150 is located between the time deinterleaver 45140 and the multiplexer 45160. Accordingly, the OFDM demodulator 45110, frequency deinterleaver 45120, frame parser 45130 and time deinterleaver 45140 process MIMO signals received through a plurality of antennas on a symbol-by-symbol basis on a plurality of paths, and the MIMO decoder 45150 converts symbol-based data into LLR bit data and output the LLR bit data. In the embodiment of FIG. 31, the MIMO receiver may include a plurality of OFDM demodulators 45110, frequency deinterleavers 45120, frame parsers 45130, and time deinterleavers 45140. Alternatively, the OFDM demodulator 45110, frequency deinterleaver 45120, frame parser 45130 and time deinterleaver 45140 may include memories capable of performing the aforementioned parallel processing. Since all the frequency deinterleaver 45120, frame parser 45130 and time deinterleaver 45140 process symbol-based data, system complexity or memory capacity can be reduced, as compared to the embodiment of FIG. 30 in which LLR bit information is processed.

In FIGS. 30 and 31, the MIMO transmitters may transmit information representing a combination of QAM types of the input signals, used for MIMO encoding. According to an embodiment, the information representing QAM types, that is, modulation types, may be included in L1-post signaling information. That is, information representing QAM types of the first and second input signals may be transmitted through a preamble. In the present embodiment, the first and second input signals have the same QAM type. That is, the MIMO decoder checks the information representing the combination of the QAM types of the input signals included in received signals and performs MIMO decoding using a MIMO matrix corresponding to the combination of the QAM types, to output signals corresponding to the combination of the QAM types. The output signals of the QAM types include bit-based data, and this bit-based data are soft decision values that represent the aforementioned probability of bits. These soft decision values can be converted into hard decision values through FEC decoding.

In FIGS. 30 and 31, devices corresponding to the input signal generator/output signal generator are the frame builder/frame parser and the MIMO encoder/MIMO decoder. However, the operations of the input signal generator/output signal generator may be performed by other device elements. For example, the demultiplexer serves as the input signal generator or is followed by the input signal generator in the transmitter, and the multiplexer serves as the output signal generator or is located behind the output signal generator in the receiver corresponding to the transmitter. Each element located behind the input signal generator may be provided as a plurality of elements to process output signals of the input signal generator in parallel along as many paths as the number of the output signals of the input signal generator, and each element located before the output signal generator may be provided as a plurality of elements to process input signals applied to the output signal generator in parallel along as many paths as the number of the input signals of the output signal generator, according to locations of the input signal generator/output signal generator.

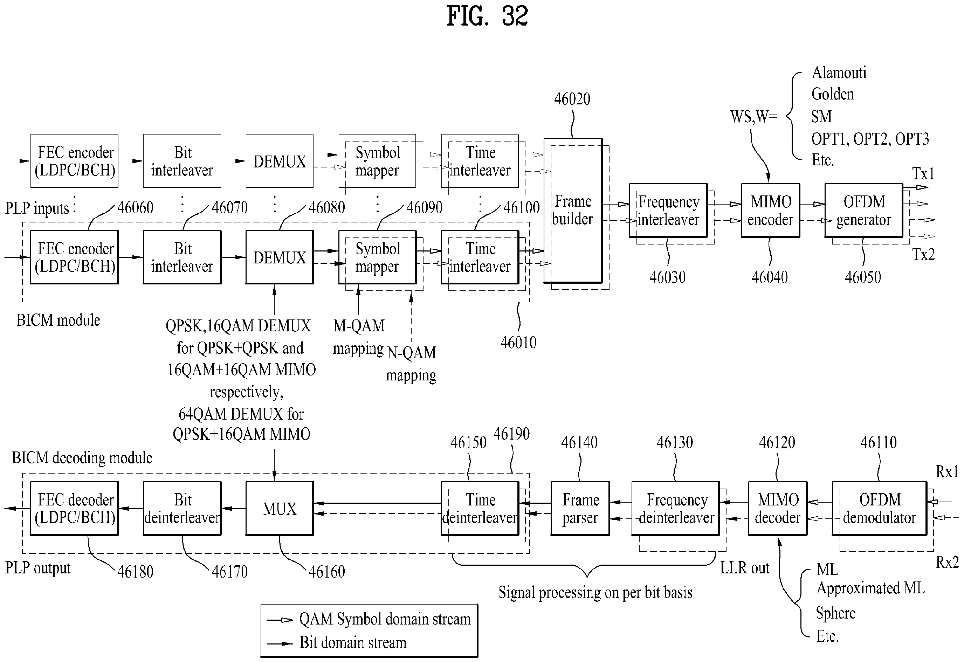

FIG. 32 illustrates a MIMO transmitter and a MIMO receiver according to another embodiment of the present invention.

FIG. 32 shows an embodiment in which each of the MIMO transmitter and the MIMO receiver performs MIMO transmission using two antennas. Particularly, in the MIMO transmitter, different modulation schemes are used for respective input signals. That is, two input signals to be transmitted using the two antennas are modulated through M-QAM and N-QAM (e.g. BPSK+QPSK or QPSK+16-QAM). In the following, cases in which modulation schemes used for input signals are QPSK+QPSK, QPSK+16-QAM and 16-QAM+16-QAM will be also described in association with the operation of a demultiplexer.

Configurations of the MIMO transmitter and MIMO receiver of FIG. 32 are similar to those of the MIMO transmitter and MIMO receiver of FIG. 30 and operations thereof are distinguished by a combination of QAM types from those of the MIMO transmitter and MIMO receiver of FIG. 30. Accordingly, only a difference between the operations of the MIMO transmitter/MIMO receiver of FIG. 32 and the MIMO transmitter/MIMO receiver of FIG. 30 will now be described.

The MIMO transmitter may include a BICM module 46010, a frame builder 46020, a frequency interleaver 46030, a MIMO encoder 46040 and an OFDM generator 46050. The BICM module 46010 may include an FEC encoder 46060, a bit interleaver 46070, a demuliplexer 46080, a symbol mapper 46090 and a time interleaver 46100. The MIMO encoder 46040 may be referred to as a MIMO processor.

The MIMO receiver may include an OFDM demodulator 46110, a MIMO decoder 46120, a frequency deinterleaver 46130, a frame parser 46140, a time deinterleaver 46150, a multiplexer 46160, a bit interleaver 46170, and an FEC decoder 46180. The time interleaver 46150, multiplexer 46160, bit deinterleaver 46170 and FEC decoder 46180 may perform an operation reverse to the operation of the BICM module 46010 of the MIMO transmitter and may be referred to as a BICM decoding module 46190. The MIMO decoder 46120 may be referred to as a MIMO ML detector.

In FIG. 32, the demultiplexer 46080 demultiplexes bitstreams according to M-QAM and N-QAM and outputs demultiplexed bitstreams. The demultiplexer 46080 additionally functions as the input signal generator that generates or arranges a plurality of input signals for MIMO transmission, described with reference to FIG. 24. The symbol mapper 46090 performs M-QAM/N-QAM gray mapping on the bitstreams output from the demultiplexer 46080 to output an M-QAM symbol stream and an N-QAM symbol stream. Here, the MIMO transmitter may include a plurality of symbol mappers such that the symbol mappers perform M-QAM/N-QAM gray mapping on a bitstream demultiplexed according to M-QAM and a bitstream demultiplexed according to N-QAM in parallel to output an M-QAM symbol stream and an N-QAM symbol stream. The time interleaver 46100 interleaves the symbol streams in time and, particularly, time-interleaves symbols output from one or more LDPC blocks. In FIG. 32, signal processing by blocks following the symbol mapper may be performed on a symbol-by-symbol basis.

The demultiplexer 46080 may operate differently according to QAM size of an input signal used for MIMO. That is, a QAM demultiplexer and a 16-QAM demultiplexer may be used when a combination of input signals for MIMO transmission is QPSK+QPSK or 16-QAM+16-QAM, whereas a 64-QAM demultiplexer may be used in the case of QPSK+16-QAM. Otherwise, a 16-QAM demultiplexer and a 256-QAM demultiplexer may be used in the case of QPSK+QPSK and 16-QAM+16-QAM. This uses the fact that M+N-QAM MIMO transmission simultaneously transmits bits corresponding to bits transmitted by M*N QAM SISO.

Operations of the frame builder 46020, MIMO encoder 46040 and OFDM generator 46050 correspond to those described with reference to FIG. 30.

Operation of the MIMO receiver will now be described.

In the MIMO receiver, operations of the OFDM demodulator 46010 and MIMO decoder 46120 correspond to those described with reference to FIG. 30.

The frequency deinterleaver 46130 deinterleaves a plurality of output signals from the MIMO decoder 46120 in order reverse to the interleaving operation of the frequency interleaver 46030 of the MIMO transmitter. Here, while the frequency interleaver 46030 of the MIMO transmitter performs frequency interleaving on a symbol-by-symbol basis, the frequency interleaver 46130 of the MIMO receiver may reorder LLR bit data belonging to M-QAM symbols and bit data belonging to N-QAM symbols on a symbol-by-symbol basis because it uses LLR bit information. The frequency deinterleaver 46130 may frequency-deinterleave MIMO input signals in parallel. Particularly, since the number of bits included in M-QAM symbol data and the number of bits included in N-QAM symbol data in the MIMO input signals may be different from each other, the frequency deinterleaver 46130 needs to perform deinterleaving in consideration of the difference between the number of bits included in M-QAM symbol data and the number of bits included in N-QAM symbol data. The frame parser 46140 and the time deinterleaver 46150, which will be described below, also needs to consider the difference between the number of bits included in M-QAM symbol data and the number of bits included in N-QAM symbol data.

The frame parser 46140 acquires desired PLP data from output data of the frequency deinterleaver 46130 and outputs the acquired PLP data, and the time deinterleaver 46150 performs deinterleaving in order reverse to the operation of the time interleaver 46100 of the MIMO transmitter. Here, since the time deinterleaver 46150 performs deinterleaving on a bit-by-bit basis, distinguished from the time interleaver 46100 of the MIMO transmitter, the time deinterleaver 46150 reorders bitstreams in consideration of LLR bit information and outputs the reordered bitstreams. The frame parser 46140 performs frame parsing on a plurality of input signals to reorder the plurality of input signals and outputs the reordered signals.

The multiplexer 46160, bit deinterleaver 46170 and FEC decoder 46180 respectively perform operations reverse to operations of the demultiplexer 46080, bit interleaver 46070 and FEC encoder 46060 of the MIMO transmitter to output restored PLPs. That is, the multiplexer 46060 reorders LLR bit data, the bit deinterleaver 46170 performs bit deinterleaving, and the FEC decoder 46180 performs LDPC/BCH decoding to correct errors and output PLP bit data. Operations following the operation of the frame parser 46140 may be regarded as BICM decoding of the BICM decoding module 46190, which is reverse to the operation of the BICM module 46010 of the MIMO transmitter. The multiplexer 46160 performs the operation of the output signal generator illustrated in FIG. 24, and blocks following the multiplexer 46160 in the MIMO receiver perform signal processing of one stream. That is, the multiplexer 46160 functions as the output signal generator.

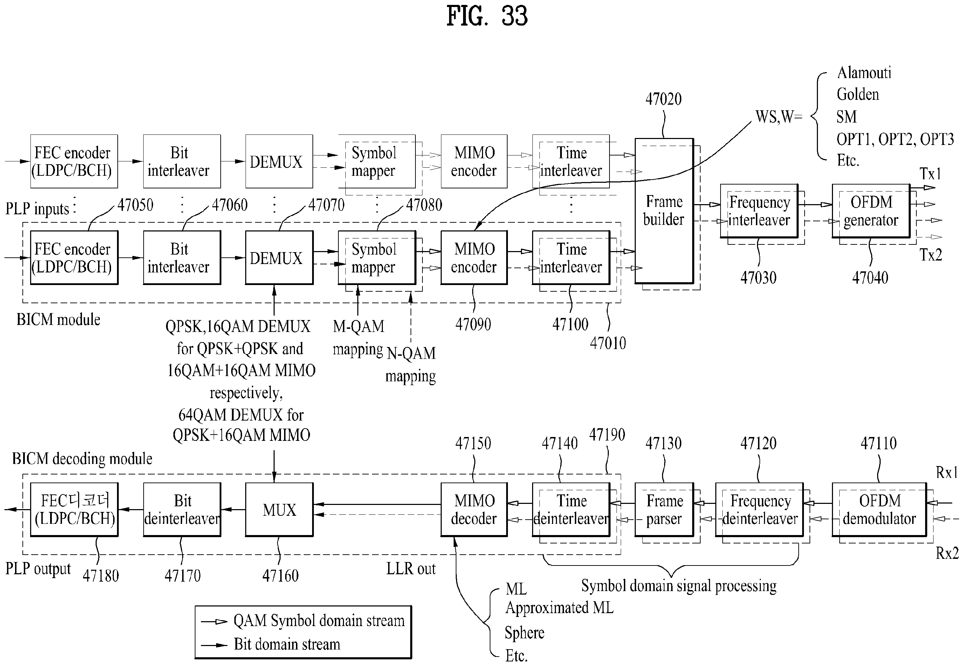

FIG. 33 illustrates a MIMO transmitter and a MIMO receiver according to another embodiment of the present invention.

FIG. 33 shows an embodiment in which each of the MIMO transmitter and the MIMO receiver performs MIMO transmission using two antennas. Particularly, in the MIMO transmitter, different modulation schemes are respectively used for input signals. That is, two input signals to be transmitted using the two antennas are modulated through M-QAM and N-QAM (e.g. BPSK+QPSK or QPSK+16-QAM). In the following, cases in which modulation schemes used for input signals are QPSK+QPSK, QPSK+16-QAM and 16-QAM+16-QAM will also be described in association with operation of a demultiplexer.

Configurations of the MIMO transmitter and MIMO receiver of FIG. 33 are similar to those of the MIMO transmitter and MIMO receiver of FIG. 31 and operations thereof are distinguished by a combination of QAM types from those of the MIMO transmitter and MIMO receiver of FIG. 31. Accordingly, only a difference between the operations of the MIMO transmitter/MIMO receiver of FIG. 33 and the MIMO transmitter/MIMO receiver of FIG. 31 will now be described.

The MIMO transmitter may include a BICM module 47010, a frame builder 47020, a frequency interleaver 47030, and an OFDM generator 47040. The BICM module 47010 may include an FEC encoder 47050, a bit interleaver 47060, a demuliplexer 47070, a symbol mapper 47080, a MIMO encoder 47090 and a time interleaver 47100.

The MIMO receiver may include an OFDM demodulator 47110, a frequency deinterleaver 47120, a frame parser 47130, a time deinterleaver 47140, a MIMO ML detector 47150, a multiplexer 47160, a bit interleaver 47170, and an FEC decoder 47180. The time interleaver 47150, multiplexer 47160, bit deinterleaver 47170 and FEC decoder 47180 may perform an operation reverse to the operation of the BICM module 47010 of the MIMO transmitter and may be referred to as a BICM decoding module 47190 in the following description.

In FIG. 33, the demultiplexer 47070 functions as an input signal generator or a divider, and the symbol mapper 47080 respectively symbol-maps a first input signal and a second input signal to an M-QAM type signal and an N-QAM type signal, as in the embodiment of FIG. 32. In the MIMO receiver, the multiplexer 47160 functions as an output signal generator, as in the embodiment of FIG. 32. Processing of input signals of different QAM types corresponds to that described with reference to FIG. 32.

In FIGS. 32 and 33, devices corresponding to the input signal generator/output signal generator are the demultiplexer/multiplexer. However, operations of the input signal generator/output signal generator may be performed by other device elements. For example, the demultiplexer is followed by the input signal generator in the transmitter, and the output signal generator is followed by the multiplexer in the receiver corresponding to the transmitter. Each of elements located behind the input signal generator may be provided as a plurality of elements to process output signals of the input signal generator in parallel along as many paths as the number of the output signals of the input signal generator, and each of elements located before the output signal generator may be provided as a plurality of elements to process input signals applied to the output signal generator in parallel along as many paths as the number of the input signals of the output signal generator, according to locations of the input signal generator/output signal generator.

Operations of the demultiplexer of the MIMO transmitter and the multiplexer of the MIMO receiver will now be described.

In the present embodiment of the invention, the MIMO transmitter may perform FEC coding that adds redundancy for error correction to data using BCH/LDPC code and encodes the data, as described above. The demultiplexer reorders or realigns bits of the FEC-coded data. Here, the demultiplexer may reorder the bits in consideration of MIMO transmission.

Operations of the demultiplexer and the multiplexer will be described below.

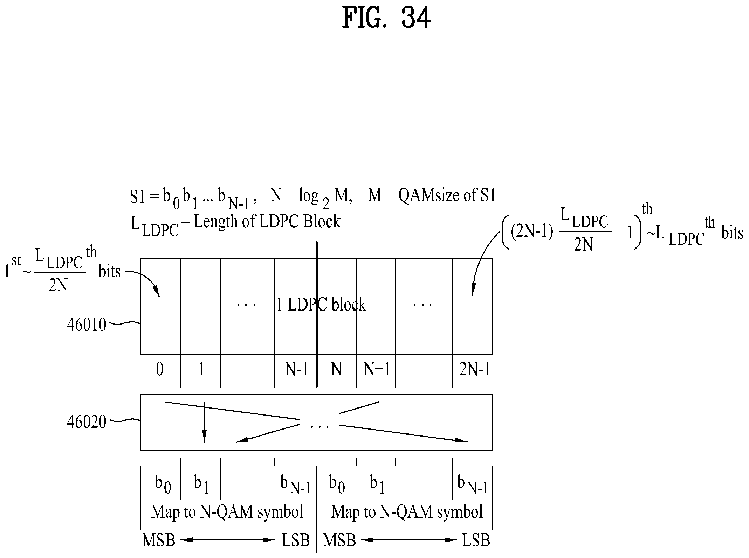

FIG. 34 illustrates an LDPC encoding block 34010 and a demultiplexer 34020 according to an embodiment of the present invention.

A BCH coding block (not shown) may be located before the LDPC encoding block 34010, and a bit interleaver that performs interleaving on a bit-by-bit basis may be located between the LDPC encoding block 34010 and the demultiplexer 34020.

The LDPC encoding block 34010 LDPC-encodes an input signal S1 in an LDPC block size. In the embodiment shown in FIG. 34, the horizontal size of an LDPC block is 2N where N is determined by the QAM size of the input signal S1. That is, if the QAM size of the input signal S1 is M, N may be determined as $N=\log_2$.

Output data of the LDPC encoding block 34010 has reliability distribution in a specific configuration according to LDPC encoding. That is, the output data of the LDPC encoding block 34010 has different reliabilities according to data sections, and thus error recovery performance in the receiver may vary with the data sections. The demultiplexer 34020 disperses the reliability of the data output from the LDPC encoding block 34010. In this case, the reliability is related to positions of bits when the bits are mapped to symbols.

In the case of QAM symbol, positions of bits mapped to symbols are associated with reliability. That is, in QAM symbols, MSBs have reliability higher than that of LSBs. This is because the probability that an MSB is wrongly restored due to error is lower than the probability that an LSB is wrongly restored due to error when symbols are transmitted and received.

In FIG. 34, when the number of bits mapped to one QAM symbol is N, one LDPC block can be divided into 2N equally divided regions. If one bit is extracted from each of the regions, the extracted bits can be mapped to two QAM symbols for two input signals. Here, the demultiplexer 34020 distributes reliabilities of bits included in the LDC block by determining which bit is mapped to which part of a QAM symbol and outputting the bits.

In MIMO transmission, reliability may depend on channel state of a MIMO transmission/reception channel.

Particularly, when a MIMO encoding matrix, as described above, is used, input signals S1 and S2 received by the receiver has the same power when a MIMO channel is an uncorrelated channel, as described above, and thus they have the same reliability. In this case, accordingly, the MIMO channel does not damage reliability assigned by the demultiplexer to the LDPC block.

When the MIMO channel is a fully correlated channel, received signals are R=h{(a+1)S1+(a-1)S2}, as represented in Expression 2, and the input signals S1 and S2 have different powers. That is, since the input signals S1 and S2 have different powers according to value 'a', reliabilities for symbols of the two input signals become different from each other, and thus the reliability allocated by the demultiplexer to the LDPC block is varied. Accordingly, a MIMO transceiving system needs to consider such reliability variation in order to prevent performance loss generated in a fully correlated MIMO channel. To achieve this, it is possible to newly design the demultiplexer or add a divider to the demultiplexer.

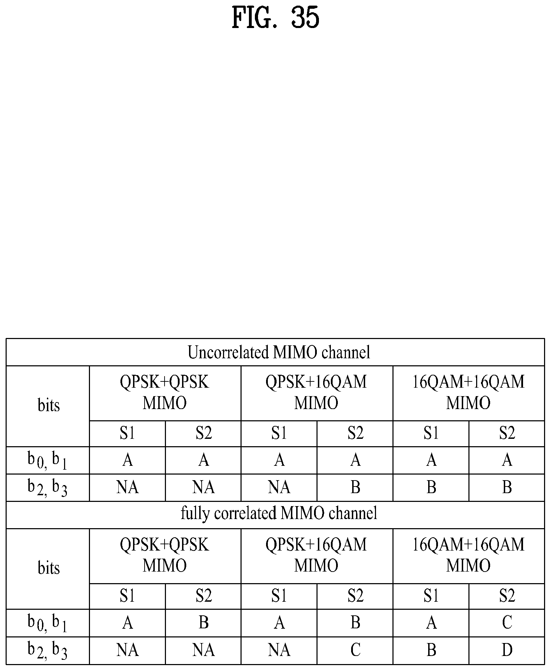

FIG. 35 is a table showing reliabilities of received signals according to MIMO channel conditions according to an embodiment of the present invention.

FIG. 35 shows reliabilities of input signals S1 and S2 received by a receiver in case of uncorrelated MIMO channel and a fully correlated MIMO channel. In the table of FIG. 35, A represents the highest reliability and B represents the lowest reliability.

In the case of an uncorrelated MIMO channel, there is no change in reliability distribution of the input signals. In the case of a fully correlated MIMO channel, however, the reliability distribution for the input signals is varied. It can be seen from the table of FIG. 35 that the reliability of the input signal S2 is decreased. Accordingly, it can be known that the reliability distribution of the LDPC block is concentrated on a specific signal through a MIMO channel although the demultiplexer uniformly disperses the reliability distribution and thus the reliability distribution needs to be adjusted in consideration of the MIMO channel.

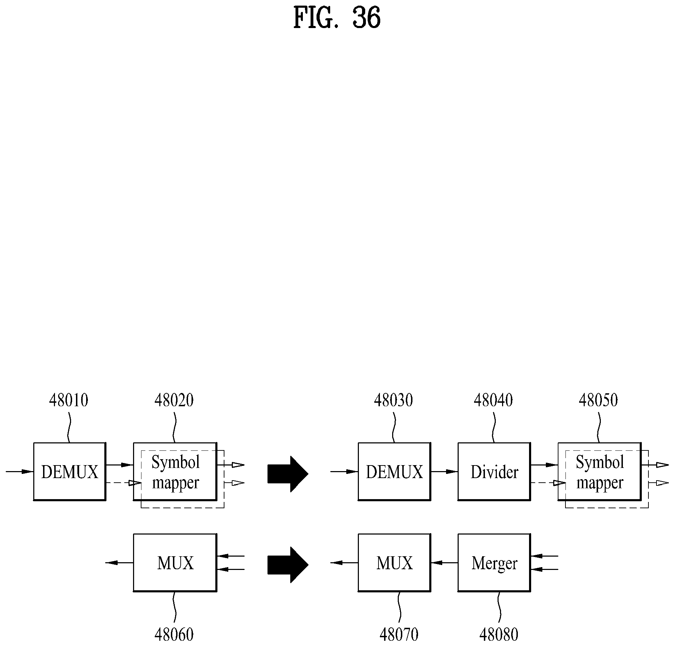

FIG. 36 illustrates part of a MIMO transceiving system according to an embodiment of the present invention.

When a transmission system processes MIMO transmission signals using a demultiplexer 48010 and a symbol mapper 48020, a problem that reliability distribution is concentrated on one signal is generated when a MIMO channel is fully correlated. Accordingly, the present invention suggests a method of arranging a divider 48040 between the demultiplexer 48010 and the symbol mapper 48050 such that the divider 48040 redistributes data to prevent reliability distribution from being concentrated on one signal. Alternatively, the transmission system does not include the divider 48040 and the demultiplexer 48030 may additionally perform the operation of the divider 48040.

A reception system may include a multiplexer 48060 and a merger 48080 that performs an operation reverse to the operation of the divider 48040 of the transmission system. The merger 48080 is located before the multiplexer 48070 of the reception system and reorders bits corresponding to a symbol reordered by the divider such that the multiplexer 48070 can multiplex input signals from the transmission system. Alternatively, the reception system does not include the merger 48080 and the multiplexer 48070 may additionally perform the operation of the merger 48080.

A description will be given of an operation of the divider when input signals have the same QAM type in the MIMO system.

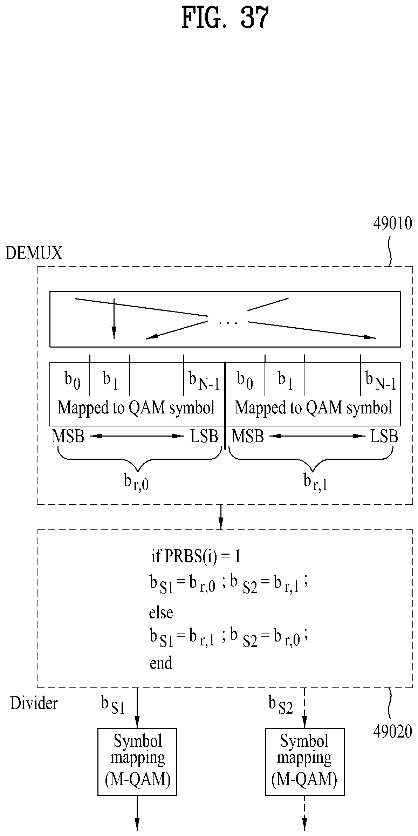

FIG. 37 illustrates operations of the demultiplexer and the divider according to an embodiment of the present invention.

FIG. 37 shows a case in which input signals have the same QAM type and illustrates an operation corresponding to the operation of the demultiplexer in the cases of FIGS. 30 and 31 or an operation when the divide is added to the demultiplexer.

Specifically, the demultiplexer 49010 may be a QPSK demultiplexer in the case of QPSK+QPSK MIMO or may be a 16-QAM demultiplexer in the case of 16-QAM+16-QAM MIMO according to the QAM type of the input signals.

If the number of bits to be mapped to one QAM symbol and sets of bits to be mapped to two QAM symbols after reordering by the demultiplexer 49010 are respectively $b\_r,0$ and $b\_r,1$, $b\_r,0$ represents first N bits output from the demultiplexer 49010 after bits of an r-th row of a bit interleaver memory are reordered by the demultiplexer 49010 and $b\_r,1$ represents N bits following the N bits $b\_r,0$.

When $b\_r,0$ and $b\_r,1$ are respectively mapped to symbols of input signals S1 and S2 to be used for a MIMO encoder, a reliability distribution structure applied by the demultiplexer 49010 to LDPC blocks does not change because reliability distributions of the input signals S1 and S2 do not change at a receiving side on an uncorrelated MIMO channel. In the case of a fully correlated channel, however, the reliability distributions of the input signals S1 and S2 change at the receiving side, and thus the reliability distribution structure of bits reordered by the demultiplexer 49010 is varied. This tendency exerts a strong influence on a low code rate LDPC structure. The low code rate LDPC has high performance when reliability is randomly distributed in each region. For this, $b\_r,0$ and $b\_r, 1$ mapped to the input signals S1 and S2 can be randomly selected.

That is, the divider 49020 can adjust reliability distribution such that high performance is achieved on a fully correlated MIMO channel by randomly mapping $b\_r,0$ and $b\_r,1$ to the input signals S1 and S2 or to the input signals S2 and S1 using a pseudo random binary sequence (PRBS). Even in this case, for an uncorrelated MIMO channel, the reliability distribution intended by the demultiplexer 49010 can be maintained because the reliability distributions of the input signals S1 and S2 do not change.

To generate the PRBS, the divider 49020 may use a $1+X14+X15$ PRBS generator or a bit reversed order sequence of an N-bit counter output. A sequence having a maximum of a length of 16200 (=64800/4) may be needed according to LDPC type. In this case, a 14-bit counter may be used. A PRBS generation sequence may be reset for every LDPC block. In this case, the divider 49020 can bypass the output of the demultiplexer 49010 if transmitted PLP data is of SISO type or MISO type.

In the receiver, the merger can reorder the bits in the original order through an operation corresponding to the operation of the divider 49020. That is, the merger can reorder LLR bit information using the same PRBS as that used in the divider 49020 and output the reordered LLR bit information.

A description will be given of an operation of the divider when input signals have different QAM types in the MIMO system.

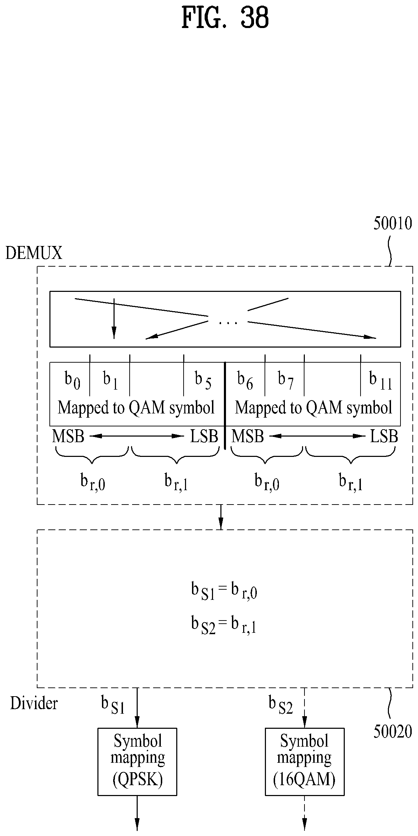

FIG. 38 illustrates operations of the demultiplexer and the divider according to an embodiment of the present invention.

FIG. 38 shows a case in which the input signals have different QAM types and illustrates an operation corresponding to the operation of the demultiplexer in the cases of FIG. 32 and 33 or an operation when the divider is added to the demultiplexer.

A plurality of demultiplexers 50010 or a demultiplexer that includes a memory and performs demultiplexing of different types of input signals may be used according to QAM types of input signals. In FIG. 38, QPSK and 16-QAM are exemplified as different QAM types.

If the number of bits to be mapped to symbols of QPSK and 16-QAM types is 12(=4+8) and sets of bits to be mapped to two QAM symbols after being reordered by the demultiplexer 50010 are respectively $b\_r,0$ and $b\_r,1$, $b\_r,0$ represents a set of first two bits from among first six bits output from the demultiplexer 50020 after reordering of bits of the r-th row of the bit interleaver and first two bits from among six bits following the first six bits, and $b\_r,1$ represents a set of the next four bits of the first six bits and the next four bits of the six bits following the first six bits.

In the case of QPSK+16-QAM MIMO, relative reliability of the bits of the QAM symbols does not largely change between an uncorrelated MIMO channel and a fully correlated MIMO channel, as shown in the table of FIG. 35. This is because reliability of QPSK increases even on the fully correlated MIMO channel while reliability of bits corresponding to QPSK is high. Using this property, in the case of QPSK+16-QAM type MIMO, the divider 50020 may use a 64-QAM demultiplexer and distribute reliability as in 64-QAM SISO. To achieve this, the divider 50020 may map bits of $b\_r,0$ to S1 (QPSK) and map bits of $b\_r,1$ to S2 (16-QAM).

In the receiver, the merger may perform an operation corresponding to the operation of the divider 50020 to output LLR bit information to the multiplexer. That is, the merger may reorder the bits of the input signals S1 and S2 such that bits from S1 are output as first, second, seventh and eighth bits and bits from S2 are output as third, fourth, fifth, sixth, ninth, tenth, eleventh and twelfth bits.

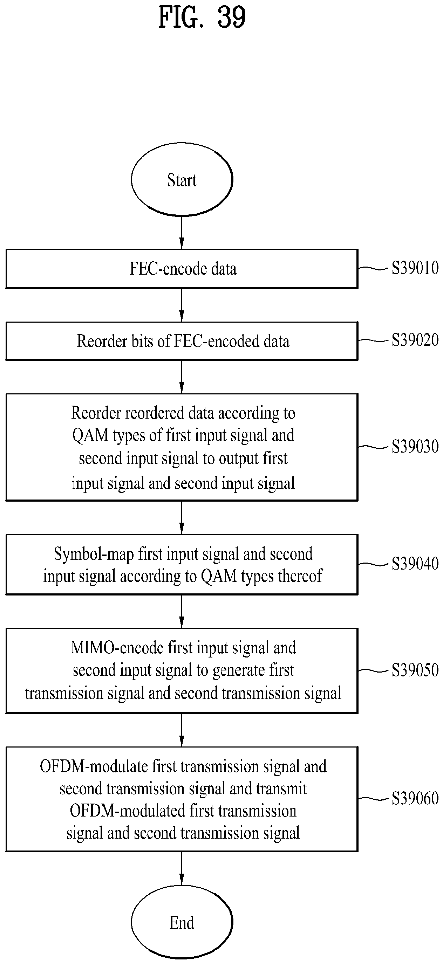

FIG. 39 is a flowchart illustrating a method of transmitting a broadcast signal according to an embodiment of the present invention.

A broadcast signal transmitter FEC-encodes data to be transmitted (S39010). The data may be encoded by an FEC encoder, and the encoding method has been described above.

The broadcast signal transmitter reorders bits of the FEC-encoded data (S39020). Reordering of the bits of the FEC-encoded data may be performed in a demultiplexer.

The broadcast signal transmitter reorders the reordered data according to QAM types of a first input signal and a second input signal so as to output first and second input signals (S39030). This step S39030 may be performed in a divider, or may be performed in a demultiplexer as necessary, as described above.

The broadcast signal transmitter symbol-maps the first and second input signals according to QAM types thereof to generate a first input signal and a second input signal for MIMO transmission (S39040).

The symbol-mapped first and second input signals may be processed on a symbol-by-symbol basis in the following steps. The input signals output from a symbol mapper may be M-QAM type input signals or an M-QAM type input signal and an N-QAM type input signal.

The broadcast signal transmitter performs MIMO encoding of the first and second input signals to generate a first transmission signal and a second transmission signal (S39050).

The MIMO encoding operation may be performed by a MIMO encoder or a MIMO processor, as described above, and may use the MIMO encoding matrix described in the above embodiments. That is, the broadcast signal transmitter may perform MIMO encoding using a MIMO matrix having a parameter 'a' that is set such that the first transmission signal and the second transmission signal respectively have optimized Euclidean distances, gray mapping, or Euclidean distances capable of compensating Hamming distance. As described above, the broadcast signal transmitter adjusts power of the input signals using the MIMO matrix, and the parameter 'a' may be set depending on the modulation types of the input signals.

The broadcast signal transmitter may OFDM-modulate the first transmission signal and the second transmission signal and transmit the modulated signals (S39060).

The broadcast signal transmitter may respectively transmit the modulated first and second transmission signals through first and second antennas. The first and second transmission signals may have the aforementioned signal frame structure and may include signaling information as described with reference to FIGS. 15 to 17.

FIG. 39 illustrates operations of the above-described broadcast signal transmitters, and detailed operations have been described in the corresponding figures (e.g. FIGS. 30 to 38) showing the broadcast signal transmitters.

[Modes for Invention]

Details about modes for the present invention have been described in the above best mode.

[Industrial Applicability]

As described above, the present invention can be wholly or partially applied to digital broadcast systems.

## Claims

1. A method for receiving broadcast signals transmitted using Quadrature Amplitude Modulation/Orthogonal Frequency Division Multiplexing, QAM/OFDM, the method comprising:

   receiving first and second broadcast signals through first and second antennas, and demodulating at least one signal frame included in the received first and second broadcast signals by an OFDM scheme;
   parsing and outputting first and second signals corresponding to a Physical Layer Pipe, PLP;
   time deinterleaving the first and second signals;
   Multi-input Multi-Output, MIMO, decoding the time deinterleaved first and second signals into first and second output signals including probability information of bits, wherein the MIMO decoding is performed by using a MIMO processing matrix having a parameter, wherein the parameter is related to an angle of a rotation performed by the MIMO processing matrix, and wherein the angle is determined according to the constellations applied to the transmitted broadcast signals;
   generating a single stream by combining the first and second output signals ; and
   Forward Error Correction, FEC, decoding the generated single stream to output PLP data.

2. The method of claim 1, wherein the method further includes:

bit deinterleaving the generated single stream before FEC decoding.

3.  The method of claim 1, wherein the constellations include a Quadrature Amplitude Modulation, QAM, constellation for a first transmitted broadcast signal and a QAM constellation for a second transmitted broadcast signal, wherein the QAM constellation for the first transmitted broadcast signal is equal to the QAM constellation for the second transmitted broadcast signal.

4.  The method of claim 1, wherein the method further includes:

    decoding L1 signaling information.

5.  An apparatus for receiving broadcast signals transmitted using Quadrature Amplitude Modulation/Orthogonal Frequency Division Multiplexing, QAM/OFDM, the apparatus comprising:

    a receiving unit (107100) to receive first and second broadcast signals through first and second antennas and demodulate at least one signal frame included in the received first and second broadcast signals by an OFDM scheme;
    a frame parser (107200) to parse and output first and second signals corresponding to a Physical Layer Pipe, PLP;
    a time deinterleaver (45140) to time deinterleave the first and second signals;
    a MIMO decoder (45150) to perform MIMO decoding on the time deinterleaved first and second signals into first and second output signals including probability information of bits, wherein the MIMO decoding is performed by using a MIMO processing matrix having a parameter, wherein the parameter is related to an angle of a rotation performed by the MIMO processing matrix, and wherein the angle is determined according to the constellations applied to the transmitted broadcast signals;
    a mux (45160) to generate a single stream by combining the first and second output signals; and
    a decoder (45180) to perform Forward Error Correction, FEC, decoding on the generated single stream to output PLP data.

6.  The apparatus of claim 5, wherein the apparatus further includes:

    a deinterleaver (45170) to bit deinterleave the generated single stream before FEC decoding.

7.  The apparatus of claim 5, wherein the constellations include a Quadrature Amplitude Modulation, QAM, constellation for a first transmitted broadcast signal and a QAM constellation for a second transmitted broadcast signal, wherein the QAM constellation for the first transmitted broadcast signal is equal to the QAM constellation for the second transmitted broadcast signal.

8.  The apparatus of claim 5, wherein the apparatus further includes:

    a decoder (110200) to decode L1 signaling information.


**Patentansprüche**

1.  Verfahren zum Empfangen von Rundfunksignalen, gesendet unter Verwendung von QAM (Quadraturamplitudenmodulation)/OFDM (Orthogonal Frequency Division Multiplexing), wobei das Verfahren umfasst:

    Empfangen von ersten und zweiten Rundfunksignalen über erste und zweite Antennen und Demodulieren mindestens eines in den empfangenen ersten und zweiten Rundfunksignalen eingeschlossenen Signal-Frames mittels eines OFDM-Programms;
    Parsen und Ausgeben von ersten und zweiten Signalen entsprechend einer Physical Layer Pipe (PLP);
    Zeitentschachteln der ersten und zweiten Signale;
    MIMO-Decodieren (MIMO = Multi-Input Multi-Output) der zeitentschachtelten ersten und zweiten Signale in erste und zweite Ausgangssignale einschließlich Wahrscheinlichkeitsinformationen von Bits, wobei die MIMO-Decodierung unter Verwendung einer MIMO-Verarbeitungsmatrix mit einem Parameter erfolgt, wobei der Parameter mit einem Winkel einer von der MIMO-Verarbeitungsmatrix ausgeführten Drehung in Beziehung steht und wobei der Winkel gemäß den auf die gesendeten Rundfunksignale angewandten Konstellationen bestimmt wird;

Generieren eines einzigen Datenstroms durch Kombinieren der ersten und zweiten Ausgangssignale; und FEC-Decodieren (FEC = Vorwärtsfehlerkorrektur) des generierten einzigen Datenstroms, um PLP-Daten auszugeben.

2. Verfahren nach Anspruch 1, wobei das Verfahren ferner einschließt:

Bitentschachteln des generierten einzigen Datenstroms vor dem FEC-Decodieren.

3. Verfahren nach Anspruch 1, wobei die Konstellationen eine QAM-Konstellation (QAM = Quadraturamplitudenmodulation) für ein erstes gesendetes Rundfunksignal und eine QAM-Konstellation für ein zweites gesendetes Rundfunksignal einschließen, wobei die QAM-Konstellation für das erste gesendete Rundfunksignal gleich der QAM-Konstellation für das zweite gesendete Rundfunksignal ist.

4. Verfahren nach Anspruch 1, wobei das Verfahren ferner einschließt:

Decodieren von L1-Signalisierungsinformationen.

5. Vorrichtung zum Empfangen von Rundfunksignalen, gesendet unter Verwendung von QAM (Quadraturamplitudenmodulation)/OFDM (Orthogonal Frequency Division Multiplexing), wobei die Vorrichtung umfasst:

eine Empfangseinheit (107100) zum Empfangen von ersten und zweiten Rundfunksignalen über erste und zweite Antennen und Demodulieren mindestens eines in den empfangenen ersten und zweiten Rundfunksignalen eingeschlossenen Signal-Frames mittels eines OFDM-Programms;
einen Frame-Parser (107200) zum Parsen und Ausgeben von ersten und zweiten Signalen entsprechend einer Physical Layer Pipe (PLP);
einen Zeitentschachteler (45140) zum Zeitentschachteln der ersten und zweiten Signale;
einen MIMO-Decoder (45150) zum MIMO-Decodieren der zeitentschachtelten ersten und zweiten Signale in erste und zweite Ausgangssignale einschließlich Wahrscheinlichkeitsinformationen von Bits, wobei die MIMO-Decodierung unter Verwendung einer MIMO-Verarbeitungsmatrix mit einem Parameter erfolgt, wobei der Parameter mit einem Winkel einer von der MIMO-Verarbeitungsmatrix ausgeführten Drehung in Beziehung steht und wobei der Winkel gemäß den auf die gesendeten Rundfunksignale angewandten Konstellationen bestimmt wird;
einen Multiplexer (45160) zum Generieren eines einzigen Datenstroms durch Kombinieren der ersten und zweiten Ausgangssignale; und
einen Decoder (45180) zum FEC-Decodieren (FEC = Vorwärtsfehlerkorrektur) des generierten einzigen Datenstroms, um PLP-Daten auszugeben.

6. Vorrichtung nach Anspruch 5, wobei die Vorrichtung ferner einschließt:

einen Entschachteler (45170) zum Bitentschachteln des generierten einzigen Datenstroms vor dem FEC-Decodieren.

7. Vorrichtung nach Anspruch 5, wobei die Konstellationen eine QAM-Konstellation (QAM = Quadraturamplitudenmodulation) für ein erstes gesendetes Rundfunksignal und eine QAM-Konstellation für ein zweites gesendetes Rundfunksignal einschließen, wobei die QAM-Konstellation für das erste gesendete Rundfunksignal gleich der QAM-Konstellation für das zweite gesendete Rundfunksignal ist.

8. Vorrichtung nach Anspruch 5, wobei die Vorrichtung ferner einschließt:

einen Decoder (110200) zum Decodieren von L1-Signalisierungsinformationen.

**Revendications**

1. Procédé de réception de signaux de diffusion transmis en utilisant une technique de modulation d'amplitude en quadrature / multiplexage à répartition en fréquence orthogonale (QAM/OFDM, « Quadrature Amplitude Modulation »/ « Orthogonal Frequency Division Multiplexing »), le procédé comprenant :

recevoir des premier et second signaux de diffusion par l'intermédiaire de première et seconde antennes, et démoduler au moins une trame de signal incluse dans les premier et second signaux de diffusion reçus par un schéma OFDM ;

analyser et délivrer des premier et second signaux correspondant à un conduit de couche physique (PLP, « Physical Layer Pipe ») ;

désentrelacer dans le temps les premier et second signaux ;

décoder en mode à plusieurs entrées et plusieurs sorties (MIMO, « Multiple Input-Multiple Output ») les premier et second signaux désentrelacés dans le temps pour produire des premier et second signaux de sortie incluant des informations de probabilité de bits, le décodage MIMO étant réalisé en utilisant une matrice de traitement MIMO ayant un paramètre, le paramètre étant lié à un angle d'une rotation effectuée par la matrice de traitement MIMO, l'angle étant déterminé selon les constellations appliquées aux signaux de diffusion transmis ;

générer un flux unique en combinant les premier et second signaux de sortie ; et

décoder avec correction d'erreurs de transmission (FEC, « Forward Error Correction ») le flux unique généré pour délivrer des données de sortie de PLP.

2. Procédé selon la revendication 1, dans lequel le procédé inclut en outre :

désentrelacer par bits le flux unique généré avant le décodage FEC.

3. Procédé selon la revendication 1, dans lequel les constellations incluent une constellation de modulation d'amplitude en quadrature (QAM, « Quadrature Amplitude Modulation ») pour un premier signal de diffusion transmis et une constellation QAM pour un second signal de diffusion transmis, la constellation QAM pour le premier signal de diffusion transmis étant égale à la constellation QAM pour le second signal de diffusion transmis.

4. Procédé selon la revendication 1, dans lequel le procédé inclut en outre :

décoder de l'information de signalisation L1.

5. Dispositif pour recevoir des signaux de diffusion transmis en utilisant une technique de modulation d'amplitude en quadrature / multiplexage à répartition en fréquence orthogonale (QAM/OFDM, « Quadrature Amplitude Modulation »/ « Orthogonal Frequency Division Multiplexing »), le dispositif comprenant :

une unité de réception (107100) pour recevoir des premier et second signaux de diffusion par l'intermédiaire de première et seconde antennes, et démoduler au moins une trame de signal incluse dans les premier et second signaux de diffusion reçus par un schéma OFDM ;

un analyseur de trames (107200) pour analyser et délivrer des premier et second signaux correspondant à un conduit de couche physique (PLP, « Physical Layer Pipe ») ;

un désentrelaceur temporel (45140) pour désentrelacer dans le temps les premier et second signaux ;

un décodeur MIMO (45150) pour effectuer un décodage MIMO sur les premier et second signaux désentrelacés dans le temps pour produire des premier et second signaux de sortie incluant des informations de probabilité de bits, le décodage MIMO étant réalisé en utilisant une matrice de traitement MIMO ayant un paramètre, le paramètre étant lié à un angle d'une rotation effectuée par la matrice de traitement MIMO, l'angle étant déterminé selon les constellations appliquées aux signaux de diffusion transmis ;

un multiplexeur (45160) pour générer un flux unique en combinant les premier et second signaux de sortie ; et

un décodeur (45180) pour effectuer un décodage à correction d'erreurs de transmission (FEC, « Forward Error Correction ») sur le flux unique généré pour délivrer des données de sortie de PLP.

6. Dispositif selon la revendication 5, dans lequel le dispositif inclut en outre :

un désentrelaceur (45170) pour désentrelacer par bits le flux unique généré avant le décodage FEC.

7. Dispositif selon la revendication 5, dans lequel les constellations incluent une constellation de modulation d'amplitude en quadrature (QAM, « Quadrature Amplitude Modulation ») pour un premier signal de diffusion transmis et une constellation QAM pour un second signal de diffusion transmis, la constellation QAM pour le premier signal de diffusion transmis étant égale à la constellation QAM pour le second signal de diffusion transmis.

8. Dispositif selon la revendication 5, dans lequel le dispositif inclut en outre :

un décodeur (110200) pour décoder de l'information de signalisation L1.

EP 2 955 858 B1

# FIG. 1

101100  101200  101300  101400  101500

TS or IP or GS Inputs → Input-pre processor → Input processing module → BICM module → Frame builder → OFDM generator → Antennas having polarities

# FIG. 2

(A)

Mode adaptation block      Stream adaptation block

(B)

# FIG. 3

# FIG. 4

104100

| | 104110-0 | 104120-0 | 104130-0 | 104140-0 | 104150-0 | 104160-0 | 104170-0 | 104180-0 | |
|---|---|---|---|---|---|---|---|---|---|
| PLP0 → | FEC encoder (LDPC/BCH) | Bit interleaver | First de-multiplexer | Constellation mapper | Second de-multiplexer | Cell interleaver | Time interleaver | Constellation rotator/re-mapper | → STX_0 |
| | | | | | | | | | → STX_0+1 |
| | 104110-1 | 104120-1 | 104130-1 | 104140-1 | 104150-1 | 104160-1 | 104170-1 | 104180-1 | |
| PLP1 → | FEC encoder (LDPC/BCH) | Bit interleaver | First de-multiplexer | Constellation mapper | Second de-multiplexer | Cell interleaver | Time interleaver | Constellation rotator/re-mapper | → STX_1 |
| | | | | | | | | | → STX_1+1 |
| PLPp → | FEC encoder (LDPC/BCH) | Bit interleaver | First de-multiplexer | Constellation mapper | Second de-multiplexer | Cell interleaver | Time interleaver | Constellation rotator/re-mapper | → STX_p |
| | | | | | | | | | → STX_p+1 |
| | 104110-p | 104120-p | 104130-p | 104140-p | 104150-p | 104160-p | 104170-p | 104180-p | |

104200

L1 dynamic information → L1 signaling generator → L1-pre signaling information → FEC encoder (LDPC/BCH) → constellation mapper → second de-multiplexer → Constellation rotator/re-mapper → STX_pre, STX_pre+1

L1 configuration information → L1 signaling generator → L1-post signaling information → FEC encoder (LDPC/BCH) → Bit interleaver → First de-multiplexer → constellation mapper → second de-multiplexer → Constellation rotator/re-mapper → STX_post, STX_post+1

# FIG. 5

105200

STX_0 →
STX_0+1 →

Common
PLP assembler

STX_1 →
STX_1+1 →

Sub-slice
processor

⋮

STX_p →
STX_p+1 →

Data PLP
assembler

Cell
mapper

105300

Frequency
interleaver

→
→

STX_pre →
STX_pre+1 →
STX_post →
STX_post+1 →

Delay
compensator

→
→
→
→

Signaling infor-
mation assembler

105100

# FIG. 6

EP 2 955 858 B1

# FIG. 7

Antennas having polarities (RX) → | OFDM demodulator 107100 | → | Frame parser 107200 | → | BICM decoder 107300 | → | Output processor 107400 | → TS or GS Outputs

# FIG. 8

# FIG. 9

109200

| Cell demapper (109200) | Outputs |
|---|---|

Common PLP extractor → STX_0, STX_0+1

Sub-slice processor → STX_1, STX_1+1

Data PLP extractor → STX_p, STX_p+1

Signaling information extractor → STX_pre, STX_pre+1, STX_post, STX_post+1

109100

Frequency deinterleaver → Cell demapper

# FIG. 10

# FIG. 11

(A)

From DICM Decoder →

111100 — BB descrambler → 111110 — Padding removal module → 111120 — CRC-8 decoder → 111130 — BB frame processor → TS or GS Output

(B)

PLP-0 → BB descrambler → Padding removal module → CRC-8 decoder → BB frame processor → De-jitter buffer (111200-0) → Null packet insertion module (111210-0) → Common PLP → TS recombination module (111230) → TS or GS Output

111220 — TS clock regeneration

PLP-1 → BB descrambler → Padding removal module → CRC-8 decoder → BB frame processor → De-jitter buffer (111200-1) → Null packet insertion module (111210-1) → PLP 1

In-band signaling decoder (111240) → In-band signaling

PLP-p → BB descrambler → Padding removal module → CRC-8 decoder → BB frame processor → De-jitter buffer (111200-p) → Null packet insertion module (111210-p) → PLP p

In-band signaling decoder → In-band signaling

EP 2 955 858 B1

# FIG. 12

Type-1 or type-2 PLP

OFDM symbols

Time

P1  P2 0 ··· P2 N_py-1  D 0  D 1  D 2 ···  ···  D L_data-1

Cell index

Full transmission frame

L1-pre signaling information    Type-1 PLPs (1...M1)    multiple common PLPs    Dummy cell

L1-post signaling information    type-2 PLPs (M1+1....M1+M2)    Auxiliary stream

EP 2 955 858 B1

# FIG. 13

113100

(A)

113110-1  113110-2        113110-n-1  113110-n  113120-1                                    113120-2

| Basic frame | Basic frame | ..... | Basic frame | Basic frame | NEW frame (FEF) | ..... | Basic frame | Basic frame | Basic frame | NEW frame (FEF) |

FEF interval (N basic frames)

(B)

113210-1              113210-2

| Basic frame | NEW frame (FEF) | Basic frame | NEW frame (FEF) | Basic frame | NEW frame (FEF) | ..... | Basic frame | NEW frame (FEF) | Basic frame | NEW frame (FEF) |

FEF interval
(one basic frame)

113220

113200

EP 2 955 858 B1

# FIG. 14

(A) P1 symbol structure

$T_{P1C} = 59\mu s$   $T_{P1A} = 112\mu s$   $T_{P1B} = 53\mu s$

Both P1 structure and P1 generator can be modified to generate new system P1 symbol

(B) P1 symbol generator

# FIG. 15

| L1-pre signaling information | L1-post signaling information |
|---|---|

| | |
|---|---|
| TYPE | (8 bits) |
| BWT_EXT | (1 bit) |
| S1 | (3 bit) |
| S2 | (4 bit) |
| L1_REPETITION_FLAG | (1 bit) |
| GUARD_INTERVAL | (3 bit) |
| PAPR | (4 bit) |
| L1_MOD | (4 bit) |
| L1_COD | (2 bit) |
| L1_FEC_TYPE | (2 bit) |
| L1_POST_SIZE | (18 bit) |
| L1_POST_INFO_SIZE | (18 bit) |
| PILOT_PATTERN | (4 bit) |
| TX_ID_AVAILABILITY | (8 bits) |
| CELL_ID | (16 bit) |
| NETWORK_ID | (16 bit) |
| SYSTEM_ID | (16 bit) |
| NUM_FRAMES | (8 bits) |
| NUM_DATA_SYMBOLS | (12 bit) |
| REGEN_FLAG | (3 bit) |
| L1_POST_EXTENSION | (1 bit) |
| NUM_RF | (3 bit) |
| CURRENT_RF_IDX | (3 bit) |
| RESERVED | (10 bit) |
| CRC_32 | (32 bit) |

# FIG. 16

| L1-pre signaling information | L1-post signaling information |
|---|---|

| Configurable | Dynamic | Extension | CRC | |
|---|---|---|---|---|

L1-padding

```
SUB_SLICES_PER_FRAME              (15 bits)
NUM_PLP                           (8 bits)
NUM_AUX                           (4 bits)
AUX_CONFIG_RFU                    (8 bits)

for i=0..NUM_RF-1 {
RF_IDX                            (3 bits)
FREQUENCY                         (32 bits)
}

IF S2 =='xxx1' {
FEF_TYPE                          (4 bits)
FEF_LENGTH                        (22 bits)
FEF_INTERVAL                      (8 bits)
}

for i = 0..NUM_PLP-1 {
PLP_ID                            (8 bits)
PLP_TYPE                          (3 bits)
PLP_PATLOAD_TYPE                  (5 bits)
FR_FLAG                           (1 bits)
FIRST_RF_IDX                      (3 bits)
FIRST_FRAME_IDX                   (8 bits)
PLP_GROUP_ID                      (8 bits)
PLP_COD                           (3 bits)
PLP_MOD                           (3 bits)
PLP_ROTATION                      (1 bits)
PLP_FEC_TYPE                      (2 bits)
PLP_NUM_BLOCKS_MAX                (10 bits)
FRAME_INTERVAL                    (8 bits)
TIME_IL_LENGTH                    (8 bits)
TIME_IL_TYPE                      (1 bits)
IN_BAND_FLAG                      (1 bits)
RESERVED_1                        (16 bits)
}

RESERVED_2                        (32 bits)

for i=0..NUM_AUX-1 {
AUX_RFU                           (32 bits)
}
```

# FIG. 17

| L1-pre signaling information | L1-post signaling information |
|---|---|

L1-padding

| Configurable | Dynamic | Extension | CRC | |
|---|---|---|---|---|

| | |
|---|---|
| FRAME_IDX | (8 bits) |
| SUB_SLICE_INTERVAL | (22 bits) |
| TYPE_2_START | (22 bits) |
| L1_CHANGE_COUNTER | (8 bits) |
| START_RF_IDX | (3 bits) |
| RESERVED_1 | (8 bits) |
| | |
| for i = 0..NUM_PLP-1 { | |
| PLP_ID | (8 bits) |
| PLP_START | (22 bits) |
| PLP_NUM_BLOCKS | (10 bits) |
| RESERVED_2 | (8 bits) |
| } | |
| | |
| RESERVED_3 | (8 bits) |
| | |
| for i=0..NUM_AUX-1 { | |
| AUX_RFU | (48 bits) |
| } | |

# FIG. 18

(A)

Data → FEC encoder → DEMUX → First symbol mapper / second symbol mapper → MIMO encoder → First frame mapper / Second frame mapper → First OFDM modulator → To Tx1 / Second OFDM modulator → To Tx2

(B)

From Rx1 → First synchronizer → First OFDM demodulator → First frame parser → MIMO decoder → First symbol dempper → MUX

From Rx2 → Second synchronizer → Second OFDM demodulator → Second frame parser → MIMO decoder → Second symbol dempper → MUX → Data merger → FEC decoder

Third symbol demapper → Data merger

EP 2 955 858 B1

# FIG. 19

(A)

Data → FEC encoder → DEMUX → First symbol mapper → First power corrector → MIMO encoder → First frame mapper → First OFDM modulator → To Tx1

DEMUX → second symbol mapper → Second power corrector → MIMO encoder → Second frame mapper → Second OFDM modulator → To Tx2

(B)

From Rx1 → First synchronizer → First OFDM demodulator → First frame parser → MIMO decoder → First power corrector → First symbol dempper → MUX

From Rx2 → Second synchronizer → Second OFDM demodulator → Second frame parser → MIMO decoder → Second power corrector → Second symbol dempper → MUX

MUX → FEC decoder → Data

EP 2 955 858 B1

FIG. 20

FIG. 21

# FIG. 22

SISO PLP (time slot)

MIMO PLP (time slot)

MIMO PLP part

SISO PLP part

Time

Ant 1

Ant 2

MIMO PLP part

MIMO PLP part

Base layer

Enhancement layer

SVC encoder

MIMO encoder

122100

122200

# FIG. 23

(A)

Terrestrial broadcast frame . . . Terrestrial broadcast frame FEF Terrestrial broadcast frame . . . Terrestrial broadcast frame FEF

SISO
Base layer

MIMO
enhancement layer

(B)

Terrestrial broadcast frame . . . Terrestrial broadcast frame FEF Terrestrial broadcast frame . . . Terrestrial broadcast frame FEF

SISO
Base layer

MIMO
enhancement layer

(C)

Terrestrial broadcast frame . . . Terrestrial broadcast frame FEF Terrestrial broadcast frame . . . Terrestrial broadcast frame FEF

SISO.MISO carrier for base layer and
MIMO carrier for enhancement layer

# FIG. 24

201010

S1

Input signal generator

S2

201020

MIMO encoder

St1

St2

201030

First transmit antenna

Second transmit antenna

201040

201080

S1

Output signal generator

S2

201070

MIMO decoder

St1

St2

201050

First receive antenna

Second receive antenna

201060

# FIG. 25

BER vs. SNR with QPSK channel Rayleigh

EP 2 955 858 B1

## FIG. 26

203010

Conded BER, Matrix B and Matrix C, QPSK 1/2.

203020

Conded BER, Matrix B and Matrix C, QPSK $3/4$

203030

Conded BER, Matrix B and Matrix C, 64 QAM $5/6$

FIG. 27

# FIG. 28

# FIG. 29

## FIG. 30

# FIG. 31

EP 2 955 858 B1

FIG. 32

# FIG. 33

Alamouti
Golden
SM
WS,W= OPT1, OPT2, OPT3
Etc.

PLP inputs

BICM module

QPSK,16QAM DEMUX
for QPSK+QPSK and
16QAM+16QAM MIMO
respectively,
64QAM DEMUX for
QPSK+16QAM MIMO

M-QAM
mapping N-QAM
mapping

BICM decoding module

PLP output

ML
Approximated ML
Sphere
Etc.

Symbol domain signal processing

LLR out

QAM Symbol domain stream
Bit domain stream

47020
47050
47060
47070
47080
47090
47100
47010
47030
47040
47150
47140
47190
47130
47120
47110
47180
47170
47160

FEC encoder (LDPC/BCH)
Bit interleaver
DEMUX
Symbol mapper
MIMO encoder
Time interleaver
Frame builder
Frequency interleaver
OFDM generator

Tx1
Tx2

FEC디코더 (LDPC/BCH)
Bit deinterleaver
MUX
MIMO decoder
Time deinterleaver
Frame parser
Frequency deinterleaver
OFDM demodulator

Rx1
Rx2

EP 2 955 858 B1

# FIG. 34

$$S1 = b_0 b_1 \ldots b_{N-1}, \quad N = \log_2 M, \quad M = QAM size of S1$$

$$L_{LDPC} = \text{Length of LDPC Block}$$

$$\left((2N-1)\frac{L_{LDPC}}{2N}+1\right)^{th} \sim L_{LDPC}^{th} \text{ bits}$$

$$1^{st} \sim \frac{L_{LDPC}}{2N}^{th} \text{ bits}$$

46010

··· 1 LDPC block ···

| 0 | 1 | | N-1 | N | N+1 | | 2N-1 |

46020

| $b_0$ | $b_1$ | | $b_{N-1}$ | $b_0$ | $b_1$ | | $b_{N-1}$ |

Map to N-QAM symbol    Map to N-QAM symbol

MSB ⟵⟶ LSB | MSB ⟵⟶ LSB

# FIG. 35

| Uncorrelated MIMO channel | | | | | | |
|---|---|---|---|---|---|---|
| bits | QPSK+QPSK MIMO | | QPSK+16QAM MIMO | | 16QAM+16QAM MIMO | |
| | S1 | S2 | S1 | S2 | S1 | S2 |
| $b_0, b_1$ | A | A | A | A | A | A |
| $b_2, b_3$ | NA | NA | NA | B | B | B |
| fully correlated MIMO channel | | | | | | |
| bits | QPSK+QPSK MIMO | | QPSK+16QAM MIMO | | 16QAM+16QAM MIMO | |
| | S1 | S2 | S1 | S2 | S1 | S2 |
| $b_0, b_1$ | A | B | A | B | A | C |
| $b_2, b_3$ | NA | NA | NA | C | B | D |

# FIG. 36

48010      48020                          48030      48040      48050

DEMUX → Symbol mapper →→      ➡      → DEMUX → Divider → Symbol mapper →→

MUX ←←      ➡      ← MUX ← Merger ←←

48060                          48070      48080

# FIG. 37

49010

DEMUX

$$b_0 \quad b_1 \qquad b_{N-1} \quad b_0 \quad b_1 \qquad b_{N-1}$$

Mapped to QAM symbol | Mapped to QAM symbol

MSB ⟵⟶ LSB | MSB ⟵⟶ LSB

$$b_{r,0} \qquad\qquad b_{r,1}$$

if PRBS(i) = 1

$b_{S1} = b_{r,0}$ ; $b_{S2} = b_{r,1}$ ;

else

$b_{S1} = b_{r,1}$ ; $b_{S2} = b_{r,0}$ ;

end

Divider    $b_{S1}$        $b_{S2}$                49020

Symbol
mapping
(M-QAM)

Symbol
mapping
(M-QAM)

# FIG. 38

# FIG. 39

```
        ┌─────────┐
        │  Start  │
        └─────────┘
             │
             ▼
┌──────────────────────────────┐
│       FEC-encode data        │──── S39010
└──────────────────────────────┘
             │
             ▼
┌──────────────────────────────┐
│  Reorder bits of FEC-encoded data │──── S39020
└──────────────────────────────┘
             │
             ▼
┌──────────────────────────────┐
│   Reorder reordered data according to   │
│   QAM types of first input signal and   │
│      second input signal to output first   │──── S39030
│    input signal and second input signal  │
└──────────────────────────────┘
             │
             ▼
┌──────────────────────────────┐
│   Symbol-map first input signal and second   │
│  input signal according to QAM types thereof │──── S39040
└──────────────────────────────┘
             │
             ▼
┌──────────────────────────────┐
│      MIMO-encode first input signal and      │
│       second input signal to generate first    │──── S39050
│  transmission signal and second transmission signal │
└──────────────────────────────┘
             │
             ▼
┌──────────────────────────────┐
│  OFDM-modulate first transmission signal and  │
│    second transmission signal and transmit     │
│         OFDM-modulated first transmission       │──── S39060
│    signal and second transmission signal       │
└──────────────────────────────┘
             │
             ▼
        ┌─────────┐
        │   End   │
        └─────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **ATANES.** MIMO Performance of the Next Generation DVB-T. *2009 IEEE 69TH VEHICULAR TECHNOLOGY CONFERENCE,* April 2009, 1-5